# EUROPEAN PATENT APPLICATION

(11) **EP 4 435 023 A1**
(43) Date of publication of application: **25.09.2024**
(21) Application number: 22901366.9
(22) Date of filing: 30.11.2022
(51) Int. Cl.: C08F 265/00, C09K 11/02, C09K 11/08, C08F 2/44, C09D 11/101, C09D 11/326, C09D 11/50

(54) **INK COMPOSITION**

(30) Priority: 30.11.2021 JP 2021194475; 30.11.2021 JP 2021194477; 16.03.2022 JP 2022041492; 28.03.2022 JP 2022051869; 15.11.2022 JP 2022182324; 15.11.2022 JP 2022182326; 28.11.2022 JP 2022189340
(71) Applicant: CANON KABUSHIKI KAISHA, Tokyo 146-8501 (JP)
(72) Inventor: YOSHIMASA Yutaka, Tokyo 146-8501 (JP); OHASHI Yoshihiro, Tokyo 146-8501 (JP)
(74) Representative: WESER & Kollegen Patentanwälte PartmbB
(86) International application number: PCT/JP2022/044195
(87) International publication number: WO 2023/100934

(57) **Abstract**

An ink composition 200 contains a photoresponsive nanoparticle 10, a shell-like ligand 20 including a plurality of binding portions 30 with an ionic structural unit and a polymer portion 40 bound to the nanoparticle 10 at a plurality of positions via the plurality of binding portions 20, and a polymerizable compound 50.

## Description

### Technical Field

The present disclosure relates to an ink composition.

### Background Art

It is known that photoresponsive nanoparticles, such as quantum dots, have intermediate electronic properties between a bulk system and a discrete system and therefore have unique light absorption characteristics and emission properties. Thus, such photoresponsive nanoparticles are expected to be applied to a wide range of industrial applications, such as displays, solar cells, and laser.

It is expected that photoresponsive nanoparticles are dispersed in a medium, such as a solvent or a polymerizable monomer, and are handled as an ink, from the perspective of facilitating patterning depending on a device to which the photoresponsive nanoparticles are applied, the procurement of raw materials, or the management of the particle size and dispersibility in a distribution process and a production process. It is known that the particle size and dispersibility of photoresponsive nanoparticles in a medium affect the quantum efficiency of quantum dots applied to a device.

On the other hand, with a small particle size of several nanometers to tens of nanometers and a large specific surface area, photoresponsive nanoparticles may easily aggregate due to the influence of an interface in contact with a medium and sometimes cannot maintain dispersibility in the medium. Patent Literature 1 discloses an ink composition containing quantum dots dispersed in a medium using a photopolymerizable compound with a carboxy group. In the present description, a medium is a material serving as a receptacle in which quantum dots are dispersed, and includes a solvent and a low-molecular-weight polymerizable compound with fluidity until at least a stage of receiving predetermined energy.

### Citation List

### Patent Literature

PTL 1: Japanese Patent Laid-Open No. 2016-71362

### Summary of Invention

### Technical Problem

In the ink composition described in Patent Literature 1, the structure and physical properties of the medium are specified to improve the dispersibility of photoresponsive nanoparticles, and the dispersion stability of the ink composition may be restricted by the selection of the medium. There was a need for an ink composition with dispersion stability guaranteed for a plurality of media.

In view of the above problems, it is an object of the present invention to provide an ink composition with dispersion stability guaranteed for a plurality of media. Solution to Problem

An ink composition according to an embodiment of the present invention contains a photoresponsive nanoparticle, a shell-like ligand including a plurality of binding portions with an ionic structural unit and a polymer portion bound to the nanoparticle at a plurality of positions via the plurality of binding portions, and a polymerizable compound. Advantageous Effects of Invention

The present invention can provide an ink composition with dispersion stability guaranteed for a plurality of media.

### Brief Description of Drawings

[Fig. 1A] Fig. 1A is a view of the dispersion state of an ink composition according to a first embodiment.
[Fig. 1B] Fig. 1B is a schematic view of a binding portion of the ink composition according to the first embodiment.
[Fig. 1C] Fig. 1C is a schematic view of a polymer portion of the ink composition according to the first embodiment.
[Fig. 2] Fig. 2 is a view of the dispersion state of an ink composition according to a second embodiment.
[Fig. 3A] Fig. 3A is a view of the dispersion state of an ink composition according to a first reference embodiment immediately after preparation.
[Fig. 3B] Fig. 3B is a view of the dispersion state of the ink composition according to the first reference embodiment after the passage of time.
[Fig. 4A] Fig. 4A is a schematic view of an ink composition according to an eighth embodiment.
[Fig. 4B] Fig. 4B is a schematic view of a wavelength conversion layer according to a fourth embodiment.
[Fig. 5A] Fig. 5A is a view of the dispersion state of an ink composition according to a fifth embodiment.
[Fig. 5B] Fig. 5B is a schematic view of a binding portion of the ink composition according to the fifth embodiment.
[Fig. 5C] Fig. 5C is a schematic view of a polymer portion of the ink composition according to the fifth embodiment.
[Fig. 6A] Fig. 6A is a view of the dispersion state of an ink composition according to a sixth embodiment.
[Fig. 6B] Fig. 6B is a schematic view of a binding portion of the ink composition according to the sixth embodiment.
[Fig. 6C] Fig. 6C is a schematic view of an organic polymer portion of the ink composition according to the sixth embodiment.
[Fig. 7] Fig. 7 is a view of the dispersion state of an ink composition according to a seventh embodiment.
[Fig. 8A] Fig. 8A is a view of the dispersion state of an ink composition according to a second reference embodiment immediately after preparation.
[Fig. 8B] Fig. 8B is a view of the dispersion state of the ink composition according to the second reference embodiment after the passage of time.
[Fig. 9A] Fig. 9A is a schematic view of the ink composition according to the first embodiment.
[Fig. 9B] Fig. 9B is a schematic view of an eighth wavelength conversion layer.

### Description of Embodiments

Preferred embodiments of the present invention are described in detail below with reference to the drawings. The dimensions, materials, shapes, and relative arrangements of the constituents described in these embodiments are not intended to limit the scope of the present invention.

### <First Embodiment>

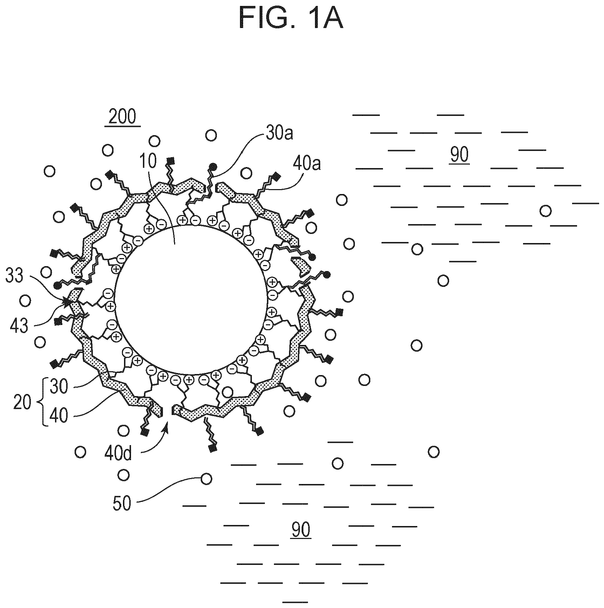

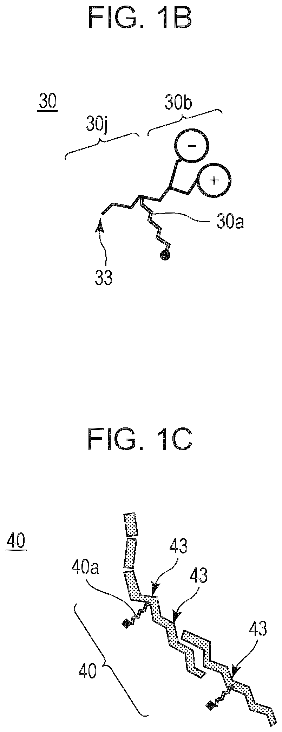

An ink composition 200 according to a first embodiment is described below with reference to Figs. 1A and 1C.

### (Ink Composition)

As illustrated in Fig. 1A, the ink composition 200 according to the present embodiment contains a photoresponsive nanoparticle 10 with a surface coordinated by a shell-like ligand 20, and a polymerizable compound to be polymerized upon receiving energy. The shell-like ligand 20 has a plurality of binding portions 30 with an ionic structural unit, and a polymer portion 40 (organic polymer portion 40) bound to the nanoparticle 10 at a plurality of positions via the plurality of binding portions 30.

### (Nanoparticle)

In the present embodiment, a photoresponsive nanoparticle is in the form of particle with at least one length of 500 nm or less. The shape thereof may be of any geometrical shape, such as spherical, cubic, rod-like, or disk-shaped, and a so-called quantum dot with a spherical shape or a cubic shape is employed.

A material of a quantum dot is, for example, a semiconductor crystal, a nanoparticle of a Group IV semiconductor, a Group III-V or Group II-VI compound semiconductor, a compound semiconductor composed of three or more of Group II, Group III, Group IV, Group V, and Group VI elements, or the like. More specifically, a material that emits light in the wavelength region for a display element may be CsS, CdSe, CdZnSe, CdSeTe, ZnSe, ZnTeSe, ZnTeS, InP, CuInS2, AgInS2, a Pb perovskite, or the like. The nanoparticle 10 itself may be composed of different materials in the radial direction. For example, the nanoparticle 10 may have different compositions, crystal structures, and the like in an inner core, a middle shell, and an outer shell.

A quantum dot may have an average particle size of 2 nm or more and 15 nm or less. A quantum dot with a particle size equal to or smaller than the Bohr radius of an exciton existing therein has a change in the band gap due to the quantum size effect. For example, a group III-V semiconductor InP is said to have a Bohr radius in the range of approximately 10 nm to 14 nm. Thus, in a quantum dot with an average particle size of 15 nm or less, the band gap can be controlled by the quantum size effect. In a quantum dot with an average particle size of 2 nm or more, the crystal growth of the quantum dot can be easily controlled in the synthesis of the quantum dot.

The nanoparticle 10 may be used alone or in combination of two or more thereof.

The photoresponsive nanoparticle 10 according to the present embodiment may be a semiconductor nanocrystal with a perovskite crystal structure including an A site (a monovalent cation), a B site (a divalent cation), and an X site (a monovalent anion including a halide anion) as constituents. The perovskite crystal structure is also referred to as a perovskite structure, an ABX₃ crystal structure, or an ABX₃ structure. Furthermore, a double perovskite crystal structure represented by A₂B₁B₂X₆ is also included in the perovskite crystal structure.

### [A Site of Perovskite Structure]

A monovalent cation is used in the A site. The monovalent cation used in the A site may be a nitrogen-containing organic compound cation, such as an ammonium cation (NH₄⁺), an alkylammonium cation with 6 or less carbon atoms, a formamidinium cation (HC(NH₂)₂⁺), a guanidinium cation (C(NH₂)₃⁺), an imidazolium cation, a pyridinium cation, or a pyrrolidinium cation, or an alkali metal cation, such as a lithium cation (Li⁺), a sodium cation (Na⁺), a potassium cation (K⁺), a rubidium cation (Rb⁺), or a cesium cation (Cs⁺).

These monovalent cations used in the A site have a small ion size that can fit a crystal lattice, and the perovskite compound can therefore form a stable three-dimensional crystal.

The alkylammonium cation with 6 or less carbon atoms is preferably, for example, a methylammonium cation (CH₃NH₃⁺), an ethylammonium cation (C₂H₅NH₃⁺), a propylammonium cation (C₃H₇NH₃⁺), or the like.

From the perspective of achieving high light emission efficiency, at least one of a methylammonium cation, a formamidinium cation, and a cesium cation is preferably used in the A site, and from the perspective of reducing color change, a cesium cation is more preferably used in the A site. These monovalent cations used in the A site may be used in combination of two or more thereof.

When a cesium cation is used in the A site, a cesium salt may be used as a raw material for the synthesis of a photoresponsive nanocrystal described later. The cesium salt may be cesium chloride, cesium bromide, cesium iodide, cesium hydroxide, cesium carbonate, cesium hydrogen carbonate, cesium bicarbonate, cesium formate, cesium acetate, cesium propionate, cesium pivalate, or cesium oxalate as appropriate. Among these cesium salt candidates, a cesium salt suitable for the synthesis method can be used.

When another alkali metal cation is used in the A site, a salt produced by replacing the cesium element of the cesium compound with another alkali metal cation element can be used as a raw material.

When a nitrogen-containing organic compound cation, such as a methylammonium cation, is used in the A site, for example, a neutral compound other than a salt, such as methylamine, can be used as a raw material. These raw materials may be used in combination of two or more thereof.

### [Perovskite Crystal Structure B Site]

A divalent cation including a divalent transition metal cation or a divalent typical metal cation is used in the B site of the perovskite crystal structure.

The divalent transition metal cation may be a scandium cation (Sc₂⁺) , a titanium cation (Ti₂⁺), a vanadium cation (V₂⁺), a chromium cation (Cr₂⁺), a manganese cation (Mn₂⁺), an iron cation (Fe₂⁺), a cobalt cation (Co₂⁺), a nickel cation (Ni₂⁺), a copper cation (Cu₂⁺), a palladium cation (Pd₂⁺), a europium cation (Eu₂⁺), or an ytterbium cation (Yb₂⁺).

The divalent typical metal cation may be a magnesium cation (Mg₂⁺), a calcium cation (Ca₂⁺), a strontium cation (Sr₂⁺), a barium cation (Ba₂⁺), a zinc cation (Zn₂⁺), a cadmium cation (Cd₂⁺), a germanium cation (Ge₂⁺), a tin cation (Sn₂⁺), or a lead cation (Pb₂⁺).

Among these divalent cations, a divalent typical metal cation is preferred in terms of the growth of a stable three-dimensional crystal, a tin cation or a lead cation is more preferred, and a lead cation is particularly preferred from the perspective of high light emission intensity. These divalent cations may be used in combination of two or more thereof, and the perovskite crystal structure may be of a so-called double perovskite type.

When a lead cation is used in the B site, a raw material for the synthesis of a nanoparticle (photoresponsive nanocrystal) described later may be a lead compound and can be appropriately selected depending on the synthesis method. The lead compound may be lead chloride, lead bromide, lead iodide, lead oxide, lead hydroxide, lead sulfide, lead carbonate, lead formate, lead acetate, lead 2-ethylhexanoate, lead oleate, lead stearate, lead naphthenate, lead citrate, lead maleate, or lead acetylacetonate. When another divalent metal cation is used in the B site, a salt produced by replacing the lead element of the lead compound with another divalent metal cation element can be used as a raw material. These raw materials may be used in combination of two or more thereof.

### [X Site of Perovskite Crystal Structure]

A monovalent anion including a halide anion is used in X of the perovskite crystal structure. The halide anion may be a fluoride anion (F-), a chloride anion (Cl-), a bromide anion (Br⁻), an iodide anion (I⁻), or the like. Among these, a chloride anion, a bromide anion, or an iodide anion is preferred from the perspective of forming a stable three-dimensional crystal and emitting strong light in the visible light region. The emission color is blue for the chloride anion, green for the bromide anion, and red for the iodide anion.

The halide anions may be used in combination of two or more thereof. In particular, when a chloride anion, a bromide anion, and an iodide anion are used in combination, the photoresponsive nanocrystal can have a desired emission wavelength depending on the content ratio of the anionic species. More specifically, in particular, the combined use of a chloride anion, a bromide anion, and an iodide anion is preferred because an emission spectrum covering almost the entire region of visible light from blue to red can be obtained while maintaining a narrow full width at half maximum depending on the content ratio of the anionic species.

The X site may contain a monovalent anion other than halide anions. The monovalent anion other than halide anions may be a pseudohalide anion, such as a cyanide anion (CN-), a thiocyanic acid anion (SCN-), or an isothiocyanic acid anion (CNS⁻). A raw material for the synthesis of a nanoparticle (photoresponsive nanocrystal) described later can be appropriately selected from a salt with a counter cation in the A site and the B site, a salt with another cation, and the like, such as cesium chloride or lead bromide, depending on the synthesis method.

The nanoparticle (photoresponsive nanocrystal) in the present embodiment can be produced by a process as described below. The process is, for example, a hot injection method of mixing raw material liquids at high temperature and rapidly cooling the mixture after the formation of fine particles to produce a stable product or a ligand-assisted reprecipitation method of producing fine particles by reprecipitation utilizing a difference in miscibility of a product with a solvent. The production method may also be a room-temperature synthesis method of producing fine particles by mixing a liquid mixture of a raw material for the A site and a raw material for the B site, which are non-halides containing no component for the X site, with a separately prepared raw material liquid for the X site under a mild condition of approximately room temperature. The production method may also be a production method adopted in a mechanochemical method of producing product fine particles by a reaction of a solid raw material by mechanical mixing, such as milling, or ultrasonication, or in an in-situ synthesis method of applying a raw material liquid to a substrate and then producing a reaction product by direct crystal growth.

### (Shell-Like Ligand)

The shell-like ligand 20 in the ink composition 200 according to the present embodiment includes a plurality of binding portions 30 with a zwitterionic structural unit, and a polymer portion 40 (organic polymer portion 40) bound to the nanoparticle 10 at a plurality of positions via the plurality of binding portions 30.

The zwitterionic structural unit is a zwitterionic structural unit that has a positive charge and a negative charge at positions not adjacent to each other in the same molecule and that has no electric charge as a whole molecule. The zwitterionic structural unit includes a betaine structure, a quaternary ammonium salt, or the like. Thus, in other words, the shell-like ligand 20 according to the present embodiment is a ligand that has the plurality of binding portions 30 with a zwitterionic structural unit and the polymer portion 40 coordinated to the photoresponsive nanoparticle 10 via the plurality of binding portions 30. As illustrated in Fig. 1B, the binding portions 30 include a betaine structure 30b related to bonding to the nanoparticle 10 and a linking portion 30j related to bonding to the polymer portion 40 (organic polymer portion 40) and including a bonding arm 33 at an end. Furthermore, as illustrated in Figs. 1A to 1C, at least one of the binding portions 30 and the polymer portion 40 (organic polymer portion 40) has an organic group 30a or 40a. The organic group 30a extends to the outside of a shell structure constituted by the polymer portion 40 (organic polymer portion 40) through a discontinuous portion 40d of the polymer portion 40 (organic polymer portion 40) constituting the shell-like ligand 20. A portion where the polymer portions 40 (organic polymer portions 40) are not connected to each other is shown as the discontinuous portion 40d in Fig. 1B. The discontinuous portion 40d may extend in a network shape or a linear shape in the shell-like ligand 20 or may be discretely present as an independent hole opened in part of the polymer portion 40 (organic polymer portion 40) extending in a two-dimensional shape.

### (Organic Group)

The organic groups 30a and 40a may also be referred to as the organic groups 30a and 40a protruding outward from a shell portion constituted by the polymer portion 40 (organic polymer portion 40). In other words, an organic group protruding outward from the shell portion is an organic group present on the opposite side of the shell portion from the nanoparticle 10. The organic group may be an alkyl group, a heteroalkyl group, an aryl group, a heteroaryl group, an aralkyl group, or a heteroaralkyl group. Among these, the alkyl group and the heteroalkyl group may have a linear, branched, or cyclic structure and may be partially substituted. The aryl group, the heteroaryl group, the aralkyl group, and the heteroaralkyl group may be partially substituted. A linear alkyl group may also be referred to as a linear alkyl chain.

The organic group 30a is an organic group constituting the shell-like ligand 20 and corresponds to at least part of A₁ to A₅ in the formulae (1) to (3) described later. Likewise, the organic group 40a is an organic group constituting the shell-like ligand 20 and corresponds to part of at least one of R₆ and R₇ in the formula (4) described later. The organic group may be bound to an atom (for example, a carbon atom) in the polymer portion to which the linking group A₁, A₃, or A₅ is bound. The number of carbon atoms of each of the organic groups 30a and 40a is selected from values in a range in which compatibility with a polymerizable compound 50 is ensured and in a range in which the binding portions 30 and the polymer portion 40 (organic polymer portion 40) as the shell-like ligand 20 are formed. The number of carbon atoms of each of the organic groups 30a and 40a is preferably 2 or more, more preferably 4 or more.

The organic groups 30a and 40a according to the present embodiment protrude outward from the shell portion constituted by the polymer portion 40, are thereby compatibly mixed with the polymerizable compound 50 present outside a photoresponsive material 100, and co-disperse the photoresponsive material 100 and the polymerizable compound 50. In other words, the organic groups 30a and 40a according to the present embodiment protrude outward from the shell portion constituted by the polymer portion 40, are thereby compatibly mixed with the polymerizable compound 50 present outside the shell portion, and co-disperse the photoresponsive material 100 and the polymerizable compound 50. The organic groups 30a and 40a may also be referred to as a circumferential organic group or a radial organic group depending on the structure. The polymer portion 40 may also be referred to as the organic polymer portion 40.

Among the linking groups A1 to A5 and the functional groups R₆ and R₇ in the general formulae (1) to (4), the shell-like ligand 20 according to the present embodiment has an organic group protruding outward from the shell portion constituted by the polymer portion 40 (organic polymer portion 40). Among the linking groups A₁ to A₅ and the functional groups R₆ and R₇ in the general formulae (1) to (4), the ink composition 200 according to the present embodiment has an alkyl group protruding outward from the shell portion constituted by the polymer portion 40 (organic polymer portion 40).

In the ink composition 200 illustrated in Fig. 1A, the nanoparticle 10 with the shell-like ligand 20 coordinated on the surface thereof is stably dispersed in a medium containing a solvent 90 and the polymerizable compound 50 due to the organic groups 30a and 40a. The present inventors presume that this is an effect brought about by the organic groups 30a and 40a compatible with the polymerizable compound 50 in the medium due to an appropriate affinity (miscibility) for the polymerizable compound 50. In the present description, the bond between the binding portions 30 and the nanoparticle 10 corresponds to an ionic bond due to electrostatic interaction. In other words, the bond between the binding portions 30 and the nanoparticle 10 may be distinguished from a covalent bond and may correspond to a noncovalent bond.

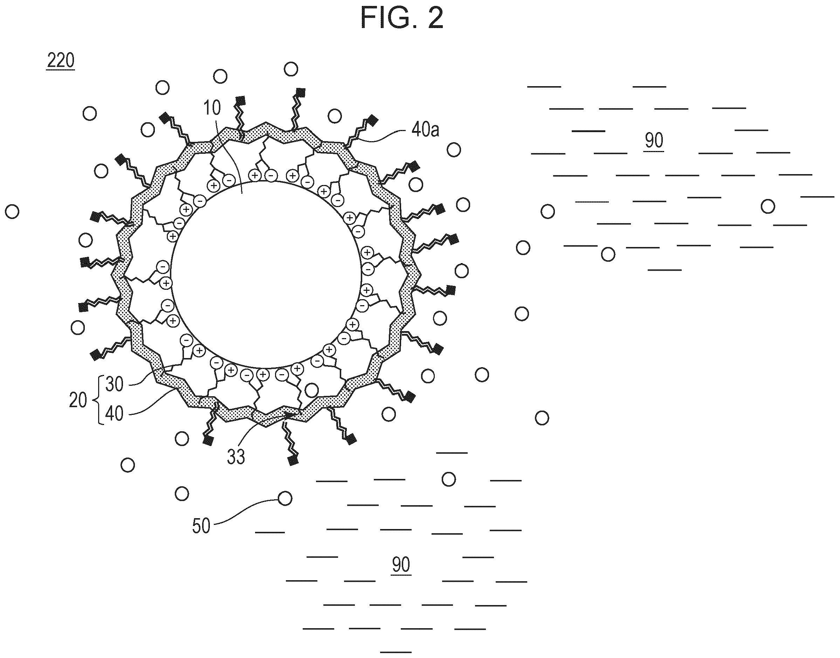

As illustrated in Figs. 1A to 1C and Fig. 2, to clearly show bonding due to electrostatic interaction, the betaine structure 30b is shown to have a pair of branched ends positively and negatively polarized in the molecule. The pair of positively and negatively polarized portions in the molecule in the betaine structure 30b corresponds to a polarization region located in a linear structure corresponding to any one of polarized portions in the structural unit represented by each of the formulae (1) and (2) .

The organic groups 30a and 40a extend to the outside of the shell-like polymer portion 40 (organic polymer portion 40), and this is probably caused by the difference in polarity between the organic groups 30a and 40b and the betaine structure 30b. More specifically, the binding portions 30 coordinate to the nanoparticle 10 by the betaine structure 30b with strong polarity, and the organic groups 30a and 40a with relatively low polarity extend approximately radially to the medium side on which the solvent 90 and the polymerizable compound 50 are present.

The organic groups 30a and 40a extending from the shell-like ligand 20 are compatibly mixed with the polymerizable compound 50 in the medium, and the nanoparticles 10 are therefore less likely to aggregate. Furthermore, the organic groups 30a and 40a extending from the shell-like ligand 20 are compatibly mixed with the polymerizable compound 50 in the medium, and the nanoparticle 10 is protected by the shell-like ligand 20 even when the nanoparticle 10 is close to a polar molecule or the polymerizable compound 50 in the solvent 90.

As illustrated in Fig. 1A, the photoresponsive nanoparticle 10 surrounded by the coordinated shell-like ligand 20 is dispersed in the solvent 90 and is protected from the solvent 90 and a polymerizable compound described later by the shell-like ligand 20. The nanoparticle 10 may also be protected from attack by a dispersed component or a dissolved component (not shown) dispersed or dissolved in the solvent 90. In other words, the zwitterionic structure is a form with a structural unit partially having an ionic property.

The shell-like ligand 20 including the structural unit with the betaine structure 30b can coordinate strongly to the surface of the nanoparticle 10 (photoresponsive nanocrystal). Furthermore, because the shell-like ligand 20 has a plurality of betaine structures 30b in the same molecule, even if some stimulus partially eliminates some coordination from the surface of the nanoparticle 10, the shell-like ligand 20 can coordinate easily again. Furthermore, a polymer chain of the polymer portion 40 (organic polymer portion 40) performs a protective function as a shell for the core of the nanoparticle 10 and reduces the effects of a substance, such as a polar solvent, on the nanoparticle 10. It is thought that this improves the stability of the structure and composition of the nanoparticle 10, which is a photoresponsive nanocrystal, and improves the stability of emission properties.

The shell-like ligand 20 according to the present embodiment has at least the binding portions 30 as a portion coordinated to the nanoparticle 10. In the shell-like ligand 20, the polymer portion 40 (organic polymer portion 40) coordinates so as to cover almost the entire periphery of the nanoparticle 10 except for part of the discontinuous portion 40d. In an embodiment of the present invention, the shell-like ligand 20 does not necessarily incompletely cover the outer periphery of the nanoparticle 10 and may cover the nanoparticle 10 at a coverage of 100%, as illustrated in Fig. 2. The coverage of the nanoparticle 10 with the shell-like ligand 20 has the same meaning as the coverage of the nanoparticle 10 with the polymer portion 40 (organic polymer portion 40) and may also be referred to as the coverage of the nanoparticle 10 with the polymer portion 40 (organic polymer portion 40).

From the perspective of the stability of the nanoparticle 10 in a polar solvent, the shell-like ligand 20 preferably has a number-average molecular weight of 1,000 or more and 50,000 or less. Likewise, the shell-like ligand 20 more preferably has a number-average molecular weight of 2,000 or more and 30,000 or less. When the ratio of the polymer portion 40 to the shell-like ligand 20 is dominant over the ratio of the binding portions 30 to the shell-like ligand 20, the number-average molecular weight of the polymer portion 40 may substitute for the number-average molecular weight of the shell-like ligand 20.

### (Binding Portion)

As illustrated in Fig. 1B, each binding portion 30 of the shell-like ligand 20 includes the betaine structure 30b related to bonding to the nanoparticle 10 and the linking portion 30j with the bonding arm 33 on the side opposite the betaine structure 30b. The bonding arm 33 is a portion related to bonding to the polymer portion 40 (organic polymer portion 40) and corresponds to a bonding arm 43 of the polymer portion 40 (organic polymer portion 40) illustrated in Fig. 1C.

Furthermore, each binding portion 30 has an organic group 30a in the linking portion 30j. The organic group 30a is compatibly mixed with the polymerizable compound 50 present in the medium and stabilizes the dispersion of the nanoparticle 10 coordinated by the shell-like ligand 20 in the medium.

The binding portions 30 of the shell-like ligand 20 have a structural unit represented by at least one of the formulae (1) to (5).

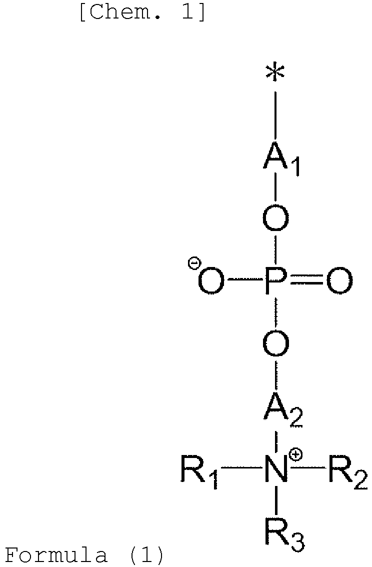

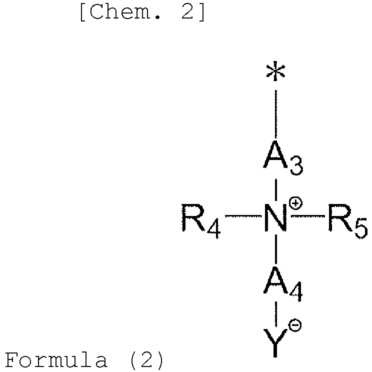

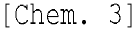

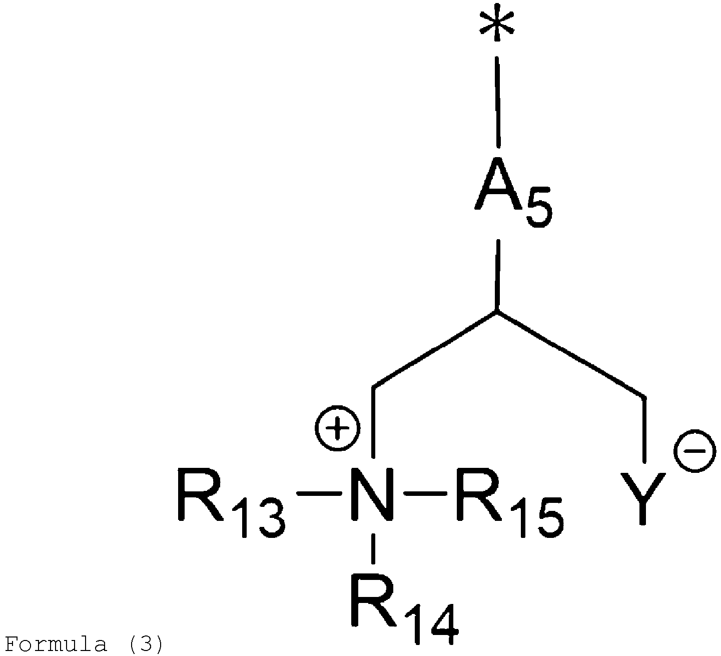

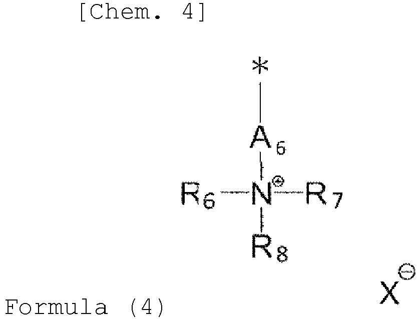

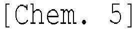

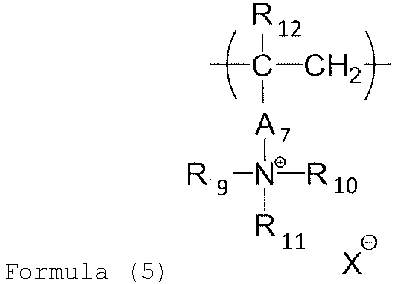

In the formulae (1) to (5), R₁ to R₅ and R₁₂ to R₁₅ each independently denote any one of a hydrogen atom and an alkyl group, R₆ to R₁₁ denote any one of an alkyl group and an aryl group, N denotes a nitrogen atom, A₁ to A₇ denote a linking group, X⁻ denotes an anion, Y⁻ denotes a COO⁻ group or a SO₃⁻group, and "*" denotes a bonding arm to the polymer portion.

In the present embodiment, the shell-like ligand 20 may be a copolymer having the polymer portion 40 (organic polymer portion 40) described later and the binding portions 30 with a structural unit.

The alkyl groups in R₁ to R₃ in the formula (1), R₄ and R₅ in the formula (2), and R₁₃ to R₁₅ in the formula (3) are preferably alkyl groups with 1 to 18 carbon atoms. Examples thereof include a methyl group, an ethyl group, a n-propyl group, an isopropyl group, a n-butyl group, a n-octyl group, a 2-ethylhexyl group, a dodecyl group, and an octadecyl group. These alkyl groups may be further substituted or may be bound together to form a ring.

In the formula (1), A₁ denotes a linking group that links the polymer main chain and the phosphate moiety. The linking group A₁ is any one of a carbonyl group, an alkylene group, an arylene group, and -COOR₂₀- (provided that the carbonyl group in -COOR₂₀- is bound to one other than the phosphate moiety, and R₂₀ denotes an alkylene with 1 or more and 4 or less carbon atoms). Furthermore, the betaine structure 30b may be directly bound by a single bond to the polymer main chain of the organic polymer portion 40.

The alkylene group in the linking group A₁ may be linear or branched and is preferably an alkylene group with 1 to 4 carbon atoms. The alkylene group with 1 to 4 carbon atoms may be a methylene group, an ethylene group, a propylene group, a butylene group, or the like.

The arylene group in the linking group A₁ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

In -COOR₂₀- in the linking group A₁, the carbonyl group of -COOR₂₀- is bound to one other than the phosphate moiety, and R₂₀ denotes an alkylene with 1 or more and 4 or less carbon atoms. The alkylene may be linear or branched.

The linking group A₁ may be further substituted with another functional group.

The linking group A₁ is more preferably a carbonyl group or -COOR₂₀- from the perspective of the availability of a raw material and the ease of production.

In the formula (1), A₂ denotes a linking group that links the phosphate moiety and the quaternary ammonium moiety and denotes any one of an alkylene group and an arylene group.

The alkylene group in the linking group A₂ may be linear or branched and is preferably an alkylene group with 1 to 4 carbon atoms.

Examples thereof include a methylene group, an ethylene group, a propylene group, and various butylene groups.

The arylene group in the linking group A₂ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The linking group may be further substituted.

From the perspective of the availability of a raw material and the ease of production, the linking group A₂ is more preferably a simple alkylene group, such as a methylene group or an ethylene group.

In the formula (2), A₃ denotes a linking group that links the polymer main chain and the quaternary ammonium moiety. The linking group A₃ may be an alkylene group, an arylene group, an aralkylene group, a-COOR₂₁-b, a-CONHR₂₁-b, a-OR₂₁-b, or the like. "a" denotes a binding site for one other than the quaternary ammonium moiety, "b" denotes a binding site for the quaternary ammonium moiety, and R₂₁ denotes an alkylene group or an arylene group. The betaine portion may be directly bound to the polymer main chain by a single bond.

The alkylene group in the linking group A₃ may be linear or branched and is preferably an alkylene group with 1 to 4 carbon atoms. Examples thereof include a methylene group, an ethylene group, a propylene group, and various butylene groups.

The arylene group in the linking group A₃ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The aralkylene group in the linking group A₃ is, for example, an aralkylene group with 7 to 15 carbon atoms.

When the linking group A₃ is a-COOR₂₁-b, a-CONHR₂₁-b, or a-OR₂₁-b, the alkylene group in R₂₁ may be linear or branched and is preferably an alkylene group with 1 to 4 carbon atoms. Examples thereof include a methylene group, an ethylene group, a propylene group, and various butylene groups. "a" denotes a binding site for one other than the quaternary ammonium moiety, "b" denotes a binding site for the quaternary ammonium moiety, and R₇ denotes an alkylene group or an arylene group.

The arylene group in R₂₁ is, for example, a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The linking group A₃ may be further substituted.

From the perspective of the availability of a raw material and the ease of production, the linking group A₃ is more preferably a-COOR₂₁-b or a-CONHR₂₁-b.

In the formula (2), A₄ denotes a linking group that links the quaternary ammonium moiety and the counter anion moiety Y⁻ thereof, and is, for example, an alkylene group, an arylene group, or the like.

In the formula (3), A₅ is a linking group that links the polymer main chain and the betaine moiety. The linking group A₅ may be an alkylene group, an arylene group, an aralkylene group, a-COOR₂₂-b, a-CONHR₂₂-b, a-OR₂₂-b, or the like. "a" denotes a binding site for one other than the betaine moiety, b denotes a binding site for the betaine moiety, and R₂₂ denotes an alkylene group or an arylene group. The betaine portion may be directly bound to the polymer main chain by a single bond.

The alkylene group in the linking group A₄ may be linear or branched and is preferably an alkylene group with 1 to 4 carbon atoms.

Examples thereof include a methylene group, an ethylene group, a propylene group, and various butylene groups.

The arylene group in the linking group A₂ may be a 1,2-phenylene group, a 1,3-phenylene group, a 1,4-phenylene group, a naphthalene-1,4-diyl group, a naphthalene-1,5-diyl group, a naphthalene-2,6-diyl group, or the like.

The linking group A₄ may be further substituted.

The linking group A₄ is not particularly limited as described above. From the perspective of the availability of a raw material and the ease of production, the linking group A₂ is more preferably a simple alkylene group, such as a methylene group, an ethylene group, or a propylene group.

In the formula (3), Y⁻ denotes a counter anion of the quaternary ammonium moiety and is covalently bound to the quaternary ammonium moiety via the linking group A₄. Y⁻denotes a COO⁻ group or a SO₃⁻ group.

In the formula (5), R₉ to R₁₁ each independently denote any one of an alkyl group and an aryl group, R₁₂ denotes any one of a hydrogen atom and an alkyl group, N denotes a nitrogen atom, A₇ denotes a linking group, and X⁻ denotes an anion.

The shell-like ligand 20 according to the present embodiment may include the binding portions 30 with a structure bound to the polymer main chain via the linking group A₇, as represented by the formula (5).

In the formula (5), the organic group in R₁₂ is preferably an alkyl group with 1 to 4 carbon atoms. Examples thereof include a methyl group, an ethyl group, a n-propyl group, an isopropyl group, and a n-butyl group. R₉ in the formula (5) can be arbitrarily selected from the substituents listed above and a hydrogen atom and is preferably a hydrogen atom or a methyl group from the perspective of the production of a polymer (polymerizability).

The shell-like ligand 20 according to the present embodiment is preferably a copolymer having the polymer portion 40 with the structural unit represented by any one of the formulae (6) to (8) together with the binding portions 30.

### (Polymer Portion)

As illustrated in Fig. 1C, the polymer portion 40 (organic polymer portion 40) in the shell-like ligand 20 has a polymer chain constituting a linear or branched shell structure, and the polymer chain has the bonding arm 43. The bonding arm 43 is a portion related to bonding to the binding portions 30 and corresponds to the bonding arm 33 of the binding portions 30 illustrated in Fig. 1B.

The polymer portion 40 (organic polymer portion 40) may have a plurality of bonding arms 33. The polymer portion 40 (organic polymer portion 40) and an adjacent polymer portion 40 (organic polymer portion 40) overlap and are entangled with each other, forming an organic polymer network constituting the shell-like ligand 20.

Illustrated in Fig. 1C. The discontinuous portion 40d is a gap between the adjacent organic polymers 40 and may have a plurality of forms, including a linear or branched slit type and an independent opening type corresponding to a mesh of an organic polymer chain constituting the shell structure.

Furthermore, the shell-like ligand 20 according to the present embodiment includes the organic group 30a in the linking portion 30j. The organic group 30a is compatibly mixed with the polymerizable compound 50 present in the medium and stabilizes the dispersion of the nanoparticle 10 coordinated by the shell-like ligand 20 in the medium.

The polymer portion 40 in the shell-like ligand 20 may be a polymer with a structural unit represented by any one of the following formulae (6) to (8). The polymer portion 40 with the structural unit of the formula (6) may also be referred to as the organic polymer portion 40, and the polymer portion 44 with the structural unit of the formula (7) or (8) may also be referred to as an organosilicon polymer portion 44.

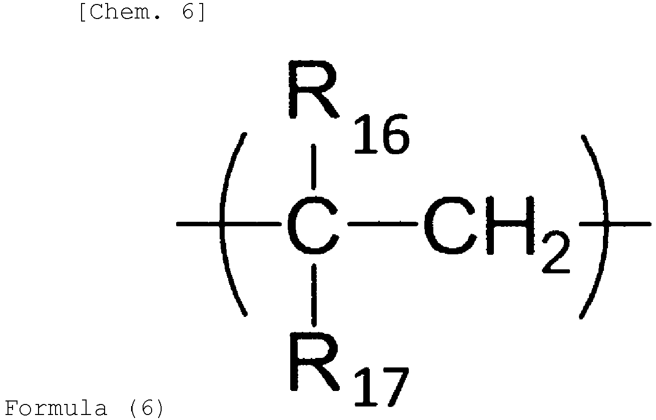

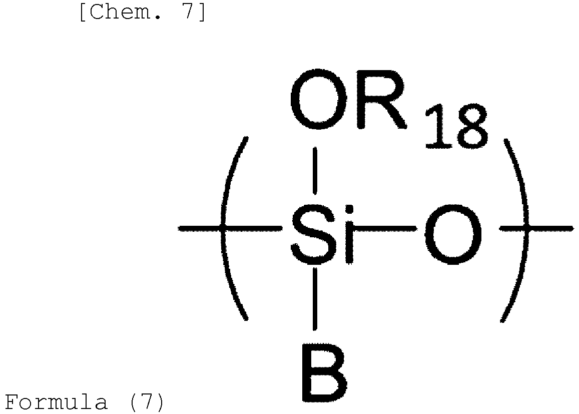

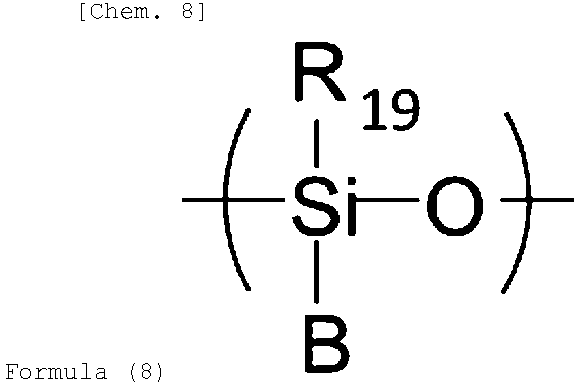

In the formulae (6) to (8), R₁₆ and R₁₈ each independently denote any one of a hydrogen atom and an alkyl group, and R₁₇ denotes any one of an alkyl group, a carboxylate group, a carboxamide group, an alkoxy group, and an aryl group. In the formulae (6) to (8), R₁₉ denotes an alkyl group, and B denotes a bonding arm to one of the binding portions.

The shell-like ligand 20 is also regarded as a copolymer of the binding portions 30 with at least one of the structural units represented by the formulae (1) to (5) and the polymer portion 40 (organic polymer portion 40) with at least one of the structural units represented by the formulae (6) to (8). Thus, the shell-like ligand 20 may also be referred to as a copolymer 20.

In the formula (6), R₁₆ denotes any one of a hydrogen atom and an alkyl group, and R17 denotes any one of an alkyl group, a carboxylate group, a carboxamide group, an alkoxy group, and an aryl group.

In the formula (6), the alkyl group in R₁₆ is preferably an alkyl group with 1 to 4 carbon atoms. Examples thereof include a methyl group, an ethyl group, a n-propyl group, an isopropyl group, and a n-butyl group. In the formula (6), R₁₆ preferably denotes a hydrogen atom or a methyl group from the perspective of the production of a copolymer (polymerizability).

In the formula (6), the alkyl group in R₁₇ is preferably an alkyl group with 1 to 30 carbon atoms. Examples thereof include a methyl group, an ethyl group, a n-propyl group, a n-butyl group, a n-hexyl group, a n-decyl group, a n-hexadecyl group, an octadecyl group, a docosyl group, and a triacontyl group.

In the formula (6), the aryl group in R₁₇ may be an aryl group, such as a phenyl group, a 1-naphthyl group, or a 2-naphthyl group.

In the formula (6), the carboxylate group in R₁₇ may be -COOR₂₄. R₂₄ denotes any one of an alkyl group with 1 to 30 carbon atoms, a phenyl group, and a hydroxyalkyl group with 1 to 30 carbon atoms. The carboxylate group in R₁₇ may be an ester group, such as a methyl ester group, an ethyl ester group, a n-propyl ester group, an isopropyl ester group, a n-butyl ester group, a tert-butyl ester group, an octyl ester group, a 2-ethylhexyl ester group, a dodecyl ester group, an octadecyl ester group, a docosyl ester group, a triacontyl ester group, a phenyl ester group, or a 2-hydroxyethyl ester group.

In the formula (6), the carboxamide group in R₁₇ may be -CO-NR₂₅R₂₆. R₂₅ and R₂₆ each independently denote any one of hydrogen, an alkyl group with 1 to 30 carbon atoms, and a phenyl group. The carboxamide group in R₁₇ may be an amide group, such as an N-methylamide group, an N,N-dimethylamide group, an N,N-diethylamide group, an N-isopropylamide group, an N-tert-butyramide group, an N-n-decylamide group, an N-n-hexadecylamide group, an N-octadecylamide group, an N-docosylamide group, an N-triacontylamide group, or an N-phenylamide group.

In the formula (6), the alkoxy group in R₁₇ may be an alkoxy group with 1 to 30 carbon atoms or a hydroxyalkoxy group with 1 to 30 carbon atoms. The alkoxy group in R₁₇ may be an alkoxy group, such as a methoxy group, an ethoxy group, a n-propoxy group, an isopropoxy group, a n-butoxy group, a n-hexyloxy group, a cyclohexyloxy group, a n-octyloxy group, a 2-ethylhexyloxy group, a dodecyloxy group, an octadecyloxy group, a docosyloxy group, a triacontyloxy group, or a 2-hydroxyethoxy group.

In the formula (6), a substituent in R₁₇ may be further substituted. In such a case, a substituent that may be substituted may be an alkoxy group, such as a methoxy group or an ethoxy group, an amino group, such as an N-methylamino group or an N,N-dimethylamino group, an acyl group, such as an acetyl group, or a halogen atom, such as a fluorine atom or a chlorine atom.

In the formula (6), R₁₆ and R₁₇ can be arbitrarily selected from the substituents listed above, and an appropriate substituent may be selected according to the intended use. For example, when the photoresponsive material is used in a highly hydrophobic medium, a substituent with a long-chain organic group is preferably selected to improve dispersibility and stability.

In the formula (7), R₁₈ can be arbitrarily selected from the substituents listed above and a hydrogen atom and is preferably a methyl group or an ethyl group from the perspective of the production of a copolymer (polymerizability).

Furthermore, the Si-OR₁₈ bond may be hydrolyzed and form a Si-O-Si bond. The Si-O-Si bond may be formed by an intermolecular condensation reaction or an intramolecular condensation reaction.

In the formula (7), R₁₈ can be arbitrarily selected from the substituents listed above, and an appropriate substituent may be selected according to the intended use.

The alkyl group in R₁₉ can be an alkyl group with 1 to 30 carbon atoms, preferably an alkyl group with 1 to 4 carbon atoms. Examples thereof include a methyl group, an ethyl group, a n-propyl group, an isopropyl group, and a n-butyl group.

For example, when the photoresponsive material is used in a highly hydrophobic medium, a substituent with a long alkyl chain is preferably selected to improve dispersibility and stability.

The copolymerization ratio of the shell-like ligand 20 corresponds to the ratio M30/M44 of the total number of moles M30 of the binding portions 30 including the structural unit represented by any one of the formulae (1) to (3) to the total number of moles M44 of the organosilicon polymer portion 44 including the structural unit represented by the formula (7) or (8). The copolymerization ratio of the shell-like ligand 20 is preferably 0.01/99.99 or more and 50/50 or less, more preferably 1/99 or more and 30/70 or less. A copolymerization composition ratio in such a range results in the shell-like ligand 20 strongly coordinated to the nanoparticle 10.

In the present embodiment, the mole ratio of a structural unit represented by any one of the formulae (1) to (3) to the structural unit represented by any one of the formulae (6) to (8) in the copolymer is preferably 2.0/98 or more and 50/50 or less. The mole ratio is more preferably 6/94 or more and 45/55 or less, still more preferably 10/90 or more and 40/60 or less.

A copolymerization composition ratio in such a range results in the shell-like ligand stably coordinated to the nanoparticle and the photoresponsive nanocrystal with a stabilized composition and crystal structure. In the present description, a photoresponsive nanoparticle may also be referred to as a photoresponsive nanocrystal, a photoresponsive nanoparticle, or simply a nanoparticle or a nanocrystal.

The amount of the shell-like ligand 20 corresponding to the polymer is appropriately adjusted according to the type and application of the nanoparticle 10, the binding portions 30, and the polymer portion 40, and is preferably 1 part by mass or more and 1000 parts by mass or less per 100 parts by mass of the nanoparticle 10 content. Furthermore, the shell-like ligand 20 content is preferably 3 parts by mass or more and 500 parts by mass or less, more preferably 10 parts by mass or more and 300 parts by mass or less. A shell-like ligand 20 content of less than 1 part by mass may result in an insufficient effect as a shell and unimproved stability. A shell-like ligand 20 content of more than 1000 parts by mass may result in the shell-like ligand 20 with reduced solubility and dispersibility in a medium and a photoresponsive material with unimproved stability. A shell-like ligand 20 content of more than 1000 parts by mass may result in an ink composition with increased viscosity. Each component content of the ink composition may be considered to be the charged amount when aggregation, reaction, decomposition, and the like at the time of blending can be negligible.

The shell-like ligand 20 content of the ink composition 200 is determined by TG-DTA measure of a mixture containing the nanoparticle 10 and the shell-like ligand 20. The mixture containing the nanoparticle 10 and the shell-like ligand 20 can be produced by adding a poor solvent for the mixture to the ink composition and precipitating and drying the mixture. For the nanoparticle 10 containing an organic component, the shell-like ligand 20 content can be determined by separately measuring the organic component content and subtracting the content from the ratio of the ink composition 200. The case where the nanoparticle 10 contains an organic component includes a case where the A site of the perovskite quantum dot is an organic compound.

The shell-like ligand 20 may coordinate to the surface of the nanoparticle 10 by a method of allowing the shell-like ligand 20 to replace a ligand described later after the synthesis of the nanoparticle 10, a method of allowing the shell-like ligand 20 to coexist for coordination during the synthesis of the nanoparticle 10, or the like. When the shell-like ligand 20 coordinates in place of the ligand as described above, an excess free ligand can be removed by centrifugation.

A method for producing the shell-like ligand 20 including the polymer portion 40 (organic polymer portion 40) is described in detail below. The shell-like ligand 20 including the polymer portion 40 (organic polymer portion 40) may also be referred to as the shell-like ligand 20 in the present description.

The shell-like ligand 20 may be produced by any method for producing the shell-like ligand 20 with the above structure, for example, by the following method (i) or (ii).

(i) The shell-like ligand 20 can be produced by a method of producing a monomer with a structural unit corresponding to one of the formulae (1) to (3) and then polymerizing the monomer. (ii) The shell-like ligand 20 can be produced by a method of synthesizing a polymer main chain and then bonding a zwitterionic moiety of one of the formulae (1 to (3) to the polymer main chain.

From the perspective of the availability of the monomer and control of the amount of functional group, the production method (i) is preferred. A method for synthesizing the shell-like ligand 20 including the structural unit represented by the formula (1) using the method (i) is described in detail below.

A monomer for introducing the structural unit represented by the formula (1) into the shell-like ligand 20 may be one of a plurality of derivatives depending on the structure of the linking group A₁. A monomer for introducing the structural unit represented by the formula (1) into the shell-like ligand 20 may be a vinyl ether derivative, an acrylate derivative, a methacrylate derivative, an α-olefin derivative, an aromatic vinyl derivative, or the like. From the perspective of the ease of production of the monomer, such a monomer is preferably an acrylate derivative or a methacrylate derivative.

A corresponding acrylate derivative or methacrylate derivative can be produced by a method described in the following literature.
K. Ishihara et al., "Polymer Journal", (Japan), the Society of Polymer Science, Japan, 1990, vol. 22, pp. 355-360.

The method for polymerizing the monomer may be radical polymerization or ionic polymerization, or living polymerization for the purpose of molecular weight distribution control or structure control. Industrially, radical polymerization is preferably used.

The radical polymerization can be performed by the use of a radical polymerization initiator, by irradiation with light, such as a radioactive ray or laser light, by a combined use of a photopolymerization initiator and irradiation with light, by heating, or the like. The radical polymerization initiator may be any radical polymerization initiator that can produce a radical and initiate a polymerization reaction, and is selected from compounds that produce a radical by the action of heat, light, radiation, a redox reaction, or the like.

Examples thereof include an azo compound, an organic peroxide, an inorganic peroxide, an organometallic compound, and a photopolymerization initiator.

More specifically, the radical polymerization initiator may be an azo compound, such as 2,2'-azobisisobutyronitrile (AIBN) or 2,2'-azobis(2,4-dimethylvaleronitrile), an organic peroxide, such as benzoyl peroxide (BPO), tert-butyl peroxypivalate, or tert-butyl peroxyisopropyl carbonate, an inorganic peroxide, such as potassium persulfate or ammonium persulfate, a redox initiator, such as a hydrogen peroxide-iron (II) salt system, a BPO-dimethylaniline system, or a cerium (IV) salt-alcohol system, or the like. The photopolymerization initiator may be an acetophenone, a benzoin ether, a ketal, or the like. These radical polymerization initiators may be used in combination of two or more thereof.

The polymerization temperature of the vinyl monomer has a preferred temperature range depending on the type of the polymerization initiator to be used and is not particularly limited. However, the polymerization is typically performed at a temperature in the range of -30°C to 150°C, more preferably 40°C to 120°C.

The amount of the polymerization initiator to be used is preferably adjusted in the range of 0.1 parts by mass or more and 20 parts by mass or less per 100 parts by mass of the monomer so as to produce the shell-like ligand 20 with a target molecular weight distribution.

The polymerization method may be, but is not limited to, solution polymerization, suspension polymerization, emulsion polymerization, dispersion polymerization, precipitation polymerization, bulk polymerization, or the like.

The resulting shell-like ligand 20 can be purified as required. The purification method can be, but is not limited to, reprecipitation, dialysis, column chromatography, or the like.

The structure of the shell-like ligand 20 thus produced can be identified by various instrumental analyses. A nuclear magnetic resonance spectrometer (NMR), gel permeation chromatography (GPC), an inductively coupled plasma emission spectrometer (ICP-AES), or the like can be used as an analyzer.

The copolymer is produced by any method for producing the copolymer with the above structure and is produced in the same manner as the shell-like ligand 20.

For example, the copolymer may be produced by producing a monomer with a structural unit corresponding to at least one of the formulae (1) to (3) and a monomer corresponding to the formula (4) and then polymerizing at least one of these monomers.

At this time, a polymerizable monomer other than the monomer with the structural unit corresponding to at least one of the formulae (1) to (3) and the monomer corresponding to the formula (6) may be further added for polymerization.

### (Non-Shell-Like Ligand)

The photoresponsive material 100 according to the present embodiment may have a non-shell-like ligand bound to the surface of a core containing a semiconductor nanoparticle with a perovskite crystal structure. The non-shell-like ligand may further improve stability, such as dispersion stability or spectral characteristics. The non-shell-like ligand may contain at least one compound or ion selected from the group consisting of an acid, such as carboxylic acid, sulfonic acid, or phosphonic acid, a base, such as ammonia or an amine, a betaine group, and a salt or ion thereof. From the perspective of dispersion stability, the non-shell-like ligand is preferably at least one compound or ion selected from the group consisting of an organic acid, an organic base, a salt or ion thereof, and a betaine group.

The organic acid is, for example, a branched or linear fatty acid with 1 to 30 carbon atoms. The fatty acid may be saturated or unsaturated. In particular, from the perspective of solubility and stability in a solvent, a linear fatty acid is preferred, and oleic acid is more preferred.

A salt component in an organic acid salt may be any metal cation. The salt component in the organic acid salt is preferably an alkali metal cation or an alkaline-earth metal cation, more preferably an alkali metal cation. Among alkali metal cations, sodium and potassium are preferred, and sodium is more preferred.

The organic base is, for example, a branched or linear organic base with 1 to 30 carbon atoms. The organic base may be saturated or unsaturated. In particular, from the perspective of solubility and stability in a solvent, a linear organic base is preferred, and oleylamine is more preferred.

The betaine group may be a compound with a phosphobetaine group, a sulfobetaine group, or a carboxybetaine group. From the perspective of solubility and stability in a solvent, a compound with a phosphobetaine group or a sulfobetaine group is preferred.

The non-shell-like ligand may be used alone or in combination of two or more thereof.

### (Polymerization Initiator)

In a polymerization reaction, a polymerization initiator and a polymerizable compound are typically used in combination. The polymerization initiator is a compound that produces an active species for initiating a polymerization reaction by active energy ray irradiation or heat, and can be a known polymerization initiator. A main active species for initiating a polymerization reaction may be a radical polymerization initiator for producing a radical or a cationic polymerization initiator for producing an acid. These may be used in combination. A radical photopolymerization initiator that produces a radical by active energy radiation is, for example, an acetophenone, such as diethoxyacetophenone, 2-hydroxy-2-methyl-1-phenylpropan-1-one, benzyl methyl ketal, 4-(2-hydroxyethoxy)phenyl-(2-hydroxy-2-propyl)ketone, 1-hydroxycyclohexyl phenyl ketone, 2-methyl-1-[4-(methylthio)phenyl]-2-morpholinopropan-1-one, 2-benzyl-2-dimethylamino-1-(4-morpholinophenyl)butane, oligo[2-hydroxy-2-methyl-1-[4-(1-methyl vinyl)phenyl]propanone], or 2-hydroxy-1-[4-[4-(2-hydroxy-2-methylpropionyl)benzyl]phenyl]-2-methylpropan-1-one; a benzoin, such as benzoin, benzoin methyl ether, benzoin ethyl ether, benzoin isopropyl ether, or benzoin isobutyl ether; a phosphine, such as 2,4,6-trimethylbenzoyl-diphenyl-phosphine oxide or bis(2,4,6-trimethylbenzoyl)-phenylphosphine oxide; or a phenyl glyoxylic methyl ester.

Among the radical photopolymerization initiators, an acetophenone, a phosphine, or an oxime ester compound exemplified by an aminoketone is preferred. These may be used alone or in combination depending on the characteristics required for a cured product. The amount of the radical polymerization initiator when used preferably ranges from 0.01 to 100 parts by mass, more preferably 0.1 to 50 parts by mass, per 100 parts by mass of the total solid amount of the composition.

### (Polymerizable Compound)

The ink composition 200 contains the polymerizable compound 50. The polymerizable compound 50 undergoes polymerization upon receiving energy, such as light or heat, and imparts viscosity to and cures the ink composition 200. The polymerizable compound 50 may be a radically polymerizable compound or a cationically polymerizable compound. These may be used alone or in combination of two or more thereof. Furthermore, either a photopolymerizable compound or a thermopolymerizable compound can be used.

The radically polymerizable compound is, for example, a monofunctional (meth)acrylate compound, a bifunctional (meth)acrylate compound, a trifunctional or higher functional (meth)acrylate compound, a (meth)acrylate compound with a hydroxy group, a (meth)acrylate compound with a carboxy group, a vinyl compound, or the like.

The monofunctional (meth)acrylate is, for example, methyl (meth)acrylate, ethyl (meth)acrylate, propyl (meth)acrylate, isopropyl (meth)acrylate, butyl (meth)acrylate, hexyl (meth)acrylate, 2-ethylhexyl (meth)acrylate, cyclohexyl (meth)acrylate, dicyclopentenyl (meth)acrylate, dicyclopentenyloxyethyl (meth)acrylate, benzyl (meth)acrylate, 3,3,5-trimethylcyclohexyl acrylate, tetrahydrofurfuryl (meth)acrylate, phenoxyethyl (meth)acrylate, methoxyethyl (meth)acrylate, ethylcarbitol (meth)acrylate, isobornyl (meth)acrylate, methoxytriethylene glycol (meth)acrylate, (2-methyl-2-ethyl-1,3-dioxolan-4-yl)methyl (meth)acrylate, (3-ethyloxetan-3-yl)methyl (meth)acrylate, or cyclic trimethylolpropaneformal (meth)acrylate.

The bifunctional (meth)acrylate compound is, for example, 1,4-butanediol di(meth)acrylate, 1,6-hexanediol di(meth)acrylate, 1,9-nonanediol di(meth)acrylate, ethylene glycol di(meth)acrylate, diethylene glycol di(meth)acrylate, triethylene glycol di(meth)acrylate, tetraethylene glycol di(meth)acrylate, poly(ethylene glycol) 200 di(meth)acrylate, poly(ethylene glycol) 300 di(meth)acrylate, poly(ethylene glycol) 400 di(meth)acrylate, poly(ethylene glycol) 600 di(meth)acrylate, dipropylene glycol di(meth)acrylate, tripropylene glycol di(meth)acrylate, tetrapropylene glycol di(meth)acrylate, poly(propylene glycol) 400 di(meth)acrylate, poly(propylene glycol) 700 di(meth)acrylate, neopentyl glycol di(meth)acrylate, neopentyl glycol PO-modified di(meth)acrylate, EO-modified bisphenol A di(meth)acrylate, PO-modified bisphenol A di(meth)acrylate, or neopentyl glycol hydroxypivalate di(meth)acrylate.

The trifunctional or higher functional (meth)acrylate compound is, for example, trimethylolpropane triacrylate, trimethylolpropane EO-modified tri(meth)acrylate, trimethylolpropane PO-modified tri(meth)acrylate, glycerin propoxy tri(meth)acrylate, pentaerythritol tri(meth)acrylate, tris(acryloxyethyl) isocyanurate, or EO-modified pentaerythritol tetraacrylate.

The (meth)acrylate compound with a hydroxy group is, for example, a hydroxyalkyl (meth)acrylate, such as 2-hydroxyethyl (meth)acrylate, 2-hydroxypropyl (meth)acrylate, 2-hydroxybutyl (meth)acrylate, 4-hydroxybutyl (meth)acrylate, or 6-hydroxyhexyl (meth)acrylate, 2-hydroxyethylacryloyl phosphate, 2-(meth)acryloyloxyethyl-2-hydroxypropyl phthalate, caprolactone-modified 2-hydroxyethyl (meth)acrylate, dipropylene glycol (meth)acrylate, fatty-acid-modified glycidyl (meth)acrylate, poly(ethylene glycol) mono(meth)acrylate, poly(propylene glycol) mono(meth)acrylate, 2-hydroxy-3-(meth)acryloyloxypropyl (meth)acrylate, glycerin di(meth)acrylate, or 2-hydroxy-3-acryloyl-oxypropyl methacrylate.

The (meth)acrylate compound with a carboxy group is, for example, β-carboxyethyl (meth)acrylate, a succinic acid mono(meth)acryloyloxyethyl ester, or ω-carboxy polycaprolactone mono(meth)acrylate.

The vinyl compound is, for example, vinyl acetate, vinyl benzoate, vinyl pivalate, vinyl butyrate, vinyl methacrylate, or N-vinylpyrrolidone.

The cationically polymerizable compound may be of a photopolymerization type or a thermal polymerization type. These may be used alone or in combination of two or more thereof. A typical cationically polymerizable compound is, for example, an epoxy compound, an oxetane compound, or a vinyl ether compound.

The amount of the polymerizable compound including the radically polymerizable compound and the cationically polymerizable compound to be used preferably ranges from 1 to 99 parts by mass, more preferably 3 to 90 parts by mass, still more preferably 5 to 80 parts by mass, per 200 parts by mass of the ink composition.

### (Solvent)

The ink composition 200 may contain a solvent 90 as required. The solvent 90 is, for example, an alkane, such as pentane or hexane, a cycloalkane, such as cyclopentane or cyclohexane, an ester, such as ethyl acetate, butyl acetate, or benzyl acetate, an ether, such as diethyl ether or tetrahydrofuran, a ketone, such as cyclohexanone or acetone, or an alcohol, such as methanol, ethanol, isopropanol, butanol, or hexanol. The solvent may also be a monoacetate compound, such as diethylene glycol monoethyl ether acetate, ethylene glycol monoethyl ether acetate, diethylene glycol monobutyl ether acetate, or dipropylene glycol methyl ether acetate, a diacetate compound, such as 1,4-butanediol diacetate or propylene glycol diacetate, or a triacetate compound, such as glyceryl triacetate.

To easily remove the solvent before curing the polymerizable compound 50, the solvent 90 has a boiling point of 300°C or less. The solvent 90 may also be referred to as a solvent medium 90.

### (Other Additive Agents)

In the present embodiment, if necessary, the ink composition may be used in a mixture with a deoxidizer, an antioxidant, a scattering agent, such as titanium oxide, a surfactant, a fungicide, a light stabilizer, an additive agent imparting other characteristics, a diluting solvent, or the like.

### (Wavelength Conversion Member)

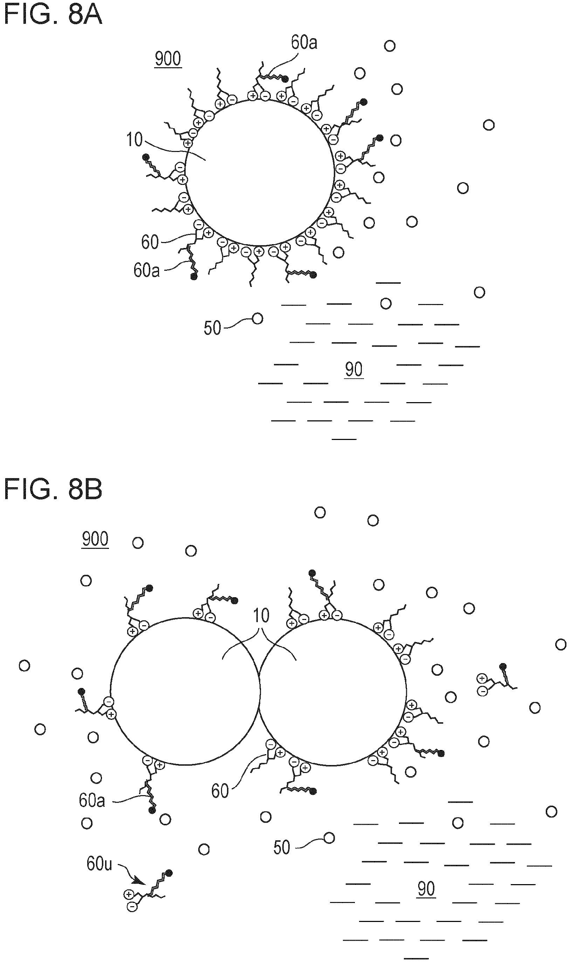

A wavelength conversion member according to the present embodiment is a member produced on a substrate by curing the ink composition 200 (the ink composition 200) containing the photoresponsive material 100 and the polymerizable compound 50 in a co-dispersion state illustrated in Fig. 8A. The wavelength conversion member has a layer form supported by another member and may be referred to as a wavelength conversion layer 520, as illustrated in Fig. 8B. The support form includes a layered form and a dispersed form dispersed in a matrix material. The wavelength conversion layer 520 may be a film, a sheet, or a patterned pixel produced by applying the ink composition 200 to a supporting member (substrate) and curing the composition.

### (Method for Forming Wavelength Conversion Layer)

The wavelength conversion layer 520 may be formed by any method, for example, a method of applying a photoresponsive material composition to a substrate, predrying the photoresponsive material composition as required, and heating the photoresponsive material composition or irradiating the photoresponsive material composition with an active energy ray as required to cure the film. The wavelength conversion layer after curing preferably has a thickness in the range of 0.1 to 200 um, more preferably 1 to 100 um.

The active energy ray in the active energy ray irradiation is appropriately selected from an electromagnetic wave, such as a heat ray, ultraviolet light, visible light, near-infrared light, or an electron beam, that reduces fluidity by polymerization, cross-linking, drying, or the like and promotes curing. A light source for applying the active energy ray is preferably a light source with a main emission wavelength in the wavelength region of 100 to 450 nm. Such a light source is, for example, an ultra-high-pressure mercury lamp, a high-pressure mercury lamp, a medium-pressure mercury lamp, a mercury-xenon lamp, a metal halide lamp, a high-power metal halide lamp, a xenon lamp, a pulsed xenon lamp, a deuterium lamp, a fluorescent lamp, a ND-YAG third harmonic laser, a HE-CD laser, a nitrogen laser, a XE-Cl excimer laser, a XE-F excimer laser, a semiconductor-pumped solid-state laser, an LED lamp light source with an emission wavelength of 365, 375, 385, 395, or 405 nm, or the like.

### <Second Embodiment>

Fig. 2 is a view of the dispersion state of an ink composition 220 according to a second embodiment. As illustrated in Fig. 2, in the ink composition 220 according to the present embodiment, the shell-like ligand 20 covers the entire sphere (corresponding to a solid angle of 4π) of the nanoparticle 10. The ink composition 220 according to the present embodiment is different from the ink composition 200 according to the first embodiment in that the organic group 40a compatible with the polymerizable compound 50 in the medium is derived from the polymer portion 40 (organic polymer portion 40), and no organic group derived from the binding portions 30 is contained.

The shell-like ligand 20 according to the present modified embodiment has at least a portion coordinated to the nanoparticle 10 as in the shell-like ligand 20 according to the first embodiment. The shell-like ligand 20 in the ink composition 220 has a discontinuous portion (not shown) that does not cover a portion of the nanoparticle 10. The discontinuous portion (not shown) that does not cover a portion of the nanoparticle 10 has a mesh opening formed by linear polymer portions 40 (organic polymer portions 40) extending in different directions overlapping along the shell of the shell-like ligand 20.

### <First Reference Embodiment>

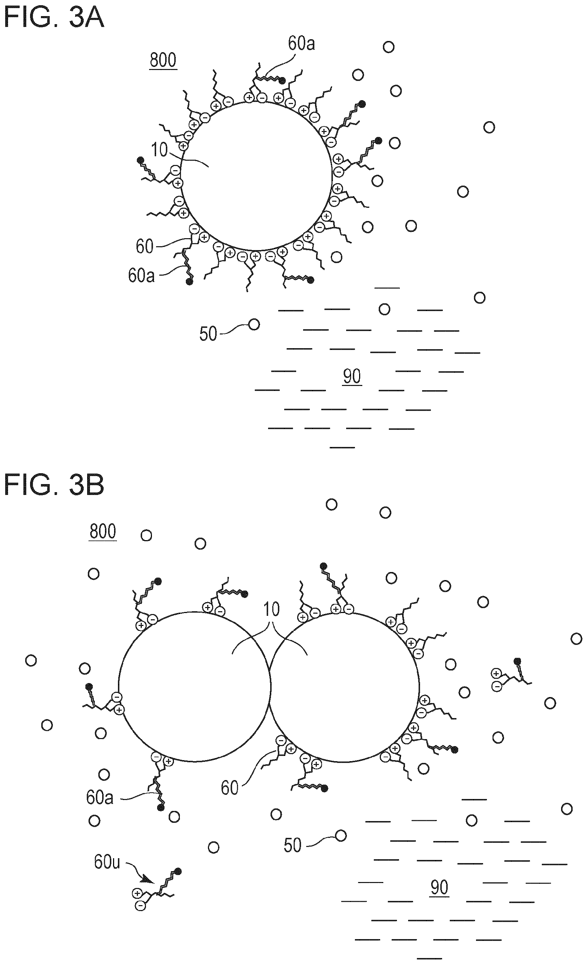

Figs. 3A and 3B are views of the dispersion state of an ink composition 800 according to a first reference embodiment immediately after preparation (Fig. 3A) and after the passage of time (Fig. 3B). A nanoparticle 10 corresponding to a quantum dot QD of the ink composition 800 according to the present reference embodiment has the betaine structure 30b but no shell-like ligand 20, and only a non-shell-like ligand 60 with a linear backbone or a branched backbone coordinates. Only the non-shell-like ligand 60 extending approximately radially from the surface of the nanoparticle 10 coordinates to the surface of the nanoparticle 10.

Thus, although the non-shell-like ligand 60 in the ink composition 800 has an organic group 60a, the non-shell-like ligand 60 is not strongly bound to the nanoparticle 10 in terms of coordination as compared with the ink composition 200 according to the first embodiment. Consequently, it is assumed that the ink composition 800 is easily attacked by the solvent 90 containing a polar molecule, and the nanoparticle 10 may partially have a change in the semiconductor composition. Furthermore, in the ink composition 800, the non-shell-like ligand 60 has the organic group 60a, but is easily separated from the nanoparticle 10, and cannot have sufficient compatibility with the polymerizable compound 50 in the medium. It is therefore assumed that the nanoparticles 10 may be aggregated, as illustrated in Fig. 3B. The aggregation of the nanoparticles 10 forms a coarse secondary particle and is considered to be responsible for a decrease in the quantum confinement effect and the quantum yield related to light emission.

### <Third Embodiment>

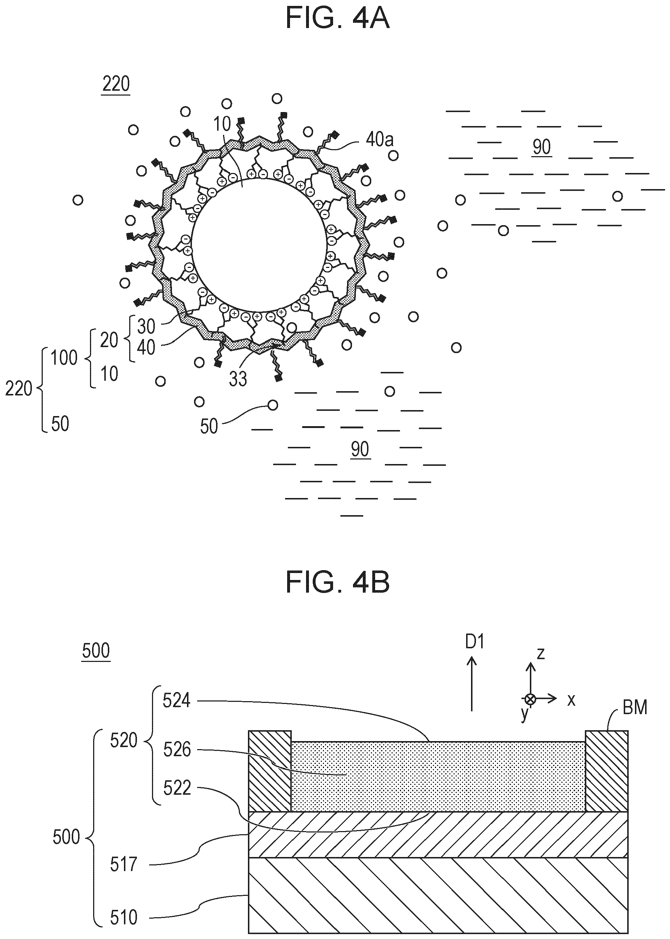

Fig. 4A is a view of the dispersion state of an ink composition 220 (photoresponsive composition 220) according to a third embodiment.

The ink composition 220 has increased viscosity and is cured due to the polymerization of a polymerizable compound contained therein. Thus, the ink composition 220 in Fig. 4A corresponding to the stage before curing is in the form of a fluid ink and may therefore be referred to as the ink composition 220. Curing may also be referred to as solidifying. The ink composition 220 contains the photoresponsive material 100 and the polymerizable compound 50 and may also be referred to as a light-emitting composition 220 or a photoresponsive composition 220. The ink composition 220 contains the photoresponsive material 100 and the polymerizable compound 50 co-dispersed in the solvent 90.

As illustrated in Fig. 4A, in the ink composition 220 according to the present embodiment, the shell-like ligand 20 covers the entire sphere (corresponding to a solid angle of 4π) of the nanoparticle 10. In the ink composition 220 according to the present embodiment, the organic group 40a compatible with the polymerizable compound 50 contained in the medium is a portion of the structure contained in the polymer portion 40 (organic polymer portion 40).

The shell-like ligand 20 according to the present modified embodiment has at least a portion coordinated to the nanoparticle 10. The shell-like ligand 20 in the ink composition 220 has a discontinuous portion (not shown) that does not cover a portion of the nanoparticle 10. The discontinuous portion (not shown) that does not cover a portion of the nanoparticle 10 has a mesh opening formed by linear polymer portions 40 (organic polymer portions 40) extending in different directions overlapping along the shell of the shell-like ligand 20.

An embodiment having an organic group as a portion of the structure of each binding portion is also included as a modified embodiment of the present embodiment. In such a modified embodiment (not shown), the organic group protrudes toward the outside of the shell-like ligand through the mesh of the network structure constituted by the polymer portions.

The ink composition 220 constitutes a film-like wavelength converter 526 by the polymerizable compound 50 being cured by polymerization.

### <Fourth Embodiment>

Fig. 4B illustrates a cross-sectional structure of a display element 500 according to a fourth embodiment.

The display element 500 includes a light-emitting layer 510, a dielectric multilayer film 517, and a wavelength conversion layer 520 stacked in the stacking direction D1. The downstream side in the stacking direction D1 corresponds to the side on which a user viewing an image on the display element is positioned. The wavelength conversion layer 520 is separated from a wavelength conversion layer corresponding to an adjacent element by a black matrix BM that separates pixels.

As described above, the ink composition 220 is cured together with the polymerizable compound 50 by polymerization treatment, such as photopolymerization treatment. The ink composition 220 is cured and constitutes the wavelength conversion layer 520 of the display element 500 satisfying a predetermined dimension. Thus, the wavelength conversion layer 520 is a layer solidified by being cured together with the polymerizable compound 50.

The light-emitting layer 510 corresponds to a light source that emits light L1 with a first wavelength λ1. The wavelength conversion layer 520 has an optical coupling surface 522 optically coupled to the light-emitting layer 510 on the side of the light-emitting layer 510 and has an extraction surface 524 for extracting secondary light L2 converted by the wavelength conversion layer 520 on the opposite side of the light-emitting layer 510.

The wavelength conversion layer 520 according to the present embodiment receives primary light L1 of a wavelength λ1 propagating through the dielectric multilayer film 917. The dielectric multilayer film 517 provides the display element 500 with the spectral transmission characteristics of the primary light from the light-emitting layer 510 and with the spectral reflection characteristics of the secondary light L2 of a wavelength λ2 emitted in the wavelength conversion layer 520. The wavelength λ2 of the secondary light L2 is longer than the wavelength λ1 of the primary light L1.

The dielectric multilayer film 917 can be replaced with another optical member optically transparent to light with the first wavelength λ1 emitted by the light-emitting layer 510. Furthermore, another optical member (not shown) can be disposed in front of the extraction surface 524 (on the side opposite the light-emitting layer 510).

### (Storage Method)

The photoresponsive properties of a photoresponsive nanoparticle are easily deteriorated not only by a polar solvent but also by light or heat. Thus, the ink composition 220 and the photoresponsive material 100 according to the present embodiment are preferably stored in a refrigerator or a darkroom shielded from external light. This can reduce the degradation of the ink composition 220 and the photoresponsive material 100 according to the present embodiment due to light or heat during storage.

### ((Measurement Method))

Various physical properties can be measured as described below.

### ((Measurement of Molecular Weight Distribution))

The molecular weight distribution of the shell-like ligand can be calculated in terms of monodisperse poly(methyl methacrylate) by gel permeation chromatography (GPC). The molecular weight can be measured by GPC, for example, in the following manner.

A sample is added to the following eluent at a sample concentration of 1% by mass and is allowed to stand at room temperature for 24 hours to dissolve the sample. The resulting solution is filtered through a solvent-resistant membrane filter with a pore size of 0.45 um to prepare a sample solution, which is subjected to measurement under the following conditions.
Apparatus: Agilent 1260 infinity system (manufactured by Agilent Technologies)
Column: PFG analytical linear M columns (manufactured by PSS)
Eluent: 2,2,2-trifluoroethanol
Flow rate: 0. 2 ml/min
Oven temperature: 40°C
Sample injection amount: 20µL

A molecular weight calibration curve prepared with a standard poly(methyl methacrylate) resin (EasiVial PM Polymer Standard Kit manufactured by Agilent Technologies) is used to calculate the molecular weight distribution of the sample.

### ((Composition Analysis))

The composition of the shell-like ligand can be analyzed by nuclear magnetic resonance (NMR). For example, 1H-NMR and 13C-NMR spectra are measured with ECA-600 (600 MHz) manufactured by JEOL Ltd. The measurement is performed at 25°C in a deuterated solvent containing tetramethylsilane as an internal standard substance. The chemical shift is read as a ppm shift (δ value) with the chemical shift value of the internal standard tetramethylsilane being 0.

### ((Crystal Structure Analysis))

The crystal structure and composition of the nanoparticle 10 can be analyzed by X-ray photoelectron spectroscopy (XPS). For example, the crystal structure can be analyzed by measuring an X-ray diffraction pattern using RINT 2100 (manufactured by Rigaku Corporation).

### ((Composition Analysis))

The composition of the nanoparticle 10 can be analyzed by XPS and ICP spectroscopy. The mole ratio of A and B can be measured from the signal intensity of XPS, and the concentration of X can be measured from the light emission intensity of ICP spectroscopy (for example, CIROS CCD (manufactured by SPECTRO)).

### ((Method for Verifying Coordination of Ligand to Nanoparticle))

Whether or not the shell-like ligand 20 coordinates to the nanoparticle 10 can be examined by infrared absorption spectroscopy (IR). A signal of a binding portion observed in the measurement of an IR absorption spectrum of the ink composition shows that the shell-like ligand 20 coordinates to the nanoparticle 10. At that time, the coordination may shift the signal of the binding portion by several nanometers. A nanoparticle may also be referred to as a photoresponsive nanoparticle, a photoresponsive nanocrystal, a light-emitting nanoparticle, a light-emitting nanocrystal, or a nanocrystal.

The coordination can also be examined by observation with a transmission electron microscope (TEM). In general, a photoresponsive nanoparticle with a perovskite crystal structure is observed in a regularly arranged form. When a shell-like ligand coordinates, however, steric repulsion between the shell-like ligands or steric repulsion between the shell-like ligand and a substrate disturbs the arrangement. The coordination can be examined in this respect.

### ((Photoresponsive Nanoparticle Content))

The photoresponsive nanoparticle content of a photoresponsive material or a photoresponsive composition can be measured by ICP spectroscopy and NMR. For example, the amount of Pb is measured from the light emission intensity of ICP spectroscopy, and the amount of ligand is measured from the signal intensity of NMR. The photoresponsive nanoparticle content can be determined from the composition information of the photoresponsive nanoparticle obtained by the above method.

### ((Polymer Content))

The polymer content of a photoresponsive material or a photoresponsive composition can be determined from the TG-DTA measurement described above or NMR integrated intensity.

### ((Betaine Group Content of Polymer))

The betaine group content of a polymer can be determined from the NMR integrated intensity ratio between the betaine portion and another moiety in the polymer.

### ((Number of Millimoles of Betaine Group per Gram of Photoresponsive Nanoparticle))

The number of millimoles of a betaine group per gram of a photoresponsive nanoparticle can be calculated from the photoresponsive nanoparticle content, the polymer content, and the betaine group content of a polymer determined by the methods described above.

### (Analysis of Anionic Species in Quaternary Ammonium Salt)

An anionic species in a quaternary ammonium salt can be analyzed by combustion-ion chromatography. A sample is burned in an airflow containing oxygen, the evolved gas is recovered, and the resulting ions are separated and quantified by ion chromatography to analyze anionic species. For example, an automatic sample combustion system AQF-2100 (manufactured by Mitsubishi Chemical Analytech Co., Ltd.) and an ion chromatograph IC-2010 (manufactured by Tosoh Corporation) can be used.

### <Fifth Embodiment>

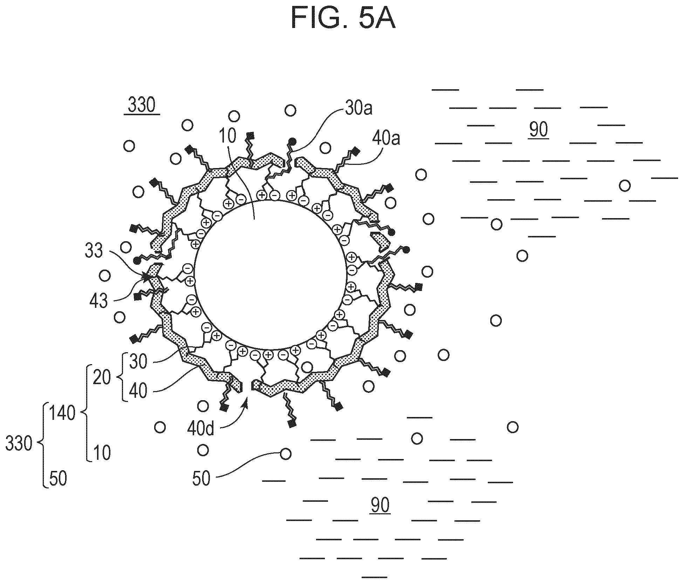

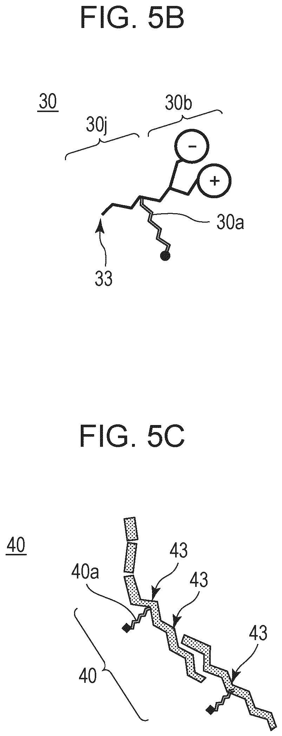

Next, an ink composition 330 according to a fifth embodiment is described using Figs. 5A, 5B, and 5C.

The ink composition 330 according to the present embodiment is different from the ink composition 200 according to the first embodiment and the ink composition 220 according to the second embodiment in that a quaternary ammonium salt is contained as a zwitterionic structural unit.

### (Shell-Like Ligand)

As illustrated in Fig. 5A, the ink composition 330 according to the present embodiment includes a photoresponsive nanoparticle 10 and a shell-like ligand 20 bound for coordination to the surface of the nanoparticle 10 at a plurality of positions. The shell-like ligand 20 has a plurality of binding portions 30 containing a quaternary ammonium salt 30b, and a polymer portion 40 bound to the nanoparticle 10 at a plurality of positions via the plurality of binding portions 30.

The quaternary ammonium salt 30b refers to a salt of a cation of an ammonia molecule tetrasubstituted with a substituent containing carbon and another anion. As illustrated in Fig. 5B, the binding portions 30 includes the quaternary ammonium salt 30b related to bonding to the nanoparticle 10 and a linking portion 30j related to bonding to the polymer portion 40 and including a bonding arm 33 at an end. Furthermore, as illustrated in Figs. 5A to 5C, at least one of the binding portions 30 and the polymer portion 40 has an organic group 30a or 40a. The organic group 30a extends to the outside of the shell through a discontinuous portion 40d of the polymer portion 40 constituting the shell-like ligand 20. A portion where the polymer portions 40 are not connected to each other is shown as the discontinuous portion 40d in Fig. 1B. The discontinuous portion 40d may extend in a network shape or a linear shape in the shell-like ligand 20 or may be discretely present as an independent hole opened in part of the polymer portion 40 extending in a two-dimensional shape.

The ink composition 330 illustrated in Fig. 5A is stably dispersed in a medium containing the medium 90 and the polymerizable compound 50 due to the organic groups 30a and 40a of the shell-like ligand 20 coordinated so as to cover the nanoparticle 10. The present inventors presume that this is an effect brought about by the organic groups 30a and 40a compatible with the polymerizable compound 50 in the medium due to an appropriate affinity (miscibility) for the polymerizable compound 50. In the present description, the bond between the binding portions 30 and the nanoparticle 10 corresponds to an ionic bond due to electrostatic interaction. In other words, the bond between the binding portions 30 and the nanoparticle 10 may be distinguished from a covalent bond and may correspond to a noncovalent bond.

The organic groups 30a and 40a extend to the outside of the shell-like polymer portion 40. This is assumed to be caused by the difference in polarity between the organic groups 30a and 40a and the quaternary ammonium salt 30b. More specifically, the binding portions 30 coordinate to the nanoparticle 10 by the quaternary ammonium salt 30b with strong polarity, and the organic groups 30a and 40a with relatively low polarity extend approximately radially to the medium side on which the medium 90 and the polymerizable compound 50 are present.

The organic groups 30a and 40a extending from the shell-like ligand 20 are compatibly mixed with the polymerizable compound 50 in the medium, and the nanoparticles 10 are therefore less likely to aggregate. Furthermore, the organic groups 30a and 40a extending from the shell-like ligand 20 are compatibly mixed with the polymerizable compound 50 in the medium, and the nanoparticle 10 is protected by the shell-like ligand 20 even when the nanoparticle 10 is close to a polar molecule or the polymerizable compound 50 in the medium 90.

As illustrated in Fig. 5A, the photoresponsive nanoparticle 10 surrounded by the coordinated shell-like ligand 20 is dispersed in the medium 90 and is protected from the medium 90 and the polymerizable compound described later by the shell-like ligand 20. The nanoparticle 10 may also be protected from attack by a dispersed component or a dissolved component (not shown) dispersed or dissolved in the medium 90.

The shell-like ligand 20 including a structural unit containing the quaternary ammonium salt 30b can coordinate strongly to the surface of the nanoparticle 10 (light-emitting nanocrystal).

Furthermore, because the shell-like ligand 20 has a plurality of quaternary ammonium salts 30b in the same molecule, even if some stimulus partially eliminates some coordination from the surface of the nanoparticle 10, the shell-like ligand 20 can coordinate easily again. Furthermore, a polymer chain of the polymer portion 40 performs a protective function as a shell for the core of the nanoparticle 10 and reduces the effects of a substance, such as a polar solvent, on the nanoparticle 10. It is thought that this improves the stability of the structure and composition of the nanoparticle 10, which is a light-emitting nanocrystal, and improves the stability of emission properties.

### <Sixth Embodiment>

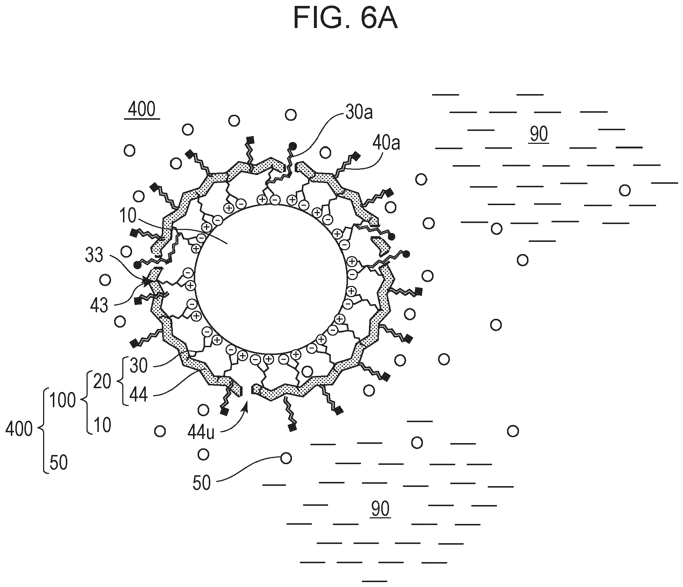

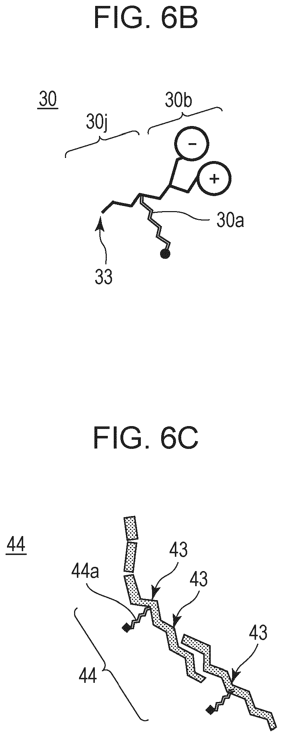

Next, an ink composition 400 according to a sixth embodiment is described below with reference to Figs. 6A, 6B, and 6C.

The ink composition 400 according to the present embodiment is different from the ink compositions 200, 220, and 330 according to the first, third, and fifth embodiments in that the ink composition 400 includes an organosilicon polymer portion 44 containing an organosilicon polymer as a structural unit corresponding to a polymer portion.

### (Organosilicon Polymer Portion)

As illustrated in Figs. 6A and 6C, the organosilicon polymer portion 44 in the shell-like ligand 20 according to the present embodiment has a polymer chain constituting a linear or branched shell structure. The polymer chain has a bonding arm 43. The bonding arm 43 is a portion related to bonding to the binding portions 30 and corresponds to the bonding arm 33 of the binding portions 30 illustrated in Fig. 6B. The shell-like ligand 20 with the organosilicon polymer portion 44 and the organosilicon polymer portion 44 may also be referred to as a silica shell 44.

The organosilicon polymer portion 44 may have a plurality of bonding arms 33. The organosilicon polymer portion 44 and an adjacent organosilicon polymer portion 44 overlap and are entangled with each other, forming an organic polymer network constituting the shell-like ligand 20.

A discontinuous portion 44u in Fig. 6A is a gap between adjacent organic polymers 40 and may have a plurality of forms, including a linear or branched slit type and an independent opening type corresponding to a mesh of an organic polymer chain constituting the shell structure.

The organosilicon polymer portion 44 contains a polysiloxane compound with Si-O- linked to the main chain. The organosilicon polymer portion 44 may be a copolymer having a structural unit represented by at least one of the formulae (7) and (8) and preferably contains a copolymer having structural units represented by the formulae (7) and (8). The organosilicon polymer portion 44 may also be referred to as a polysiloxane compound portion 44 or an organosilicon compound portion 44.

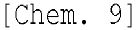

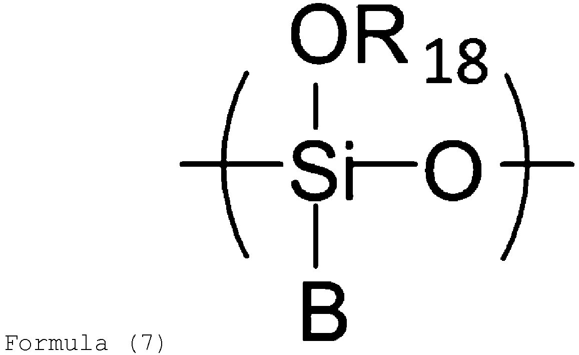

In the formula (7), R₁₈ denotes any one of a hydrogen atom and an alkyl group, and B denotes a bonding arm to one of the binding portions.

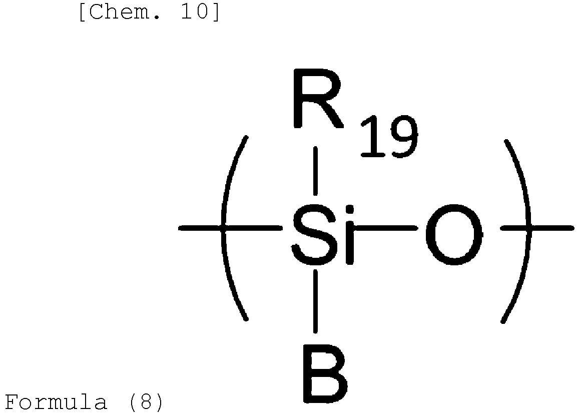

In the formula (8), R₁₉ denotes an alkyl group, and B denotes a bonding arm to one of the binding portions.

In the formula (7), R₁₈ can be arbitrarily selected from the substituents listed above and a hydrogen atom and is preferably a methyl group or an ethyl group from the perspective of the production of a copolymer (polymerizability).

Furthermore, the Si-OR₁₈ bond may be hydrolyzed and form a Si-O-Si bond. The Si-O-Si bond may be formed by an intermolecular condensation reaction or an intramolecular condensation reaction.

In the formula (7), R₁₈ can be arbitrarily selected from the substituents listed above, and an appropriate substituent may be selected according to the intended use.

The alkyl group in R₁₉ can be an alkyl group with 1 to 30 carbon atoms, preferably an alkyl group with 1 to 4 carbon atoms. Examples thereof include a methyl group, an ethyl group, a n-propyl group, an isopropyl group, and a n-butyl group.

In the formula (7), R₁₈ can be arbitrarily selected from the substituents listed above and a hydrogen atom and is preferably a methyl group or an ethyl group from the perspective of the production of a copolymer (polymerizability) .

Furthermore, the Si-OR₁₈ bond may be hydrolyzed and form a Si-O-Si bond. The Si-O-Si bond may be formed by an intermolecular condensation reaction or an intramolecular condensation reaction.

In the formula (7), R₁₈ can be arbitrarily selected from the substituents listed above, and an appropriate substituent may be selected according to the intended use.

The alkyl group in R₁₉ can be an alkyl group with 1 to 30 carbon atoms, preferably an alkyl group with 1 to 4 carbon atoms. Examples thereof include a methyl group, an ethyl group, a n-propyl group, an isopropyl group, and a n-butyl group.

In the formula (7), R₁₈ can be arbitrarily selected from the substituents listed above, and an appropriate substituent may be selected according to the intended use.

The alkyl group in R₁₉ can be an alkyl group with 1 to 30 carbon atoms, preferably an alkyl group with 1 to 4 carbon atoms. Examples thereof include a methyl group, an ethyl group, a n-propyl group, an isopropyl group, and a n-butyl group.

The copolymerization ratio of the shell-like ligand 20 corresponds to the ratio M30/M44 of the total number of moles M30 of the binding portions 30 including the structural unit represented by any one of the formulae (1) to (5) to the total number of moles M44 of the organosilicon polymer portion 44 including the structural unit represented by the formula (7) or (8). The copolymerization ratio of the shell-like ligand 20 is preferably 0.01/99.99 or more and 50/50 or less, more preferably 1/99 or more and 30/70 or less. A copolymerization composition ratio in such a range results in the photoresponsive material 100 with improved stability due to the shell-like ligand 20 strongly coordinated to the nanoparticle 10.

The organosilicon polymer portion 44 content may be appropriately adjusted according to the type and use of the nanoparticle 10 and the organosilicon polymer portion 44 and is 0.01% by weight or more and 10% by weight or less of the nanoparticle 10 content. The organosilicon polymer portion 44 content is preferably 0.05% by weight or more and 5% by weight or less, more preferably 0.1% by weight or more and 3% by weight or less. When the organosilicon polymer portion 44 content is less than 0.01% by weight, the effects as a shell are not sufficiently exhibited, and the dispersion stability of the nanoparticle 10 may not be maintained. An organosilicon polymer portion 44 content of more than 10% by weight may result in an organosilicon polymer portion with reduced solubility and dispersibility in a medium and a photoresponsive material with unimproved stability.

The organosilicon polymer portion 44 may be produced by any method, for example, by the following method.

The organosilicon polymer portion 44 can be produced by hydrolyzing betaine silane with an alkylsilane main chain connected to a betaine structure to form a Si-O-Si bond.

The organosilicon polymer portion 44 may be bound to the surface of the nanoparticle 10 by a method of coordinating a silane compound with the betaine structure 30b (hereinafter referred to as a betaine silane compound) after the synthesis of the nanoparticle 10 and then forming the organosilicon polymer portion 44 by hydrolysis. The organosilicon polymer portion 44 may also be bound to the surface of the nanoparticle 10 by a method of allowing a silane compound with the betaine structure 30b to coexist for bonding during the synthesis of the nanoparticle 10 and forming the organosilicon polymer portion by hydrolysis after purification.

The betaine silane compound can be a sulfobetaine silane compound with a SO₃- group as a counter anion of the quaternary ammonium moiety, a carboxybetaine silane compound with a COO⁻ group as a counter anion of the quaternary ammonium moiety, or a phosphobetaine silane compound with a HPO₃⁻ group as a counter anion of the quaternary ammonium moiety.

A sulfobetaine silane can be produced, for example, by a method described in the following literature. Langmuir 30. 38 (2014): 11386-11393.

A sulfobetaine silane compound can be produced by a reaction of an aminoalkyl silane with sultone. [3-(N,N-dimethylamino)propyl]trimethoxysilane is preferably used as an aminoalkyl silane due to the formation of a quaternary ammonium. The sultone may be a four- or five-membered ring sultone. The number of carbon atoms in the alkylene group of the linking group A₂ or A₄ that links the quaternary ammonium moiety and the counter anion moiety Y⁻ thereof is 3 when a four-membered ring sultone is used or 4 when a five-membered ring sultone is used.

A carboxybetaine silane compound can be produced, for example, by a method described in the following literature. RSC advances 6. 30 (2016): 24827-24834.

A phosphobetaine silane compound can be produced, for example, by a method described in the following literature. ACS applied materials & interfaces 2. 10 (2010): 2781-2788.

The structures of the produced organosilicon polymer portion and the raw material betaine silane compound can be identified by various instrumental analyses. A nuclear magnetic resonance spectrometer (NMR), gel permeation chromatography (GPC), an inductively coupled plasma emission spectrometer (ICP-AES), or the like can be used as an analyzer.

To make the photoresponsive material according to the present embodiment a photoresponsive material composition that cures in response to an external stimulus, a polymerizable monomer can also be used as a medium.

### <Seventh Embodiment>

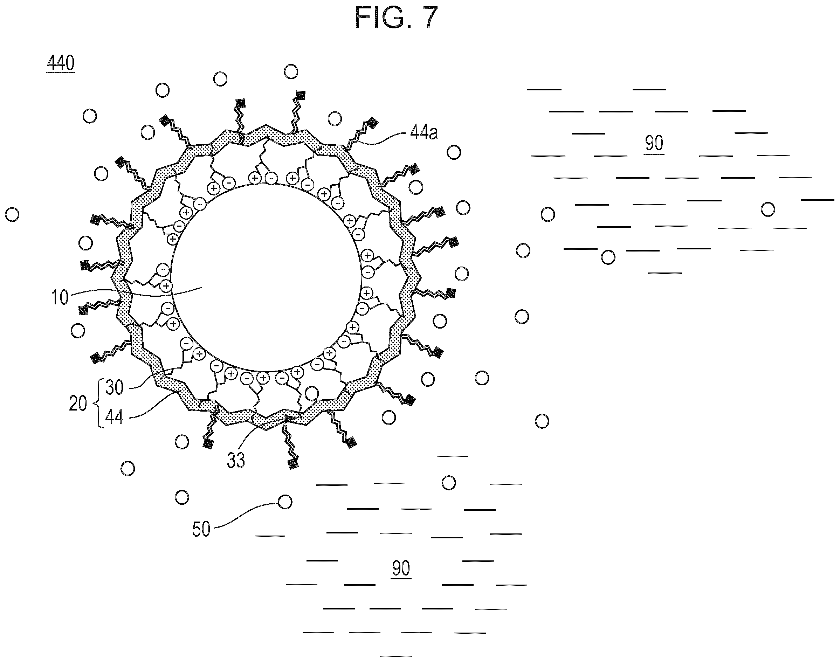

Next, an ink composition 440 according to a seventh embodiment is described with reference to Fig. 7.

As illustrated in Fig. 7, in the ink composition 440 according to the present embodiment, the shell-like ligand 20 covers the entire sphere (corresponding to a solid angle of 4π) of the nanoparticle 10. The ink composition 440 according to the present embodiment is different from the ink composition 400 according to the sixth embodiment in that an organic group 44a compatible with the polymerizable compound 50 in the medium is derived from the organosilicon polymer portion 44, and no organic group derived from the binding portions 30 is contained.

The shell-like ligand 20 according to the present modified embodiment has at least a portion coordinated to the nanoparticle 10 as in the shell-like ligand 20 according to the sixth embodiment. The shell-like ligand 20 in the ink composition 440 has a discontinuous portion (not shown) that does not cover a portion of the nanoparticle 10. The discontinuous portion (not shown) that does not cover a portion of the nanoparticle 10 has a mesh opening formed by linear organosilicon polymer portions 44 extending in different directions overlapping along the shell of the shell-like ligand 20.

Also in the ink composition 440 according to the present embodiment, the organic group 44a in the shell-like ligand 20 ensures compatibility with the polymerizable compound 50 in the medium, and the nanoparticle 10 protected by the shell-like ligand 20 stably maintains the dispersion state.

### <Second Reference Embodiment>

Figs. 8A and 8B are views of the dispersion state of an ink composition 900 according to a second reference embodiment immediately after preparation (a) and after 12 hours (b). A nanoparticle 10 corresponding to a quantum dot QD of the ink composition 900 according to the reference embodiment has the betaine structure 30b, but has no shell-like ligand 20, and only a non-shell-like ligand 60 with a linear backbone or a branched backbone coordinates. Only the non-shell-like ligand 60 extending approximately radially from the surface of the nanoparticle 10 coordinates to the surface of the nanoparticle 10.

Thus, although the non-shell-like ligand 60 in the ink composition 900 has an organic group 60a, the non-shell-like ligand 60 is not strongly bound to the nanoparticle 10 in terms of coordination as compared with the ink composition 400 according to the sixth embodiment. Consequently, it is assumed that the ink composition 900 is easily attacked by the solvent 90 containing a polar molecule, and the nanoparticle 10 may partially have a change in the semiconductor composition. Furthermore, in the ink composition 900, the non-shell-like ligand 60 has the organic group 60a, but is easily separated from the nanoparticle 10, and cannot have sufficient compatibility with the polymerizable compound 50 in the medium. It is therefore assumed that the nanoparticles 10 may be aggregated, as illustrated in Fig. 8B. The aggregation of the nanoparticles 10 forms a coarse secondary particle and is considered to be responsible for a decrease in the quantum confinement effect and the quantum yield related to light emission.

### <Eighth Embodiment>

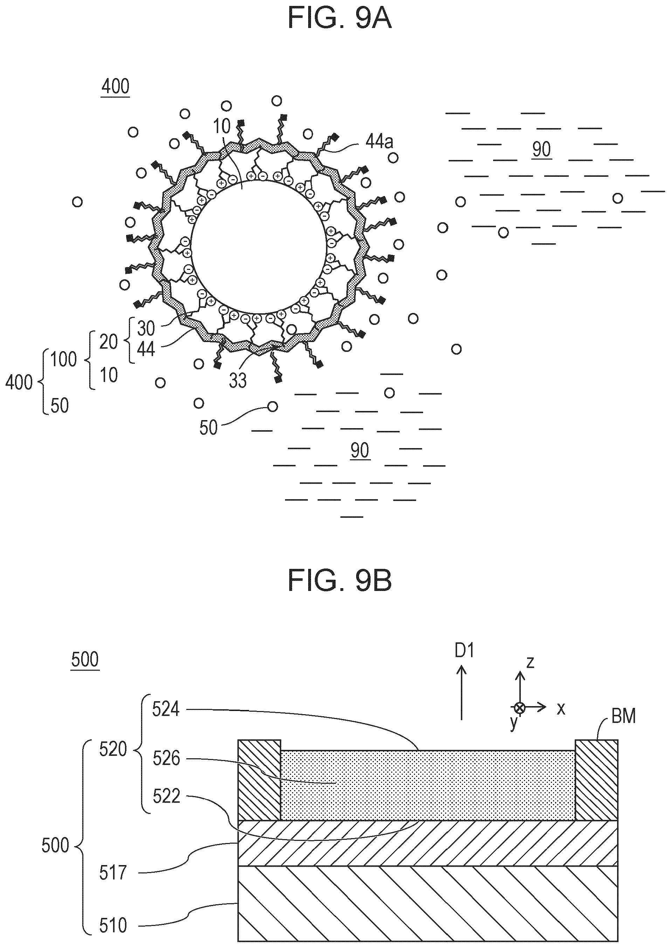

Fig. 9A is a view of the dispersion state of an ink composition 400 according to a third embodiment.

The ink composition 400 has increased viscosity and is cured due to the polymerization of a polymerizable compound contained therein. Thus, the ink composition 400 in Fig. 8A corresponding to the stage before curing is in the form of a fluid ink and may therefore be referred to as the ink composition 400. Curing may also be referred to as solidifying. The light-emitting material 200 contains the photoresponsive material 100 and the polymerizable compound 50. The light-emitting material 200 contains the photoresponsive material 100 and the polymerizable compound 50 dispersed in the solvent 90.

As illustrated in Fig. 9A, in the ink composition 400 according to the present embodiment, the shell-like ligand 20 substantially covers the entire sphere (corresponding to a solid angle of 4π) of the nanoparticle 10. The form in which the shell-like ligand 20 substantially covers the entire sphere of the nanoparticle 10 includes a form in which the organosilicon polymer portion 44 (polymer portion) locally has a discontinuous portion 44u. In the ink composition 400 according to the present embodiment, an organic group 40a compatible with the polymerizable compound 50 contained in the medium is a portion of the structure contained in the organosilicon polymer portion 44.

The shell-like ligand 20 according to the present modified embodiment has at least a portion coordinated to the nanoparticle 10. The shell-like ligand 20 in the ink composition 400 has a discontinuous portion (not shown) that does not cover a portion of the nanoparticle 10. The discontinuous portion (not shown) that does not cover a portion of the nanoparticle 10 has a mesh opening formed by linear organosilicon polymer portions 44 extending in different directions overlapping along the shell of the shell-like ligand 20.

An embodiment having an organic group as a portion of the structure of each binding portion is also included as a modified embodiment of the present embodiment. In such a modified embodiment (not shown), the organic group protrudes toward the outside of the shell-like ligand through the mesh of the network structure constituted by the polymer portions.

The ink composition 400 constitutes a film-like wavelength converter 526 by the polymerizable compound 50 being cured by polymerization.

### <Ninth Embodiment>

Fig. 9B illustrates a cross-sectional structure of a display element 500 according to a ninth embodiment.

The display element 500 includes a light-emitting layer 510, a dielectric multilayer film 517, and a wavelength conversion layer 520 stacked in the stacking direction D1. The downstream side in the stacking direction D1 corresponds to the side on which a user viewing an image on the display element is positioned. The wavelength conversion layer 520 is separated from a wavelength conversion layer corresponding to an adjacent element by a black matrix BM that separates pixels.

As described above, the ink composition 400 is cured together with the polymerizable compound 50 by polymerization treatment, such as photopolymerization treatment. The ink composition 400 is cured and constitutes the wavelength conversion layer 520 of the display element 500 satisfying a predetermined dimension. Thus, the wavelength conversion layer 520 is a layer solidified by being cured together with the polymerizable compound 50.

The light-emitting layer 510 corresponds to a light source that emits light L1 with a first wavelength λ1. The wavelength conversion layer 520 has an optical coupling surface 522 optically coupled to the light-emitting layer 510 on the side of the light-emitting layer 510 and has an extraction surface 524 for extracting secondary light L2 converted by the wavelength conversion layer 520 on the opposite side of the light-emitting layer 510.

The wavelength conversion layer 520 according to the present embodiment receives primary light L1 of a wavelength λ1 propagating through the dielectric multilayer film 917. The dielectric multilayer film 517 provides the display element 500 with the spectral transmission characteristics of the primary light from the light-emitting layer 510 and with the spectral reflection characteristics of the secondary light L2 of a wavelength λ2 emitted in the wavelength conversion layer 520. The wavelength λ2 of the secondary light L2 is longer than the wavelength λ1 of the primary light L1.

The dielectric multilayer film 917 can be replaced with another optical member optically transparent to light with the first wavelength λ1 emitted by the light-emitting layer 510. Furthermore, another optical member (not shown) can be disposed in front of the extraction surface 524 (on the side opposite the light-emitting layer 510).

### EXAMPLES

The present disclosure is described in more detail below with reference to a first exemplary embodiment group (Exemplary Embodiments 1-1 to 1-15), but the present disclosure is not limited thereto.

### [Production of Polymer a]

A reaction vessel equipped with a cooling tube, a stirrer, a thermometer, and a nitrogen inlet tube was charged with 17.9 parts of 2-(methacryloyloxy)ethyl 2-(trimethylammonio)ethyl phosphate, 82.1 parts of octadecyl methacrylate, 4.1 parts of azobisisobutyronitrile, and 900 parts of n-butanol, and nitrogen bubbling was performed for 30 minutes. The resulting reaction mixture was heated at 65°C for 8 hours in a nitrogen atmosphere to complete the polymerization reaction. The reaction liquid was cooled to room temperature, and the solvent was evaporated under reduced pressure. The resulting residue was dissolved in chloroform and was purified by dialysis using a dialysis membrane (Spectra/Por7 MWCO 1kDa manufactured by Spectrum Laboratories). The solvent was evaporated under reduced pressure, and a polymer 1-a was produced by drying at 50°C under a reduced pressure of 0.1 kPa or less.

The polymer 1-a was analyzed by the analysis method described above and was found to have a weight-average molecular weight (Mw) of 11800, and the structural unit represented by the formula (2) constituted 21% by mole of the total monomer units. The polymer 1-a may also be referred to as an intermediate raw material a or a precursor a of the shell-like ligand 20 coordinated to the particle surface of nanoparticles 1-10 dispersed in the solvent 90.

### [Production of Polymer 1-b]

A polymer 1-b was produced in the same manner as in the production of the polymer 1-a except that 48.1 parts of octyl methacrylate was used instead of octadecyl methacrylate.

### [Production of Polymer 1-c]

A polymer 1-c was produced in the same manner as in the production of the polymer 1-a except that 41.3 parts of hexyl methacrylate was used instead of octadecyl methacrylate.

### [Production of Polymer 1-d]

A polymer 1-d was produced in the same manner as in the production of the polymer 1-a except that 34.5 parts of butyl methacrylate was used instead of octadecyl methacrylate.

### [Production of Comparative Polymer 1-e]

A comparative polymer 1-e was produced in the same manner as the polymer 1-a except that 102.6 parts of octadecyl methacrylate was used instead of 17.9 parts of 2-(methacryloyloxy)ethyl 2-(trimethylammonio)ethyl phosphate and 82.1 parts of octadecyl methacrylate.

Table 1 shows the composition ratio and the weight-average molecular weight (Mw) of each of the polymers 1-a to 1-e produced as described above. In Table 1, X denotes a binding site of the structural unit represented by the formula (1) to the polymer main chain, and X' denotes a binding site of the structural unit represented by the formula (1) to the phosphate moiety. Y denotes a binding site of the structural unit represented by the formula (1) to the phosphate moiety, Y' denotes a binding site of the structural unit represented by the formula (1) to the quaternary ammonium salt moiety, and Z denotes a binding site of the structural unit represented by the formula (6) to the polymer main chain.

### [Table 1]

**Table 1**

| Polymer No. | Structure of polymer | | | | | | | Composition ratio (mole ratio) [formula (1):formula (6)] | Mw |
|---|---|---|---|---|---|---|---|---|---|
| | Formula (1) structure | | | | | Formula (6) structure | | | |
| | R₁ | R₂ | R₃ | A₁ | A₂ | R16 | R17 | | |
| Polymer 1-a | CH₃ | CH₃ | CH₃ | 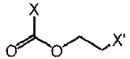 | Y-CH₂-CH₂-Y' | CH₃ | 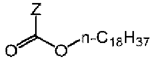 | 21:79 | 11,800 |
| Polymer 1-b | CH₃ | CH₃ | CH₃ | 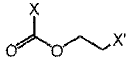 | Y-CH₂-CH₂-Y' | CH₃ | 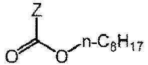 | 22:78 | 10,100 |
| Polymer 1-c | CH₃ | CH₃ | CH₃ | 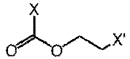 | Y-CH₂-CH₂-Y' | CH₃ | 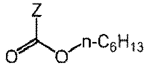 | 19:81 | 10,200 |
| Polymer 1-d | CH₃ | CH₃ | CH₃ | 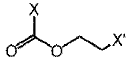 | Y-CH₂-CH₂-Y' | CH₃ | 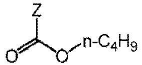 | 19:81 | 9,800 |
| Polymer 1-e | None | | | | | CH₃ | 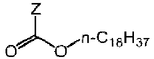 | - | 11,500 |

### [Production of Polymer 1-f]

A reaction vessel equipped with a cooling tube, a stirrer, a thermometer, and a nitrogen inlet tube was prepared. The reaction vessel was charged with 25.4 parts of 3-[[2-(methacryloyloxy)ethyl]dimethylammonio]propane-1-sulfonic acid, 36.1 parts of hexyl methacrylate, 4.1 parts of azobisisobutyronitrile, and 900 parts of 2,2,2-trifluoroethanol. Furthermore, nitrogen bubbling was performed on the reaction vessel for 30 minutes. The resulting reaction mixture was heated at 78°C for 8 hours in a nitrogen atmosphere to complete the polymerization reaction. The reaction liquid was cooled to room temperature, and the solvent was evaporated under reduced pressure. The resulting residue was dissolved in 2,2,2-trifluoroethanol and was purified by dialysis using a dialysis membrane (Spectra/Por7 MWCO 1kDa manufactured by Spectrum Laboratories). The solvent was evaporated under reduced pressure, and a polymer 1-f was produced by drying at 50°C under a reduced pressure of 0.1 kPa or less.

### [Production of Polymer 1-g]

A polymer 1-g was produced in the same manner as the polymer 1-n except that 22.8 parts of 2-[[2-(methacryloyloxy)ethyl]dimethylammonio]acetic acid and 33.5 parts of hexyl methacrylate were used instead of 3-[[2-(methacryloyloxy)ethyl]dimethylammonio]propane-1-sulfonic acid. Table 2 shows the composition ratio and the weight-average molecular weight (Mw) of each of the polymers 1-f and 1-g produced as described above. In Table 2, X denotes a binding site of the structural unit represented by the formula (5) to the polymer main chain, and X' denotes a binding site of the structural unit represented by the formula (5) to the quaternary ammonium moiety. In Table 2, Y denotes a binding site of the structural unit represented by the formula (2) to the quaternary ammonium moiety, Y' denotes a binding site of the structural unit represented by the formula (5) to the Y- moiety, and Z denotes a binding site of the structural unit represented by the formula (6) to the polymer main chain.

### [Table 2]

**Table 2**

| Polymer No. | Structure of polymer | | | | | | | Composition ratio (mole ratio) [formula (2):formula (6)] | Mw |
|---|---|---|---|---|---|---|---|---|---|
| | Formula (2) structure | | | | | Formula (6) structure | | | |
| | R₄ | R₅ | A₃ | A₄ | Y- | R₁₆ | R17 | | |
| Polymer 1-f | CH₃ | CH₃ | 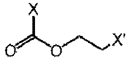 | Y-CH₂-Y' | SO₃⁻ | CH₃ | 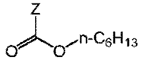 | 18:82 | 13,500 |
| Polymer 1-g | CH₃ | CH₃ | 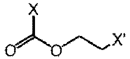 | Y-CH₂-Y' | CO₂⁻ | CH₃ | 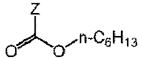 | 22:78 | 11,900 |

### (Exemplary Embodiment 1-1)

### [Preparation of Polymer 1- Solution]

### (Toluene Solution of Polymer 1-a)

A reaction vessel equipped with a stirrer, a thermometer, and a refluxing condenser was charged with 1 part of the polymer 1-a and 99 parts of toluene, was heated to 110°C, and was heated at this temperature for 5 minutes. After confirming that the polymer 1-a was completely dissolved, a toluene solution of the polymer 1-a was produced by cooling to room temperature.

### [Production of Nanoparticle 1-a]

10 parts of cesium carbonate, 27 parts of oleic acid, and 385 parts of 1-octadecene were placed in a flask, were heated to 120°C, and were degassed with a vacuum pump for 30 minutes. Furthermore, the liquid was heated to 150°C in a dry nitrogen stream and was held for 30 minutes to produce a cation raw material liquid.

Separately, 10 parts of lead (II) bromide and 494 parts of 1-octadecene were placed in a flask, were heated to 120°C, and were degassed with a vacuum pump for 1 hour. 89 parts of oleic acid and 31 parts of oleylamine were added, and the mixture was degassed with a vacuum pump for 30 minutes. The liquid temperature was then altered to 185°C in a nitrogen flow.

40 parts of the cation raw material liquid was added thereto, and the mixture was cooled with ice after 5 seconds. 2000 parts of ethyl acetate was added thereto, the mixture was centrifuged, and the supernatant was removed. The resulting residue was dispersed in toluene to adjust the solid concentration to 1% by weight. Thus, a dispersion liquid of a photoresponsive nanoparticle 1-a with a CsPbBr₃ perovskite crystal structure was produced.

### [Preparation of Ink Composition 1-1]

500 parts of the dispersion liquid of the nanoparticle 1-a was put in a vessel, and the solvent was evaporated under reduced pressure. 500 parts of the toluene solution of the polymer 1-a was added thereto, and the mixture was stirred for 3 hours. After the solvent was evaporated again under reduced pressure, 100 parts of 3,3,5-trimethylcyclohexyl acrylate (TMCHA) and 5 parts of 1-hydroxycyclohexyl phenyl ketone (Omnirad 184) were added thereto to produce an ink composition 1-1.

### (Exemplary Embodiments 1-2 to 4)

Ink compositions 1-2 to 1-4 were produced in the same manner as in Exemplary Embodiment 1-1 except that the polymers 1-b to 1-d were used instead of the polymer 1-a.

### (Exemplary Embodiment 1-5)

An ink composition 1-5 was produced in the same manner as in Exemplary Embodiment 1-3 except that tetrahydrofurfuryl acrylate (THFA) was used instead of TMCHA.

### (Exemplary Embodiment 1-6)

An ink composition 1-6 was produced in the same manner as in Exemplary Embodiment 1-3 except that 1,6-hexanediol diacrylate (HDDA) was used instead of TMCHA.

### (Exemplary Embodiment 1-7)

An ink composition 1-7 was produced in the same manner as in Exemplary Embodiment 1-3 except that cyclohexyl acrylate (CHA) was used instead of TMCHA.

### (Exemplary Embodiment 1-8)

An ink composition 1-8 was produced in the same manner as in Exemplary Embodiment 1-3 except that a mixture of 80 parts of THFA and 20 parts of HDDA was used instead of 100 parts of TMCHA.

### (Exemplary Embodiment 1-9)

An ink composition 1-9 was produced in the same manner as in Exemplary Embodiment 1-1 except that the polymer 1-f was used instead of the polymer 1-a.

### (Exemplary Embodiment 1-10)

An ink composition 1-10 was produced in the same manner as in Exemplary Embodiment 1-1 except that the polymer 1-g was used instead of the polymer 1-a.

### (Exemplary Embodiment 1-11)

An ink composition 1-11 was produced in the same manner as in Exemplary Embodiment 1-1 except that 250 parts of the toluene solution of the polymer 1-a was used instead of 500 parts of the toluene solution of the polymer 1-a, and THFA was used instead of TMCHA.

### (Exemplary Embodiment 1-12)

An ink composition 1-12 was produced in the same manner as in Exemplary Embodiment 1-1 except that 1000 parts of the toluene solution of the polymer 1-a was used instead of 500 parts of the toluene solution of the polymer 1-a, and THFA was used instead of TMCHA.

### [Production of Nanoparticle 1-b]

A dispersion liquid of a nanoparticle 1-b with a CsPb(Br/I)₃ perovskite crystal structure was produced in the same manner as the nanoparticle 1-a except that 3.2 parts of lead (II) bromide and 9.3 parts of lead (II) iodide were used instead of 10 parts of lead (II) bromide.

### (Exemplary Embodiment 1-13)

An ink composition 1-13 was produced in the same manner as in Exemplary Embodiment 1-1 except that the charged amount of the dispersion liquid of the photoresponsive nanoparticle 1-a was changed from 500 parts to 250 parts, and the charged amount of the toluene solution of the polymer 1-a was changed from 500 parts to 250 parts.

### [Production of Nanoparticle 1-c]

A dispersion liquid of a nanoparticle 1-c with a CsPbI₃ perovskite crystal structure was produced in the same manner as the photoresponsive nanocrystal dispersion liquid a except that 12.5 parts of lead (II) iodide was used instead of 10 parts of lead (II) bromide.

### (Exemplary Embodiment 1-14)

An ink composition 1-14 was produced in the same manner as in Exemplary Embodiment 1-1 except that the polymer 1-c was used instead of the polymer 1-a, and the nanoparticle 1-c was used instead of the nanoparticle 1-a.

### [Production of Nanoparticle 1-d]

First, an oleate solution of methylamine acetate was synthesized as described below. 40 parts of methylamine acetate and 1290 parts of oleic acid were mixed in a flask and were degassed with a vacuum pump at room temperature for 3 hours. The mixture was heated to 120°C and was degassed for 30 minutes to produce an oleate solution of methylamine acetate.

Next, an oleate solution of formamidine acetate was synthesized as described below. 46 parts of formamidine acetate and 1290 parts of oleic acid were mixed in a flask and were degassed with a vacuum pump at room temperature for 3 hours. The mixture was heated to 120°C and was degassed for 30 minutes to produce an oleate solution of formamidine acetate.

Separately, 10 parts of lead bromide, 129 parts of oleic acid, 59 parts of oleylamine, and 572 parts of octadecene were placed in a flask, were heated to 160°C, and were degassed with a vacuum pump for 100 minutes. 16 parts of the oleate solution of methylamine acetate and 77 parts of the oleate solution of formamidine acetate were mixed and added to the flask all at once. 10 seconds after the addition, the flask was cooled with ice. The ice-cooled solution was centrifuged, and the supernatant was removed. The resulting residue was dispersed in hexane and was further centrifuged to remove a precipitate. The solid concentration was adjusted to 1% by weight to produce a photoresponsive nanocrystal dispersion liquid d with a (MA/FA)PbBr₃ perovskite crystal structure.

### (Exemplary Embodiment 1-15)

An ink composition 1-15 was produced in the same manner as in Exemplary Embodiment 1-1 except that the polymer 1-c was used instead of the polymer 1-a, and the nanoparticle 1-d was used instead of the nanoparticle 1-a.

### (Comparative Example 1-1)

An ink composition 1-16 was produced in the same manner as in Exemplary Embodiment 1-1 except that 500 parts of toluene was used instead of 500 parts of the toluene solution of the polymer 1-a.

### (Comparative Example 1-2)

An ink composition 1-17 was produced in the same manner as in Exemplary Embodiment 1-1 except that the polymer 1-e was used instead of the polymer 1-a.

### (Comparative Example 1-3)

An ink composition 1-18 was produced in the same manner as in Comparative Example 1-1 except that THFA was used instead of TMCHA.

### (Comparative Example 1-4)

An ink composition 1-19 was produced in the same manner as in Exemplary Embodiment 1-1 except that 100 parts of a toluene solution of an octadecyl dimethyl(3-sulfopropyl)ammonium hydroxide inner salt (ligand a, manufactured by Tokyo Chemical Industry Co., Ltd.) was used instead of 500 parts of the toluene solution of the polymer 1-a.

For the ink compositions 1-1 to 1-19, Table 3 shows the type and concentration of the nanoparticle 1- and the type and concentration of the polymer 1-.

### [Table 3]

**Table 3**

| Exemplary Embodiment No. | Ink composition | Photoresponsive nanoparticle | | Polymer | | Polymerizable compound | | Polymerization initiator |
|---|---|---|---|---|---|---|---|---|
| | | Type | Parts | Type | Parts | Type | Parts | Parts |
| Exemplary Embodiment 1-1 | Ink composition 1-1 | CsPbBr₃ | 5 | Polymer 1-a | 5 | TMCHA | 100 | 5 |
| Exemplary Embodiment 1-2 | Ink composition 1-2 | CsPbBr₃ | 50 | Polymer 1-b | 5 | TMCHA | 100 | 5 |
| Exemplary Embodiment 1-3 | Ink composition 1-3 | CsPbBr₃ | 5 | Polymer 1-c | 5 | TMCHA | 100 | 5 |
| Exemplary Embodiment 1-4 | Ink composition 1-4 | CsPbBr₃ | 5 | Polymer 1-d | 5 | TMCHA | 100 | 5 |
| Exemplary Embodiment 1-5 | Ink composition 1-5 | CsPbBr₃ | 5 | Polymer 1-c | 5 | THFA | 100 | 5 |
| Exemplary Embodiment 1-6 | Ink composition 1-6 | CsPbBr₃ | 5 | Polymer 1-c | 5 | HDDA | 100 | 5 |
| Exemplary Embodiment 1-7 | Ink composition 1-7 | CsPbBr₃ | 5 | Polymer 1-c | 5 | CHA | 100 | 5 |
| Exemplary Embodiment 1-8 | Ink composition 1-8 | CsPbBr₃ | 5 | Polymer 1-c | 5 | THFA/HDDA=8/2 | 100 | 5 |
| Exemplary Embodiment 1-9 | Ink composition 1-9 | CsPbBr₃ | 5 | Polymer 1-f | 5 | TMCHA | 100 | 5 |
| Exemplary Embodiment 1-10 | Ink composition 1-10 | CsPbBr₃ | 5 | Polymer 1-g | 5 | TMCHA | 100 | 5 |
| Exemplary Embodiment 1-11 | Ink composition 1-11 | CsPbBr₃ | 5 | Polymer 1-c | 2.5 | THFA | 100 | 5 |
| Exemplary Embodiment 1-12 | Ink composition 1-12 | CsPbBr₃ | 5 | Polymer 1-c | 10 | THFA | 100 | 5 |
| Exemplary Embodiment 1-13 | Ink composition 1-13 | CsPb(Br/I)₃ | 5 | Polymer 1-c | 2.5 | TMCHA | 100 | 5 |
| Exemplary Embodiment 1-14 | Ink composition 1-14 | CsPbI₃ | 5 | Polymer 1-c | 2.5 | TMCHA | 100 | 5 |
| Exemplary Embodiment 1-15 | Ink composition 1-15 | (MA/FA)PbBr₃ | 5 | Polymer 1-c | 2.5 | TMCHA | 100 | 5 |
| Comparative Example 1-1 | Ink composition 1-16 | CsPbBr₃ | 5 | - | - | TMCHA | 100 | 5 |
| Comparative Example 1-2 | Ink composition 1-17 | CsPbBr₃ | 5 | Polymer 1-e | 5 | TMCHA | 100 | 5 |
| Comparative Example 1-3 | Ink composition 1-18 | CsPbBr₃ | 5 | - | - | THFA | 100 | 5 |
| Comparative Example 1-4 | Ink composition 1-19 | CsPbBr₃ | 5 | Ligand a | - | TMCHA | 100 | 5 |

The abbreviations in Table 3 are as follows:
TMCHA: 3,3,5-trimethylcyclohexyl acrylate (manufactured by Osaka Organic Chemical Industry Ltd.)
HDDA: 1,6-hexanediol diacrylate (manufactured by Osaka Organic Chemical Industry Ltd.)
THFA: tetrahydrofurfuryl acrylate (manufactured by Osaka Organic Chemical Industry Ltd.)
CHA: cyclohexyl acrylate (manufactured by Osaka Organic Chemical Industry Ltd.)

### (Evaluation of Ink Compositions 1-1 to 1-16)

The particle size distribution and the absolute photoluminescence quantum yield (hereinafter referred to as PLQY) of the ink compositions 1-1 to 1-16 were measured for initial evaluation. The ink composition 1 was then allowed to stand for 14 days at a humidity of 70%RH and at a temperature of 25°C in a constant temperature and humidity chamber, and the particle size distribution and PLQY were then measured for evaluation after the passage of time. The particle size distribution was measured with Zetasizer Nano ZS (manufactured by Malvern), and the arithmetic mean diameter (on a number basis) of the particle size distribution was used as a measured value. The evaluation criteria are described below.

### <Evaluation Criteria for Initial Particle Size>

A: initial particle size of less than 20 nm
B: initial particle size of 20 nm or more and less than 50 nm
C: initial particle size of 50 nm or more and less than 80 nm
D: initial particle size of 80 nm or more [0296]

### <Evaluation Criteria for Particle Size Change>

A: particle size change of less than twice
B: particle size change of twice or more and less than three times
C: particle size change of three times or more and less than four times
D: particle size change of four times or more

The particle size change is defined by the particle size after the passage of time/the initial particle size.

PLQY is the number of photons of fluorescence when the number of excitation photons absorbed by a photoresponsive nanocrystal is taken as 1. The measurement conditions and evaluation criteria are described below.

### <Measurement Conditions>

Measuring apparatus: absolute PL quantum yield measurement system C9920-03 (manufactured by Hamamatsu Photonics K.K.)
Excitation light wavelength: 460 nm
Excitation light integration range: excitation light wavelength ± 10 nm
Light emission integration range: (excitation light wavelength + 20) nm to 770 nm

### <Evaluation Criteria>

A: absolute PLQY change rate of less than 10%
B: absolute PLQY change rate of 10% or more and less than 25%
C: absolute PLQY change rate of 25% or more and less than 40%
D: absolute PLQY change rate of 40% or more

Table 4 shows the results.

### [Table 4]

**Table 4**

| Exemplary Embodiment No. | Ink composition | Initial particle size | Particle size change | PLQY change |
|---|---|---|---|---|
| Exemplary Embodiment 1-1 | Ink composition 1-1 | A | A | B |
| Exemplary Embodiment 1-2 | Ink composition 1-2 | A | A | A |
| Exemplary Embodiment 1-3 | Ink composition 1-3 | B | A | A |
| Exemplary Embodiment 1-4 | Ink composition 1-4 | B | A | A |
| Exemplary Embodiment 1-5 | Ink composition 1-5 | A | A | A |
| Exemplary Embodiment 1-6 | Ink composition 1-6 | A | A | A |
| Exemplary Embodiment 1-7 | Ink composition 1-7 | A | A | A |
| Exemplary Embodiment 1-8 | Ink composition 1-8 | A | A | A |
| Exemplary Embodiment 1-9 | Ink composition 1-9 | A | A | A |
| Exemplary Embodiment 1-10 | Ink composition 1-10 | A | A | C |
| Exemplary Embodiment 1-11 | Ink composition 1-11 | A | A | B |
| Exemplary Embodiment 1- 12 | Ink composition 1-12 | A | A | A |
| Exemplary Embodiment 1-13 | Ink composition 1-13 | B | A | A |
| Exemplary Embodiment 1-14 | Ink composition 1-14 | B | A | A |
| Exemplary Embodiment 1-15 | Ink composition 1-15 | A | A | A |
| Comparative Example 1-1 | Ink composition 1-16 | A | D | D |
| Comparative Example 1-2 | Ink composition 1-17 | A | D | C |
| Comparative Example 1-3 | Ink composition 1-18 | C | D | D |
| Comparative Example 1-4 | Ink composition 1-19 | A | D | C |

Table 4 shows that the ink compositions 1-1 to 1-15 according to Exemplary Embodiments 1-1 to 1-15 of the present invention have a small initial particle size for a plurality of media and have a small particle size change and a small PLQY change. This is probably because the shell-like ligand 20 with the betaine structure 30b in the binding portions 30 coordinates strongly to the nanoparticle 1-10, the organic group 30a or 40a is compatibly mixed with the polymerizable compound 50, and the photoresponsive material 100 therefore has high dispersion stability.

On the other hand, in the ink compositions 1-17 to 1-19 without the shell-like ligand 20 in Comparative Examples 1-1 to 1-4, although the initial particle size was small in some cases, the particle size increased and PLQY decreased over time. It is presumed that a coarse secondary particle is formed.

The present disclosure is described in more detail below with reference to a second exemplary embodiment group (Exemplary Embodiments 2-14 to 2-28), but the present disclosure is not limited thereto.

### [Production of Polymer 2-a]

A reaction vessel equipped with a cooling tube, a stirrer, a thermometer, and a nitrogen inlet tube was charged with 15.8 parts of [2-(methacryloyloxy)ethyl]trimethylammonium chloride (80% aqueous solution), 82.1 parts of octadecyl methacrylate, 4.1 parts of azobisisobutyronitrile, and 900 parts of n-butanol, and nitrogen bubbling was performed for 30 minutes. The resulting reaction mixture was heated at 65°C for 8 hours in a nitrogen atmosphere to complete the polymerization reaction. The reaction liquid was cooled to room temperature, and the solvent was evaporated under reduced pressure. The resulting residue was dissolved in chloroform and was purified by dialysis using a dialysis membrane (Spectra/Por7 MWCO 1kDa manufactured by Spectrum Laboratories). The solvent was evaporated under reduced pressure, and a polymer 2-a was produced by drying at 50°C under a reduced pressure of 0.1 kPa or less.

The polymer 2-a was analyzed by the analysis method described above and was found to have a weight-average molecular weight (Mw) of 21,000, and the monomer with the partial structure represented by the formula (1) constituted 21% by mole of the total monomer units.

### [Production of Polymer 2-b]

A solution of 1.3 parts of sodium bromide dissolved in 2.7 parts of water was slowly added to a solution of 5 parts of the polymer 2-a dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-b.

### [Production of Polymer 2-c]

A polymer 2-c was produced in the same manner as the polymer 2-b except that a solution of 1.9 parts of sodium iodide dissolved in 2.0 parts of water was used instead of the solution of 1.3 parts of sodium bromide dissolved in 2.7 parts of water.

### [Production of Polymer 2-d]

A polymer 2-d was produced in the same manner as the polymer 2-b except that a solution of 0.39 parts of sodium bromide and 1.3 parts of sodium iodide dissolved in 2.7 parts of water was used instead of the solution of 1.3 parts of sodium bromide dissolved in 2.7 parts of water.

### [Production of Polymer 2-e]

A solution of 1.9 parts of sodium iodide dissolved in 2.0 parts of water was slowly added to a solution of 5 parts of the polymer 2-, which was produced in the same manner as the polymer 2-a except that 29.3 parts of [2-(methacryloyloxy)ethyl]trimethylammonium chloride (80% aqueous solution) and 63.4 parts of octadecyl methacrylate were used instead of 15.8 parts of [2-(methacryloyloxy)ethyl]trimethylammonium chloride (80% aqueous solution) and 82.1 parts of octadecyl methacrylate, dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-e.

### [Production of Polymer 2-f]

A polymer 2-af was produced in the same manner as the polymer 2-a except that 48.1 parts of octyl methacrylate was used instead of 82.1 parts of octadecyl methacrylate. A solution of 1.9 parts of sodium iodide dissolved in 2.0 parts of water was slowly added to a solution of 5 parts of the polymer 2-af dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-f.

### [Production of Polymer 2-g]

A polymer 2-ag was produced in the same manner as the polymer 2-a except that 41.3 parts of hexyl methacrylate was used instead of 82.1 parts of octadecyl methacrylate. A solution of 1.9 parts of sodium iodide dissolved in 2.0 parts of water was slowly added to a solution of 5 parts of the polymer 2-ag dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-g.

### [Production of Polymer 2-h]

A polymer 2-ah was produced in the same manner as the polymer 2-a except that 34.5 parts of butyl methacrylate was used instead of 82.1 parts of octadecyl methacrylate. A solution of 1.9 parts of sodium iodide dissolved in 2.0 parts of water was slowly added to a solution of 5 parts of the polymer 2-ah dissolved in 95 parts of tetrahydrofuran, and the mixture was stirred at room temperature for 2 hours. The resulting liquid was subjected to reprecipitation treatment with water, was washed with methanol, and was then dried under vacuum at 50°C for 2 hours to produce a polymer 2-h.

### [Production of Comparative Polymer 2-i]

A polymer 2-i for leather was produced in the same manner as the polymer 2-a except that 108 parts of octadecyl methacrylate was used instead of 15.8 parts of [2-(methacryloyloxy)ethyl]trimethylammonium chloride (80% aqueous solution) and 82.1 parts of octadecyl methacrylate.

Table 5 shows the composition ratio and the weight-average molecular weight (Mw) of each of the polymers 2-a to 2-i produced as described above. In Table 5, "a" denotes a binding site for a carbon atom to which R₁₂ in the formula (5) is bound, "b" denotes a binding site for the quaternary ammonium moiety, and "c" denotes a binding site for a carbon atom to which R₅ in the formula (6) is bound.

### [Table 5]

**Table 5**

| Polymer No. | Structure of polymer | | | | | | | | Composition ratio (mole ratio) [formula (5):formula (6)] | Mw |
|---|---|---|---|---|---|---|---|---|---|---|
| | Formula (5) structure | | | | | | Formula (6) structure | | | |
| | R₉ | R₁₀ | R₁₁ | R₁₂ | A₇ | X | R16 | R17 | | |
| Polymer 2-a | CH₃ | CH₃ | CH₃ | CH₃ | 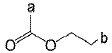 | Cl | CH₃ | 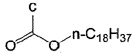 | 21:79 | 21,000 |
| Polymer 2-b | CH₃ | CH₃ | CH₃ | CH₃ | 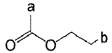 | Br | CH₃ | 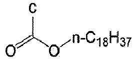 | 21:79 | 21,300 |
| Polymer 2-c | CH₃ | CH₃ | CH₃ | CH₃ | 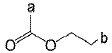 | I | CH₃ | 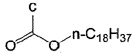 | 21:79 | 21,500 |
| Polymer 2-d | CH₃ | CH₃ | CH₃ | CH₃ | 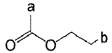 | Br_{0.3}I_{0.7} | CH₃ | 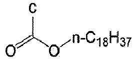 | 21:79 | 21,400 |
| Polymer 2-e | CH₃ | CH₃ | CH₃ | CH₃ | 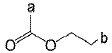 | I | CH₃ | 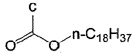 | 39:61 | 18,700 |
| Polymer 2-f | CH₃ | CH₃ | CH₃ | CH₃ | 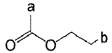 | I | CH₃ | 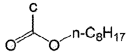 | 20:80 | 20,500 |
| Polymer 2-g | CH₃ | CH₃ | CH₃ | CH₃ | 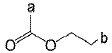 | I | CH₃ | 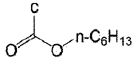 | 22:78 | 19,800 |
| Polymer 2-h | CH₃ | CH₃ | CH₃ | CH₃ | 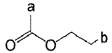 | I | CH₃ | 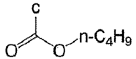 | 20:80 | 19,400 |
| Polymer 2-i | None | | | | | - | CH₃ | 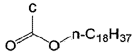 | 0:100 | 11,500 |

### (Exemplary Embodiment 2-1)

### [Preparation of Polymer 2- Solution]

### (Toluene Solution of Polymer 2-a)

A reaction vessel equipped with a stirrer, a thermometer, and a refluxing condenser was charged with 0.5 parts of the polymer 2-a and 99.5 parts of toluene, was heated to 110°C, and was heated at this temperature for 5 minutes. After confirming that the polymer 2-a was completely dissolved, a toluene solution of the polymer 2-a was produced by cooling to room temperature.

### [Production of Nanoparticle Dispersion Liquid 2-a]

10 parts of cesium carbonate, 27 parts of oleic acid, and 385 parts of 1-octadecene were placed in a flask, were heated to 120°C, and were degassed with a vacuum pump for 30 minutes. Furthermore, the liquid was heated to 150°C in a dry nitrogen stream and was held for 30 minutes to produce a cation raw material liquid.

Separately, 10 parts of lead (II) bromide and 494 parts of 1-octadecene were placed in a flask, were heated to 120°C, and were degassed with a vacuum pump for 1 hour. 89 parts of oleic acid and 31 parts of oleylamine were added, and the mixture was degassed with a vacuum pump for 30 minutes. The liquid temperature was then altered to 185°C in a nitrogen flow.

40 parts of the cation raw material liquid was added thereto, and the mixture was cooled with ice after 5 seconds. 2000 parts of ethyl acetate was added thereto, the mixture was centrifuged, and the supernatant was removed. The residue was dispersed in toluene to adjust the solid concentration to 1% by weight. Thus, a nanoparticle dispersion liquid 2-a with a CsPbBr₃ perovskite crystal structure was produced. The peak wavelength was 512 nm.

### [Preparation of Photoresponsive Material 2-1]

A dry nitrogen stream was blown to 10 parts of the nanoparticle dispersion liquid 2-a to remove the solvent. 10 parts of the toluene solution of the polymer 2-a was added thereto, and the mixture was stirred for 3 hours to produce a photoresponsive material 2-1.

### (Exemplary Embodiment 2-2)

A photoresponsive material 2-2 was produced in the same manner as in Exemplary Embodiment 2-1 except that the polymer 2-b was used instead of the polymer 2-a.

### (Exemplary Embodiment 2-3)

A photoresponsive material 2-3 was produced in the same manner as in Exemplary Embodiment 2-1 except that 1 part of the polymer 2-b and 99 parts of toluene were used instead of 0.5 parts of the polymer 2-a and 99.5 parts of toluene.

### (Exemplary Embodiment 2-4)

A photoresponsive material 2-4 was produced in the same manner as in Exemplary Embodiment 2-1 except that 1 part of the polymer 2-c and 99 parts of toluene were used instead of 0.5 parts of the polymer 2-a and 99.5 parts of toluene.

### [Production of Nanoparticle Dispersion Liquid 2-b]

A nanoparticle dispersion liquid 2-b with a CsPb(Br_{0.3}/I_{0.7})₃ perovskite crystal structure was produced in the same manner as the nanoparticle dispersion liquid 2-a except that 3.2 parts of lead (II) bromide and 9.3 parts of lead (II) iodide were used instead of 10 parts of lead (II) bromide. The peak wavelength was 640 nm.

### (Exemplary Embodiment 2-5)

A photoresponsive material 2-5 was produced in the same manner as in Exemplary Embodiment 2-1 except that the nanoparticle b was used instead of the nanoparticle dispersion liquid 2-a.

### (Exemplary Embodiment 2-6)

A photoresponsive material 2-6 was produced in the same manner as in Exemplary Embodiment 2-1 except that the nanoparticle b was used instead of the nanoparticle dispersion liquid 2-a and that the polymer 2-b was used instead of the polymer 2-a.

### (Exemplary Embodiment 2-7)

A photoresponsive material 2-7 was produced in the same manner as in Exemplary Embodiment 2-1 except that the nanoparticle b was used instead of the nanoparticle dispersion liquid 2-a and that the polymer 2-c was used instead of the polymer 2-a.

### (Exemplary Embodiment 2-8)

A photoresponsive material 2-8 was produced in the same manner as in Exemplary Embodiment 2-1 except that the nanoparticle b was used instead of the nanoparticle dispersion liquid 2-a and that 1 part of the polymer 2-c and 99 parts of toluene were used instead of 0.5 parts of the polymer 2-a and 99.5 parts of toluene.

### (Exemplary Embodiment 2-9)

A photoresponsive material 2-9 was produced in the same manner as in Exemplary Embodiment 2-1 except that the nanoparticle b was used instead of the nanoparticle dispersion liquid 2-a and the polymer 2-d was used instead of the polymer 2-a.

### (Exemplary Embodiment 2-10)

A photoresponsive material 2-10 was produced in the same manner as in Exemplary Embodiment 2-1 except that the nanoparticle b was used instead of the nanoparticle dispersion liquid 2-a and the polymer 2-e was used instead of the polymer 2-a.

### [Production of Nanoparticle Dispersion Liquid 2-c]

A nanoparticle dispersion liquid 2-c with a CsPbI₃ perovskite crystal structure was produced in the same manner as the nanoparticle dispersion liquid 2-a except that 12.5 parts of lead (II) iodide was used instead of 10 parts of lead (II) bromide. The peak wavelength was 690 nm.

### (Exemplary Embodiment 2-11)

A photoresponsive material 2-11 was produced in the same manner as in Exemplary Embodiment 2-1 except that the nanoparticle c was used instead of the nanoparticle dispersion liquid 2-a.

### (Exemplary Embodiment 2-12)

A photoresponsive material 2-12 was produced in the same manner as in Exemplary Embodiment 2-1 except that the nanoparticle c was used instead of the nanoparticle dispersion liquid 2-a and the polymer 2-b was used instead of the polymer 2-a.

### (Exemplary Embodiment 2-13)

A photoresponsive material 2-13 was produced in the same manner as in Exemplary Embodiment 2-1 except that the nanoparticle c was used instead of the nanoparticle dispersion liquid 2-a and the polymer 2-c was used instead of the polymer 2-a.

### (Comparative Example 2-1)

A photoresponsive material 2-14 was produced in the same manner as in Exemplary Embodiment 2-1 except that 100 parts of toluene was used instead of 0.5 parts of the polymer 2-a and 99.5 parts of toluene.

### (Comparative Example 2-2)

A photoresponsive material 2-15 was produced in the same manner as in Exemplary Embodiment 2-1 except that didodecyldimethyl ammonium bromide (manufactured by Tokyo Chemical Industry Co., Ltd.) was used instead of the polymer 2-a.

### (Comparative Example 2-3)

A photoresponsive material 2-16 was produced in the same manner as in Exemplary Embodiment 2-1 except that the nanoparticle c was used instead of the nanoparticle dispersion liquid 2-a and the polymer 2-i was used instead of the polymer 2-a.

For the photoresponsive materials 2-1 to 2-21, Table 6 shows the type and concentration of the nanoparticle and the type and concentration of the added polymer 2- or ligands.

### [Table 6]

**Table 6**

| Exemplary Embodiment No. | Photoresponsive material | Nanoparticle dispersion liquid | | Added polymer or ligand | |
|---|---|---|---|---|---|
| | | Type | Concentration | Type | Concentration |
| Exemplary Embodiment 2-1 | Photoresponsive material 2-1 | Nanoparticle dispersion liquid 2-a | 1 wt% | Polymer 2-a | 0.5 wt% |
| Exemplary Embodiment 2-2 | Photoresponsive material 2-2 | Nanoparticle dispersion liquid 2-a | 1 wt% | Polymer 2-b | 0.5 wt% |
| Exemplary Embodiment 2-3 | Photoresponsive material 2-3 | Nanoparticle dispersion liquid 2-a | 1 wt% | Polymer 2-b | 1 wt% |
| Exemplary Embodiment 2-4 | Photoresponsive material 2-4 | Nanoparticle dispersion liquid 2-a | 1 wt% | Polymer 2-c | 1 wt% |
| Exemplary Embodiment 2-5 | Photoresponsive material 2-5 | Nanoparticle dispersion liquid 2-b | 1 wt% | Polymer 2-a | 0.5 wt% |
| Exemplary Embodiment 2-6 | Photoresponsive material 2-6 | Nanoparticle dispersion liquid 2-b | 1 wt% | Polymer 2-b | 0.5 wt% |
| Exemplary Embodiment 2-7 | Photoresponsive material 2-7 | Nanoparticle dispersion liquid 2-b | 1 wt% | Polymer 2-c | 0.5 wt% |
| Exemplary Embodiment 2-8 | Photoresponsive material 2-8 | Nanoparticle dispersion liquid 2-b | 1 wt% | Polymer 2-c | 1 wt% |
| Exemplary Embodiment 2-9 | Photoresponsive material 2-9 | Nanoparticle dispersion liquid 2-b | 1 wt% | Polymer 2-d | 0.5 wt% |
| Exemplary Embodiment 2-10 | Photoresponsive material 2-10 | Nanoparticle dispersion liquid 2-b | 1 wt% | Polymer 2-e | 0.5 wt% |
| Exemplary Embodiment 2-11 | Photoresponsive material 2 11 | Nanoparticle dispersion liquid 2-c | 1 wt% | Polymer 2-a | 0.5 wt% |
| Exemplary Embodiment 2-12 | Photoresponsive material 2-12 | Nanoparticle dispersion liquid 2-c | 1 wt% | Polymer 2-b | 0.5 wt% |
| Exemplary Embodiment 2-13 | Photoresponsive material 2-13 | Nanoparticle dispersion liquid 2-c | 1 wt% | Polymer 2-c | 0.5 wt% |
| Exemplary Embodiment 2-1 | Photoresponsive material 2-14 | Nanoparticle dispersion liquid 2-b | 1 wt% | - | - |
| Exemplary Embodiment 2-2 | Photoresponsive material 2-15 | Nanoparticle dispersion liquid 2-b | 1 wt% | DDAB | 0.5 wt% |
| Exemplary Embodiment 2-3 | Photoresponsive material 2-16 | Nanoparticle dispersion liquid 2-b | 1 wt% | Polymer 2-i | 0.5 wt% |

The abbreviation in Table 6 is as follows:
DDAB: didodecyldimethyl ammonium bromide (manufactured by Tokyo Chemical Industry Co., Ltd.)

### <Evaluation of Photoresponsive Material 2->

The photoresponsive material 2- thus produced was subjected to the following evaluation. Table 7 shows the results.

### [Evaluation of Emission Properties]

For each photoresponsive material 2-, the emission peak wavelength, the full width at half maximum, and the absolute photoluminescence quantum yield (hereinafter referred to as PLQY) were measured immediately after the production and 30 minutes after 2-propanol (hereinafter referred to as IPA) was added so as to be 50% by volume. After the addition of IPA, a sample was stored in a darkroom to prevent the promotion of separation of a non-shell-like ligand by light and the inhibition of coordination of a shell-like ligand.

The emission peak wavelength and the full width at half maximum are values of an emission spectrum from which PLQY is calculated, and PLQY is the number of photons of fluorescence when the number of excitation photons absorbed by a light-emitting nanocrystal is 1. Each photoresponsive material 2- was diluted with toluene before the measurements so that the optical absorptance at an excitation light wavelength ranged from 0.2 to 0.3. The measurement conditions and evaluation criteria are described below. The full width at half maximum may also be referred to as a half width.

### <Measurement Conditions>

Measuring apparatus: absolute PL quantum yield measurement system C9920-03 (manufactured by Hamamatsu Photonics K.K.)
Excitation light wavelength: 460 nm
Excitation light integration range: excitation light wavelength ± 10 nm
Light emission integration range: (excitation light wavelength + 20) nm to 770 nm

### <Evaluation Criteria for PLQY Change>

A: absolute PLQY change rate of less than 20%
B: absolute PLQY change rate of 20% or more and less than 40%
C: absolute PLQY change rate of 40% or more and less than 80%
D: absolute PLQY change rate of 80% or more

### [Table 7]

**Table 7**

| Exemplary Embodiment No.. | Photoresponsive material | Peak wavelength/nm | | | Full width at half maximum/nm | | PLQY | | PLQY change rate | Rating | Peak wavelength change/nm | Rating |
|---|---|---|---|---|---|---|---|---|---|---|---|---|
| | | Immediately after synthesis of nanoparticle | Immediately after production | 30 minutes after addition of IPA 50% | Immediately after production | 30 minutes after addition of IPA 50% | Immediately after production | 30 minutes after addition of IPA 50% | | | | |
| Exemplary Embodiment 2-1 | Photoresponsive material 2-1 | 512 | 501 | 501 | 23 | 22 | 68% | 18% | -73% | C | -11 | B |
| Exemplary Embodiment 2-2 | Photoresponsive material 2-2 | 512 | 512 | 512 | 23 | 21 | 73% | 25% | -66% | C | 0 | A |
| Exemplary Embodiment 2-3 | Photoresponsive material 2-3 | 512 | 512 | 511 | 23 | 22 | 74% | 30% | -60% | C | 0 | A |
| Exemplary Embodiment 2-4 | Photoresponsive material 2-4 | 512 | 517 | 517 | 24 | 21 | 63% | 21% | -67% | C | 5 | A |
| Exemplary Embodiment 2-5 | Photoresponsive material 2-5 | 640 | 640 | 640 | 43 | 44 | 66% | 55% | -17% | A | 0 | A |
| Exemplary Embodiment 2-6 | Photoresponsive material 2-6 | 640 | 623 | 617 | 42 | 35 | 75% | 52% | -30% | B | -17 | C |
| Exemplary Embodiment 2-7 | Photoresponsive material 2-7 | 640 | 642 | 633 | 39 | 37 | 84% | 63% | -24% | B | 2 | A |
| Exemplary Embodiment 2-8 | Photoresponsive material 2-8 | 640 | 637 | 626 | 39 | 37 | 82% | 67% | -18% | A | -3 | A |
| Exemplary Embodiment 2-9 | Photoresponsive material 2-9 | 640 | 628 | 620 | 41 | 36 | 74% | 66% | -11% | A | -12 | B |
| Exemplary Embodiment 2-10 | Photoresponsive material 2-10 | 640 | 634 | 628 | 39 | 37 | 85% | 69% | -19% | A | -6 | A |
| Exemplary Embodiment 2-11 | Photoresponsive material 2-11 | 690 | 690 | 690 | 35 | 34 | 91% | 75% | -18% | A | 0 | A |
| Exemplary Embodiment 2-12 | Photoresponsive material 2-12 | 690 | 682 | 669 | 44 | 38 | 83% | 69% | -17% | A | -8 | A |
| Exemplary Embodiment 2-13 | Photoresponsive material 2-13 | 690 | 690 | 688 | 37 | 36 | 86% | 69% | -20% | A | 0 | A |
| Comparative Example 2-1 | Photoresponsive material 2-14 | 640 | 641 | 619 | 38 | 42 | 79% | 9% | -89% | D | 1 | A |
| Comparative Example 2-2 | Photoresponsive material 2-15 | 640 | 535 | 555 | 23 | 25 | 42% | 5% | -87% | D | -105 | D |
| Comparative Example 2-3 | Photoresponsive material 2-16 | 640 | 643 | 619 | 38 | 42 | 83% | 16% | -81% | D | 3 | A |

Table 7 shows that the photoresponsive materials 2-1 to 2-13 according to Exemplary Embodiments 2-1 to 2-13 have a high PLQY of 63% or more immediately after the production and can maintain the high PLQY even after the addition of the polar solvent IPA. This is probably because, in the photoresponsive materials 2-1 to 2-13 according to Exemplary Embodiments 2-1 to 2-13, the shell-like ligand 20 with a specific structure protects the nanoparticle 10 and ensures the stability of the nanoparticle 10.

By contrast, the photoresponsive material 2- without the shell-like ligand 20 as in Comparative Examples 2-1 to 2-3 had a low PLQY immediately after the production in some cases and were significantly deactivated with time.

### (Exemplary Embodiment 2-14)

### [Preparation of Polymer 2- Solution]

### (Toluene Solution of Polymer 2-b)

A reaction vessel equipped with a stirrer, a thermometer, and a refluxing condenser was charged with 1 part of the polymer 2-b and 99 parts of toluene, was heated to 110°C, and was heated at this temperature for 5 minutes. After confirming that the polymer 2-a was completely dissolved, a toluene solution of the polymer 2-b was produced by cooling to room temperature.

### [Preparation of Ink Composition 2-1]

A dry nitrogen stream was blown to 500 parts of the nanoparticle dispersion liquid 2-a to remove the solvent. 500 parts of the toluene solution of the polymer 2-b was added thereto, and the mixture was stirred for 3 hours. A dry nitrogen stream was again blown to the stirred solution to remove the solvent. After drying, 100 parts of 3,3,5-trimethylcyclohexyl acrylate (TMCHA) and 5 parts of 1-hydroxycyclohexyl phenyl ketone (Omnirad 184) were added as polymerizable compounds to the solid component of the solution, and the mixture was sufficiently stirred to produce an ink composition 2-1.

### (Exemplary Embodiment 2-15)

An ink composition 2-2 was produced in the same manner as in Exemplary Embodiment 2-14 except that tetrahydrofurfuryl acrylate (THFA) was used instead of TMCHA.

### (Exemplary Embodiment 2-16)

An ink composition 2-3 was produced in the same manner as in Exemplary Embodiment 2-14 except that 1,6-hexanediol diacrylate (HDDA) was used instead of TMCHA.

### (Exemplary Embodiment 2-17)

An ink composition 2-4 was produced in the same manner as in Exemplary Embodiment 2-14 except that the nanoparticle dispersion liquid 2-b was used instead of the nanoparticle dispersion liquid 2-a and that the polymer 2-c was used instead of the polymer 2-b.

### (Exemplary Embodiment 2-18)

An ink composition 2-5 was produced in the same manner as in Exemplary Embodiment 2-15 except that tetrahydrofurfuryl acrylate (THFA) was used instead of TMCHA.

### (Exemplary Embodiment 2-19)

An ink composition 2-6 was produced in the same manner as in Exemplary Embodiment 2-16 except that 1,6-hexanediol diacrylate (HDDA) was used instead of TMCHA.

### (Exemplary Embodiment 2-20)

An ink composition 2-7 was produced in the same manner as in Exemplary Embodiment 2-14 except that the nanoparticle dispersion liquid 2-c was used instead of the nanoparticle dispersion liquid 2-a and that the polymer 2-c was used instead of the polymer 2-b.

### (Exemplary Embodiment 2-21)

An ink composition 2-8 was produced in the same manner as in Exemplary Embodiment 2-20 except that tetrahydrofurfuryl acrylate (THFA) was used instead of TMCHA.

### (Exemplary Embodiment 2-22)

An ink composition 2-9 was produced in the same manner as in Exemplary Embodiment 2-20 except that 1,6-hexanediol diacrylate (HDDA) was used instead of TMCHA.

### (Exemplary Embodiment 2-23)

An ink composition 2-10 was produced in the same manner as in Exemplary Embodiment 2-14 except that the nanoparticle dispersion liquid 2-c was used instead of the nanoparticle dispersion liquid 2-a and that the polymer 2-a was used instead of the polymer 2-b.

### (Exemplary Embodiment 2-24)

An ink composition 2-11 was produced in the same manner as in Exemplary Embodiment 2-17 except that cyclohexyl acrylate (CHA) was used instead of TMCHA.

### (Exemplary Embodiment 2-25)

An ink composition 2-12 was produced in the same manner as in Exemplary Embodiment 2-17 except that 80 parts of TMCHA and 20 parts of HDDA were used instead of 100 parts of TMCHA.

### (Exemplary Embodiment 2-26)

An ink composition 2-13 was produced in the same manner as in Exemplary Embodiment 2-17 except that the polymer 2-f was used instead of the polymer 2-c.

### (Exemplary Embodiment 2-27)

An ink composition 2-14 was produced in the same manner as in Exemplary Embodiment 2-17 except that the polymer 2-g was used instead of the polymer 2-c.

### (Exemplary Embodiment 2-28)

An ink composition 2-15 was produced in the same manner as in Exemplary Embodiment 2-17 except that the polymer 2-h was used instead of the polymer 2-c.

### (Comparative Example 2-4)

An ink composition 2-16 was produced in the same manner as in Exemplary Embodiment 2-17 except that toluene was used instead of the polymer 2-c.

### (Comparative Example 2-5)

A photoresponsive material 2-17 was produced in the same manner as in Exemplary Embodiment 2-17 except that didodecyldimethyl ammonium bromide (DDAB) was used instead of the polymer 2-c.

### (Comparative Example 2-6)

An ink composition 2-18 was produced in the same manner as in Exemplary Embodiment 2-17 except that the polymer 2-i was used instead of the polymer 2-c.

### [Table 8]

**Table 8**

| Exemplary Embodiment No. | Ink composition | Photoresponsive nanoparticle | | Polymer | | Polymerizable compound | | Polymerization initiator | |
|---|---|---|---|---|---|---|---|---|---|
| | | Type | Parts | Type | Parts | Type | Parts | Type | Parts |
| Exemplary Embodiment 2-14 | Ink composition2-1 | Photoresponsive nanoparticle dispersion liquid 2-a | 5 | Polymer 2-b | 5 | TMCHA | 100 | Omnirad184 | 5 |
| Exemplary Embodiment 2-15 | Ink composition2-2 | Photoresponsive nanoparticle dispersion liquid 2-a | 5 | Polymer 2-b | 5 | THFA | 100 | Omnirad184 | 5 |
| Exemplary Embodiment 2-16 | Ink composition2-3 | Photoresponsive nanoparticle dispersion liquid 2-a | 5 | Polymer 2-b | 5 | HDDA | 100 | Omnirad184 | 5 |
| Exemplary Embodiment 2-17 | Ink composition2-4 | Photoresponsive nanoparticle dispersion liquid 2-b | 5 | Polymer 2-c | 5 | TMCHA | 100 | Omnirad184 | 5 |
| Exemplary Embodiment 2-18 | Ink composition2-5 | Photoresponsive nanoparticle dispersion liquid 2-b | 5 | Polymer 2-c | 5 | THFA | 100 | Omnirad184 | 5 |
| Exemplary Embodiment 2-19 | Ink composition2-6 | Photoresponsive nanoparticle dispersion liquid 2-b | 5 | Polymer 2-c | 5 | HDDA | 100 | Omnirad184 | 5 |
| Exemplary Embodiment 2-20 | Ink composition2-7 | Photoresponsive nanoparticle dispersion liquid 2-c | 5 | Polymer 2-c | 5 | TMCHA | 100 | Omnirad184 | 5 |
| Exemplary Embodiment 2-21 | Ink composition2-8 | Photoresponsive nanoparticle dispersion liquid 2-c | 5 | Polymer 2-c | 5 | THFA | 100 | Omnirad184 | 5 |
| Exemplary Embodiment 2-22 | Ink composition2-9 | Photoresponsive nanoparticle dispersion liquid 2-c | 5 | Polymer 2-c | 5 | HDDA | 100 | Omnirad184 | 5 |
| Exemplary Embodiment 2-2 3 | Ink composition2-10 | Photoresponsive nanoparticle dispersion liquid 2-c | 5 | Polymer 2-a | 5 | TMCHA | 100 | Omnirad184 | 5 |
| Exemplary Embodiment 2-24 | Ink composition2-11 | Photoresponsive nanoparticle dispersion liquid 2-b | 5 | Polymer 2-c | 5 | CHA | 100 | Omnirad184 | 5 |
| Exemplary Embodiment 2-25 | Ink composition2-12 | Photoresponsive nanoparticle dispersion liquid 2-b | 5 | Polymer 2-c | 5 | TMCHA/HDDA=8/2 | 100 | Omnirad184 | 5 |
| Exemplary Embodiment 2-26 | Ink composition2-13 | Photoresponsive nanoparticle dispersion liquid 2-b | 5 | Polymer 2-f | 5 | TMCHA | 100 | Omnirad184 | 5 |
| Exemplary Embodiment 2-27 | Ink composition2-14 | Photoresponsive nanoparticle dispersion liquid 2-b | 5 | Polymer 2-g | 5 | TMCHA | 100 | Omnirad184 | 5 |
| Exemplary Embodiment 2-28 | Ink composition2-15 | Photoresponsive nanoparticle dispersion liquid 2-b | 5 | Polymer 2-h | 5 | TMCHA | 100 | Omnirad184 | 5 |
| Comparative Example 2-4 | Ink composition2-16 | Photoresponsive nanoparticle dispersion liquid 2-b | 5 | OA/OAm | - | TMCHA | 100 | Omnirad184 | 5 |
| Comparative Example 2-5 | Ink composition2-17 | Photoresponsive nanoparticle dispersion liquid 2-b | 5 | DDAB | 5 | TMCHA | 100 | Omnirad184 | 5 |
| Comparative Example 2-6 | Ink composition2-18 | Photoresponsive nanoparticle dispersion liquid 2-b | 5 | Polymer 2-i | 5 | TMCHA | 100 | Omnirad184 | 5 |

The abbreviations in Table 8 are as follows:
TMCHA: 3,3,5-trimethylcyclohexyl acrylate (manufactured by Osaka Organic Chemical Industry Ltd.)
HDDA: 1,6-hexanediol diacrylate (manufactured by Osaka Organic Chemical Industry Ltd.)
THFA: tetrahydrofurfuryl acrylate (manufactured by Osaka Organic Chemical Industry Ltd.)
CHA: cyclohexyl acrylate (manufactured by Osaka Organic Chemical Industry Ltd.)
DDAB: didodecyldimethyl ammonium bromide (manufactured by Tokyo Chemical Industry Co., Ltd.)

### [Characterization]

The particle size distribution and the absolute photoluminescence quantum yield (hereinafter referred to as PLQY) of the ink compositions 2-1 to 2-16 were measured for initial evaluation. Each ink composition was then allowed to stand for 14 days at a humidity of 70%RH and at a temperature of 25°C in a constant temperature and humidity chamber, and the particle size distribution and PLQY were then measured for evaluation after the passage of time. The particle size distribution was measured with Zetasizer Nano ZS (manufactured by Malvern), and the arithmetic mean diameter (on a number basis) of the particle size distribution was used as a measured value. The evaluation criteria are described below.

### <Evaluation Criteria for Initial Particle Size>

A: initial particle size of less than 30 nm
B: initial particle size of 30 nm or more and less than 60 nm
C: initial particle size of 60 nm or more and less than 90 nm
D: initial particle size of 90 nm or more

### <Evaluation Criteria for Particle Size Change>

A: particle size change of less than twice
B: particle size change of twice or more and less than three times
C: particle size change of three times or more and less than four times
D: particle size change of four times or more

The particle size change is defined by the particle size after the passage of time/the initial particle size.

PLQY is the number of photons of fluorescence when the number of excitation photons absorbed by a light-emitting nanocrystal is taken as 1. Each photoresponsive material 2-was diluted with toluene before the measurements so that the optical absorptance at an excitation light wavelength ranged from 0.2 to 0.3. The measurement conditions and evaluation criteria are described below.

### <Measurement Conditions>

Measuring apparatus: absolute PL quantum yield measurement system C9920-03 (manufactured by Hamamatsu Photonics K.K.)
Excitation light wavelength: 460 nm
Excitation light integration range: excitation light wavelength ± 10 nm
Light emission integration range: (excitation light wavelength + 20) nm to 770 nm

### <Evaluation Criteria for PLQY>

A: absolute PLQY change rate of less than 10%
B: absolute PLQY change rate of 10% or more and less than 25%
C: absolute PLQY change rate of 25% or more and less than 40%
D: absolute PLQY change rate of 40% or more

### [Table 9]

**Table 9**

| Exemplary Embodiment No. | Ink composition | Initial particle size | Particle size change | PLQY change |
|---|---|---|---|---|
| Exemplary Embodiment 2-14 | Ink composition 2-1 | A | A | B |
| Exemplary Embodiment 2-15 | Ink composition 2-2 | A | A | C |
| Exemplary Embodiment 2-16 | Ink composition 2-3 | A | A | B |
| Exemplary Embodiment 2-17 | Ink composition 2-4 | A | A | A |
| Exemplary Embodiment 2-18 | Ink composition 2-5 | B | A | B |
| Exemplary Embodiment 2-19 | Ink composition 2-6 | A | A | A |
| Exemplary Embodiment 2-20 | Ink composition 2-7 | A | A | A |
| Exemplary Embodiment 2-21 | Ink composition 2-8 | B | A | B |
| Exemplary Embodiment 2-22 | Ink composition 2-9 | A | A | A |
| Exemplary Embodiment 2-23 | Ink composition 2-10 | A | A | B |
| Exemplary Embodiment 2-24 | Ink composition 2-11 | A | A | A |
| Exemplary Embodiment 2-25 | Ink composition 2-12 | A | A | A |
| Exemplary Embodiment 2-26 | Ink composition 2-13 | A | A | A |
| Exemplary Embodiment 2-27 | Ink composition 2-14 | A | A | A |
| Exemplary Embodiment 2-28 | Ink composition 2-15 | A | D | A |
| Comparative Example 2-4 | Ink composition 2-16 | A | D | B |
| Comparative Example 2-5 | Ink composition 2-17 | A | D | D |
| Comparative Example 2-6 | Ink composition 2-18 | A | D | B |

Table 9 shows that the ink compositions 2-1 to 2-15 according to Exemplary Embodiments 2-14 to 2-28 of the present invention have a small initial particle size for a plurality of media and have a small particle size change and a small PLQY change after the passage of time. This is probably because the shell-like ligand 20 with the quaternary ammonium salt 30b in the binding portions 30 coordinates strongly to the nanoparticle 10, the alkyl chain 30a or 40a is compatibly mixed with the polymerizable compound 50, and the photoresponsive material 100 is therefore stably dispersed.

On the other hand, in the ink compositions 2-16 to 2-18 without the shell-like ligand 20 as in Comparative Examples 2-4 to 2-6, although the change in initial particle size or PLQY is small in some cases, the particle size increases with time in any case, and it is presumed that a coarse secondary particle is formed.

The present disclosure is described in more detail below with reference to a third exemplary embodiment group (Exemplary Embodiments 3-1 to 3-15), but the present disclosure is not limited thereto.

### [Production of Sulfobetaine Silane Compound]

5 g of [3-(N,N-dimethylamino)propyl]trimethoxysilane and 3 g of 1,3-propane sultone were dissolved in 25 ml of acetone, and the mixture was stirred in a nitrogen atmosphere for 6 hours. The mixture was washed with acetone and was then filtered to produce 3-(dimethyl(3-(trimethoxysilyl)propyl)ammonia)propane-1-sulfonate as a sulfobetaine silane compound.

The polymer 3-a was analyzed by the analysis method described above and was found to have a weight-average molecular weight (Mw) of 11800, and the structural unit represented by the formula (2) constituted 21% by mole of the total monomer units. The polymer 3-a may also be referred to as an intermediate raw material a or a precursor a of the shell-like ligand 20 coordinated to the particle surface of the nanoparticle 10 dispersed in the solvent 90.

### [Production of Carboxybetaine Silane Compound]

5 g of (N,N-dimethylaminopropyl)trimethoxysilane was mixed with 7 g of ethyl-4-bromobutyrate in 20 ml of acetonitrile. After reaction for 72 hours under reflux, 60 ml of ether was added thereto, and the unreacted reactant was removed with a rotary evaporator to produce a carboxybetaine silane compound.

### (Exemplary Embodiment 3-1)

### [Preparation of Sulfobetaine Silane Compound Solution]

### (Toluene Solution of Sulfobetaine Silane Compound)

A reaction vessel equipped with a stirrer, a thermometer, and a refluxing condenser was charged with 2.5 parts of the sulfobetaine silane compound and 97.5 parts of toluene, was heated to 110°C, and was heated at this temperature for 30 minutes. After confirming that the sulfobetaine silane compound was dissolved, a toluene solution of the sulfobetaine silane compound was produced by cooling to room temperature.

### [Production of Polymer 3-d]

A polymer 3-d was produced in the same manner as in the production of the polymer 3-a except that 34.5 parts of butyl methacrylate was used instead of octadecyl methacrylate.

### [Production of Comparative Polymer 3-e]

A comparative polymer 3-e was produced in the same manner as the polymer 3-a except that 102.6 parts of octadecyl methacrylate was used instead of 17.9 parts of 2-(methacryloyloxy)ethyl 2-(trimethylammonio)ethyl phosphate and 82.1 parts of octadecyl methacrylate.

Table 10 shows the composition ratio and the weight-average molecular weight (Mw) of each of the polymers 3-a to 3-e produced as described above. In Table 10, X denotes a binding site of the structural unit represented by the formula (1) to the polymer main chain, and X' denotes a binding site of the structural unit represented by the formula (1) to the phosphate moiety. Y denotes a binding site of the structural unit represented by the formula (1) to the phosphate moiety, Y' denotes a binding site of the structural unit represented by the formula (1) to the quaternary ammonium salt moiety, and Z denotes a binding site of the structural unit represented by the formula (4) to the polymer main chain.

### [Production of Sulfobetaine Silane Compound with Introduced Functional Group]

2.5 parts of trimethoxy(propyl)silane was gradually added to 97.5 parts of a toluene solution of a sulfobetaine silane compound over 1 hour. The mixture was stirred for another 30 minutes and was then cooled to room temperature to produce a toluene solution of a sulfobetaine silane compound with a propyl group introduced as a functional group (hereinafter referred to as a sulfobetaine silane compound with an introduced functional group).

### [Production of Photoresponsive Nanoparticle 3-a]

10 parts of cesium carbonate, 27 parts of oleic acid, and 385 parts of 1-octadecene were placed in a flask, were heated to 120°C, and were degassed with a vacuum pump for 30 minutes. Furthermore, the liquid was heated to 150°C in a dry nitrogen stream and was held for 30 minutes to produce a cation raw material liquid.

Separately, 10 parts of lead (II) bromide and 494 parts of 1-octadecene were placed in a flask, were heated to 120°C, and were degassed with a vacuum pump for 1 hour. 89 parts of oleic acid and 31 parts of oleylamine were added, and the mixture was degassed with a vacuum pump for 30 minutes. The liquid temperature was then altered to 185°C in a nitrogen flow.

40 parts of the cation raw material liquid was added thereto, and the mixture was cooled with ice after 5 seconds. 2000 parts of ethyl acetate was added thereto, the mixture was centrifuged, and the supernatant was removed. The residue was dispersed in toluene to adjust the solid concentration to 1% by weight. Thus, a photoresponsive nanoparticle 3- dispersion liquid a with a CsPbBr₃ perovskite crystal structure was produced.

### [Preparation of Ink Composition 3-1]

A dry nitrogen stream was blown to 500 parts of the photoresponsive nanoparticle 3- dispersion liquid a to remove the solvent. 500 parts of the toluene solution of the sulfobetaine silane compound with an introduced functional group was added thereto, and the mixture was stirred for 3 hours. After a dry nitrogen stream was blown again to remove the solvent, 50 parts of toluene, 100 parts of 3,3,5-trimethylcyclohexyl acrylate (TMCHA), and 5 parts of 1-hydroxycyclohexyl phenyl ketone (Omnirad 184) were added thereto to produce an ink composition 3-1.

### (Exemplary Embodiment 3-2)

An ink composition 3-2 was produced in the same manner as in Exemplary Embodiment 3-1 except that hexyltrimethoxysilane was used instead of trimethoxy(propyl)silane.

### (Exemplary Embodiment 3-3)

An ink composition 3-3 was produced in the same manner as in Exemplary Embodiment 3-1 except that 3-(trimethoxysilyl)propyl methacrylate was used instead of trimethoxy(propyl)silane.

### (Exemplary Embodiment 3-4)

An ink composition 3-4 was produced in the same manner as in Exemplary Embodiment 3-1 except that 3-(trimethoxysilyl)propyl acrylate was used instead of trimethoxy(propyl)silane.

### (Exemplary Embodiment 3-5)

An ink composition 3-5 was produced in the same manner as in Exemplary Embodiment 3-1 except that a toluene solution of a sulfobetaine silane compound without an introduced functional group was used instead of the toluene solution of the sulfobetaine silane compound with an introduced functional group. In this case, a functional group is not introduced by an additional compound, but a sulfobetaine silane compound (3-(dimethyl(3-(trimethoxysilyl)propyl)ammonia)propane-1-sulfonate) is condensed between its molecules, so that the sulfobetaine silane compound partially becomes a compound with a propyl group and a betaine structure at a terminal thereof introduced as functional groups.

### (Exemplary Embodiment 3-6)

An ink composition 3-6 was produced in the same manner as in Exemplary Embodiment 3-2 except that tetrahydrofurfuryl acrylate (THFA) was used instead of TMCHA.

### (Exemplary Embodiment 3-7)

An ink composition 3-7 was produced in the same manner as in Exemplary Embodiment 3-2 except that 1,6-hexanediol diacrylate (HDDA) was used instead of TMCHA.

### (Exemplary Embodiment 3-8)

An ink composition 3-8 was produced in the same manner as in Exemplary Embodiment 3-2 except that cyclohexyl acrylate (CHA) was used instead of TMCHA.

### (Exemplary Embodiment 3-9)

An ink composition 3-9 was produced in the same manner as in Exemplary Embodiment 3-2 except that a mixture of 80 parts of THFA and 20 parts of HDDA was used instead of 100 parts of TMCHA.

### (Exemplary Embodiment 3-10)

An ink composition 3-10 was produced in the same manner as in Exemplary Embodiment 3-1 except that a carboxybetaine silane compound was used instead of the sulfobetaine silane compound.

### (Exemplary Embodiment 3-11)

An ink composition 3-11 was produced in the same manner as in Exemplary Embodiment 3-1 except that 99 parts of the toluene solution of the sulfobetaine silane compound and 1 part of hexyltrimethoxysilane were used instead of 97.5 parts of the toluene solution of the sulfobetaine silane compound and 2.5 parts of trimethoxy(propyl)silane.

### (Exemplary Embodiment 3-12)

An ink composition 3-12 was produced in the same manner as in Exemplary Embodiment 3-1 except that 95 parts of the toluene solution of the sulfobetaine silane compound and 5 parts of hexyltrimethoxysilane were used instead of 97.5 parts of the toluene solution of the sulfobetaine silane compound and 2.5 parts of trimethoxy(propyl)silane.

### [Production of Photoresponsive Nanoparticle 3-Dispersion Liquid b]

A photoresponsive nanoparticle 3- dispersion liquid b with a CsPb(Br/I)₃ perovskite crystal structure was produced in the same manner as the light-emitting nanocrystal dispersion liquid a except that 3.3 parts of lead (II) bromide and 9.3 parts of lead (II) iodide were used instead of 10 parts of lead (II) bromide.

### (Exemplary Embodiment 3-13)

An ink composition 3-13 was produced in the same manner as in Exemplary Embodiment 3-2 except that the photoresponsive nanoparticle 3- dispersion liquid b was used instead of the photoresponsive nanoparticle 3- dispersion liquid a.

### [Production of Photoresponsive Nanoparticle 3-Dispersion Liquid c]

A photoresponsive nanoparticle 3- dispersion liquid c with a CsPbI₃ perovskite crystal structure was produced in the same manner as the light-emitting nanocrystal dispersion liquid a except that 12.5 parts of lead (II) iodide was used instead of 10 parts of lead (II) bromide.

### (Exemplary Embodiment 3-14)

An ink composition 3-14 was produced in the same manner as in Exemplary Embodiment 3-2 except that the photoresponsive nanoparticle 3- dispersion liquid c was used instead of the photoresponsive nanoparticle 3- dispersion liquid a.

### [Production of Photoresponsive Nanoparticle 3-Dispersion Liquid d]

First, an oleate solution of methylamine acetate was synthesized as described below. 40 parts of methylamine acetate and 1290 parts of oleic acid were mixed in a flask and were degassed with a vacuum pump at room temperature for 3 hours. The mixture was heated to 120°C and was degassed for 30 minutes to produce an oleate solution of methylamine acetate.

Next, an oleate solution of formamidine acetate was synthesized as described below. 46 parts of formamidine acetate and 1290 parts of oleic acid were mixed in a flask and were degassed with a vacuum pump at room temperature for 3 hours. The mixture was heated to 120°C and was degassed for 30 minutes to produce an oleate solution of formamidine acetate.

Separately, 10 parts of lead bromide, 129 parts of oleic acid, 59 parts of oleylamine, and 572 parts of octadecene were placed in a flask, were heated to 160°C, and were degassed with a vacuum pump for 100 minutes. 16 parts of the oleate solution of methylamine acetate and 77 parts of the oleate solution of formamidine acetate were mixed and added to the flask all at once. 10 seconds after the addition, the flask was cooled with ice. The ice-cooled solution was centrifuged, and the supernatant was removed. The resulting residue was dispersed in hexane and was further centrifuged to remove a precipitate. The solid concentration was adjusted to 1% by weight to produce a photoresponsive nanoparticle 3- dispersion liquid d with a (MA/FA)PbBr₃ perovskite crystal structure.

### (Exemplary Embodiment 3-15)

An ink composition 3-15 was produced in the same manner as in Exemplary Embodiment 3-2 except that the photoresponsive nanoparticle 3- dispersion liquid d was used instead of the photoresponsive nanoparticle 3- dispersion liquid a.

### (Comparative Example 3-1)

An ink composition 3-16 was produced in the same manner as in Exemplary Embodiment 3-1 except that 500 parts of toluene was used instead of 500 parts of the toluene solution of the sulfobetaine silane compound with an introduced functional group.

### (Comparative Example 3-2)

An ink composition 3-17 was produced in the same manner as in Comparative Example 3-1 except that THFA was used instead of TMCHA.

### (Comparative Example 3-3)

An ink composition 3-18 was produced in the same manner as in Exemplary Embodiment 3-1 except that 100 parts of a toluene solution of an octadecyl dimethyl(3-sulfopropyl)ammonium hydroxide inner salt (a betaine ligand, manufactured by Tokyo Chemical Industry Co., Ltd.) was used instead of 500 parts of the toluene solution of the sulfobetaine silane compound with an introduced functional group.

For the ink compositions 3-1 to 3-18, Table 10 shows the type and concentration of the photoresponsive nanoparticle 3- and the type and concentration of the betaine silane compound and the added silane compound.

### [Table 10]

**Table 10**

| Exemplary Embodiment No. | Ink composition | Photoresponsive nanoparticle | | Betaine silane compound | | Added silane compound | | Polymerizable compound | | Polymerization initiator | |
|---|---|---|---|---|---|---|---|---|---|---|---|
| | | Type | Parts | Type | Parts | Type | Parts | Type | Parts | Type | Parts |
| Exemplary Embodiment 3-1 | Ink composition 3-1 | CsPbBr3 | 5 | Sulfobetaine silane compound | 12.5 | Trimethoxy (propyl)silane | 12.5 | TMCHA | 100 | Omnirad184 | 5 |
| Exemplary Embodiment 3-2 | Ink composition 3-2 | CsPbBr3 | 5 | Sulfobetaine silane compound | 12.5 | Hexyltrimethoxysilane | 12.5 | TMCHA | 100 | Omnirad184 | 5 |
| Exemplary Embodiment 3-3 | Ink composition 3-3 | CsPbBr3 | 5 | Sulfobetaine silane compound | 12.5 | 3-(trimethoxysilyl)propyl methacrylate | 12.5 | TMCHA | 100 | Omnirad184 | 5 |
| Exemplary Embodiment 3-4 | Ink composition 3-4 | CsPbBr3 | 5 | Sulfobetaine silane compound | 12.5 | 3-(trimethoxysilyl)propyl acrylate | 12.5 | TMCHA | 100 | Omnirad184 | 5 |
| Exemplary Embodiment 3-5 | Ink composition 3-5 | CsPbBr3 | 5 | Sulfobetaine silane compound | 12.5 | - | 12.5 | TMCHA | 100 | Omnirad184 | 5 |
| Exemplary Embodiment 3-6 | Ink composition 3-6 | CsPbBr3 | 5 | Sulfobetaine silane compound | 12.5 | Hexyltrimethoxysilane | 12.5 | THFA | 100 | Omnirad184 | 5 |
| Exemplary Embodiment 3-7 | Ink composition 3-7 | CsPbBr3 | 5 | Sulfobetaine silane compound | 12.5 | Hexyltrimethoxysilane | 12.5 | HDDA | 100 | Omnirad184 | 5 |
| Exemplary Embodiment 3-8 | Ink composition 3-8 | CsPbBr3 | 5 | Sulfobetaine silane compound | 12.5 | Hexyltrimethoxysilane | 12.5 | CHA | 100 | Omnirad184 | 5 |
| Exemplary Embodiment 3-9 | Ink composition 3-9 | CsPbBr3 | 5 | Sulfobetaine silane compound | 12.5 | Hexyltrimethoxysilane | 12.5 | THFA/HDDA=8/2 | 100 | Omnirad184 | 5 |
| Exemplary Embodiment 3-10 | Ink composition 3-10 | CsPbBr3 | 5 | Carboxybetaine compound | 12.5 | Trimethoxy (propyl)silane | 12.5 | TMCHA | 100 | Omnirad184 | 5 |
| Exemplary Embodiment 3-11 | Ink composition 3-11 | CsPbBr3 | 5 | Sulfobetaine silane compound | 12.5 | Hexyltrimethoxysilane | 5 | TMCHA | 100 | Omnirad184 | 5 |
| Exemplary Embodiment 3-12 | Ink composition 3-12 | CsPbBr3 | 5 | Sulfobetaine silane compound | 12.5 | Hexyltrimethoxysilane | 25 | TMCHA | 100 | Omnirad184 | 5 |
| Exemplary Embodiment 3-13 | Ink composition 3-13 | CsPb(Br/I)3 | 5 | Sulfobetaine silane compound | 12.5 | Hexyltrimethoxysilane | 12.5 | TMCHA | 100 | Omnirad184 | 5 |
| Exemplary Embodiment 3-14 | Ink composition 3-14 | CsPbl3 | 5 | Sulfobetaine silane compound | 12.5 | Hexyltrimethoxysilane | 12.5 | TMCHA | 100 | Omnirad184 | 5 |
| Exemplary Embodiment 3-15 | Ink composition 3-15 | (MA/FA)PbBr3 | 5 | Sulfobetaine silane compound | 12.5 | Hexyltrimethoxysilane | 12.5 | TMCHA | 100 | Omnirad184 | 5 |
| Comparative Example 3-1 | Ink composition 3-16 | CsPbBr3 | 5 | - | - | - | - | TMCHA | 100 | Omnirad184 | 5 |
| Comparative Example 3-2 | Ink composition 3-17 | CsPbBr3 | 5 | - | - | - | - | THFA | 100 | Omnirad184 | 5 |
| Comparative Example 3-3 | Ink composition 3-18 | CsPbBr3 | 5 | Betaine ligand | - | - | - | THFA | 100 | Omnirad184 | 5 |

The abbreviations in Table 10 are as follows:
TMCHA: 3,3,5-trimethylcyclohexyl acrylate (manufactured by Osaka Organic Chemical Industry Ltd.)
HDDA: 1,6-hexanediol diacrylate (manufactured by Osaka Organic Chemical Industry Ltd.)
THFA: tetrahydrofurfuryl acrylate (manufactured by Osaka Organic Chemical Industry Ltd.)
CHA: cyclohexyl acrylate (manufactured by Osaka Organic Chemical Industry Ltd.)

### <Evaluation of Ink Composition 3- Composition>

The particle size distribution of the ink compositions 3-1 to 3-14 was measured for initial evaluation. The ink composition 3- composition was then allowed to stand for 14 days at a humidity of 70%RH and at a temperature of 25°C in a constant temperature and humidity chamber, and the particle size distribution was then measured for evaluation after the passage of time. The particle size distribution was measured with Zetasizer Nano ZS (manufactured by Malvern), and the arithmetic mean diameter (on a number basis) of the particle size distribution was used as a measured value. The evaluation criteria are described below.

For the ink compositions 3-1 to 3-19, Table 12 shows the type and concentration of the nanoparticle and the type and concentration of the polymer 3-.

### <Initial Particle Size>

A: initial particle size of less than 20 nm
B: initial particle size of 20 nm or more and less than 50 nm
C: initial particle size of 50 nm or more and less than 80 nm
D: initial particle size of 80 nm or more

### <Particle Size Change>

A: particle size change of less than twice
B: particle size change of twice or more and less than three times
C: particle size change of three times or more and less than four times
D: particle size change of four times or more

### [Table 12]

**Table 12**

| Exemplary Embodiment No. | Polymer No. | Photoresponsive nanoparticle | | Polymer | | Polymerizable compound | | Polymerization initiator |
|---|---|---|---|---|---|---|---|---|
| | | Type | Parts | Type | Parts | Type | Parts | Parts |
| Exemplary Embodiment 3-1 | Ink composition 3-1 | CsPbBr₃ | 5 | Polymer 3-a | 5 | TMCHA | 100 | 5 |
| Exemplary Embodiment 3-2 | Ink composition 3-2 | CsPbBr₃ | 5 | Polymer 3-b | 5 | TMCHA | 100 | 5 |
| Exemplary Embodiment 3-3 | Ink composition 3-3 | CsPbBr₃ | 5 | Polymer 3-c | 5 | TMCHA | 100 | 5 |
| Exemplary Embodiment 3-4 | Ink composition 3-4 | CsPbBr₃ | 5 | Polymer 3-d | 5 | TMCHA | 100 | 5 |
| Exemplary Embodiment 3-5 | Ink composition 3-5 | CsPbBr₃ | 5 | Polymer 3-c | 5 | THFA | 100 | 5 |
| Exemplary Embodiment 3-6 | Ink composition 3-6 | CsPbBr₃ | 5 | Polymer 3-c | 5 | HDDA | 100 | 5 |
| Exemplary Embodiment 3-7 | Ink composition 3-7 | CsPbBr₃ | 5 | Polymer 3-c | 5 | CHA | 100 | 5 |
| Exemplary Embodiment 3-8 | Ink composition 3-8 | CsPbBr₃ | 5 | Polymer 3-c | 5 | THFA/HDDA=8/2 | 100 | 5 |
| Exemplary Embodiment 3-9 | Ink composition 3-9 | CsPbBr₃ | 5 | Polymer 3-f | 5 | TMCHA | 100 | 5 |
| Exemplary Embodiment 3-10 | Ink composition 3-10 | CsPbBr₃ | 5 | Polymer 3-g | 5 | TMCHA | 100 | 5 |
| Exemplary Embodiment 3-11 | Ink composition 3-11 | CsPbBr₃ | 5 | Polymer 3-c | 2.5 | THFA | 100 | 5 |
| Exemplary Embodiment 3-12 | Ink composition 3-12 | CsPbBr | 5 | Polymer 3-c | 10 | THFA | 100 | 5 |
| Exemplary Embodiment 3-13 | Ink composition 3-13 | CsPb(Br/I)₃ | 5 | Polymer 3-c | 2.5 | TMCHA | 100 | 5 |
| Exemplary Embodiment 3-14 | Ink composition 3-14 | CsPbI₃ | 5 | Polymer 3-c | 2.5 | TMCHA | 100 | 5 |
| Exemplary Embodiment 3-15 | Ink composition 3-15 | (MA/FA)PbBr₃ | 5 | Polymer 3-c | 2.5 | TMCHA | 100 | 5 |
| Comparative Example 3-1 | Ink composition 3-16 | CsPbBr₃ | 5 | - | - | TMCHA | 100 | 5 |
| Comparative Example 3-2 | Ink composition 3-17 | CsPbBr₃ | 5 | Polymer 3-e | 5 | TMCHA | 100 | 5 |
| Comparative Example 3-3 | Ink composition 3-18 | CsPbBr₃ | 5 | - | - | THFA | 100 | 5 |
| Comparative Example 3-4 | Ink composition 3-19 | CsPbBr₃ | 5 | Ligand a | - | TMCHA | 100 | 5 |

The abbreviations in Table 12 are as follows:
TMCHA: 3,3,5-trimethylcyclohexyl acrylate (manufactured by Osaka Organic Chemical Industry Ltd.)
HDDA: 1,6-hexanediol diacrylate (manufactured by Osaka Organic Chemical Industry Ltd.)
THFA: tetrahydrofurfuryl acrylate (manufactured by Osaka Organic Chemical Industry Ltd.)
CHA: cyclohexyl acrylate (manufactured by Osaka Organic Chemical Industry Ltd.)

### <Evaluation of Ink Composition 3- Composition>

The particle size distribution of the ink compositions 3-1 to 3-15 was measured for initial evaluation. The ink compositions 3-1 to 3-15 compositions were then allowed to stand for 14 days at a humidity of 70%RH and at a temperature of 25°C in a constant temperature and humidity chamber, and the particle size distribution was then measured for evaluation after the passage of time. The particle size distribution was measured with Zetasizer Nano ZS (manufactured by Malvern), and the arithmetic mean diameter (on a number basis) of the particle size distribution was used as a measured value. The evaluation criteria were described below.

### <Initial Particle Size>

A: initial particle size of less than 20 nm
B: initial particle size of 20 nm or more and less than 50 nm
C: initial particle size of 50 nm or more and less than 80 nm
D: initial particle size of 80 nm or more

### <Particle Size Change>

A: particle size change of less than twice
B: particle size change of twice or more and less than three times
C: particle size change of three times or more and less than four times
D: particle size change of four times or more

The particle size change is defined by the particle size after the passage of time/the initial particle size. Table 11 shows the results.

### [Table 11]

**Table 11**

| Exemplary Embodiment No. | Ink composition | Initial particle size | Particle size change |
|---|---|---|---|
| Exemplary Embodiment 3-1 | Ink composition 3-1 | A | B |
| Exemplary Embodiment 3-2 | Ink composition 3-2 | A | A |
| Exemplary Embodiment 3-3 | Ink composition 3-3 | A | A |
| Exemplary Embodiment 3-4 | Ink composition 3-4 | A | A |
| Exemplary Embodiment 3-5 | Ink composition 3-5 | B | B |
| Exemplary Embodiment 3-6 | Ink composition 3-6 | A | A |
| Exemplary Embodiment 3-7 | Ink composition 3-7 | A | A |
| Exemplary Embodiment 3-8 | Ink composition 3-8 | A | A |
| Exemplary Embodiment 3-9 | Ink composition 3-9 | A | A |
| Exemplary Embodiment 3-10 | Ink composition 3-10 | A | A |
| Exemplary Embodiment 3-11 | Ink composition 3-11 | A | A |
| Exemplary Embodiment 3-12 | Ink composition 3-12 | B | B |
| Exemplary Embodiment 3-13 | Ink composition 3-13 | A | A |
| Exemplary Embodiment 3-14 | Ink composition 3-14 | A | A |
| Exemplary Embodiment 3-15 | Ink composition 3-15 | A | A |
| Comparative Example 3-1 | Ink composition 3-16 | A | D |
| Comparative Example 3-2 | Ink composition 3-17 | C | D |
| Comparative Example 3-3 | Ink composition 3-18 | C | D |

Table 11 shows that the ink composition 3- according to the present invention has a small initial particle size and a small particle size change regardless of the type of medium.

When a betaine silane compound with an introduced functional group is used as in the present exemplary embodiment group, first, the betaine structure acts on the quantum dot surface and can coordinate firmly at a high density. It is presumed that an organic group of a functional group linked to the main chain with the betaine structure is then compatibly mixed with a polymerizable compound and provides high dispersion stability. It is thought that the introduction of a methacrylic chain or an acrylic chain as a functional group has the same effects.

On the other hand, in the ink compositions 3-16 to 3-18 without a specific polysiloxane compound of the present application in Comparative Examples 3-1 to 3-3, although the initial particle size was small in some cases, the particle size changed significantly over time.

The invention according to each embodiment described in the present description includes the following first to fifteenth inventions.
- The first constitution includes an ink composition containing: a photoresponsive nanoparticle; a shell-like ligand including a plurality of binding portions with an ionic structural unit and a polymer portion bound to the nanoparticle at a plurality of positions via the plurality of binding portions; and a polymerizable compound to be polymerized upon receiving energy.
- The second constitution includes the ink composition according to the first constitution, wherein the plurality of binding portions include a zwitterionic structural backbone.
- The eighth constitution includes the ink composition according to the first or second constitution, wherein the plurality of binding portions include a structural backbone of at least one of a betaine structure and a quaternary ammonium salt.
- The fourth constitution includes the ink composition according to any one of the first to eighth constitutions, wherein the plurality of binding portions include a structural unit represented by at least one of the formulae (1) to (5) as a betaine structure.

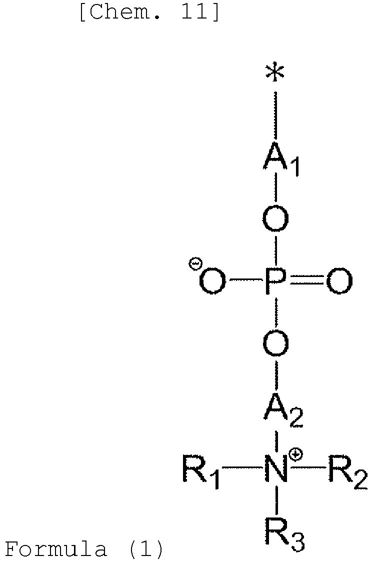

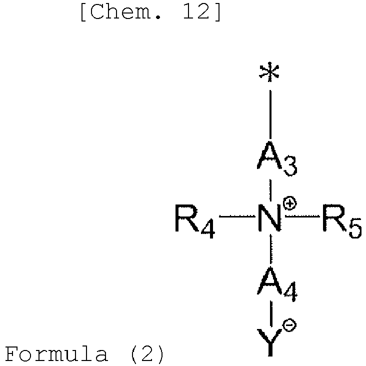

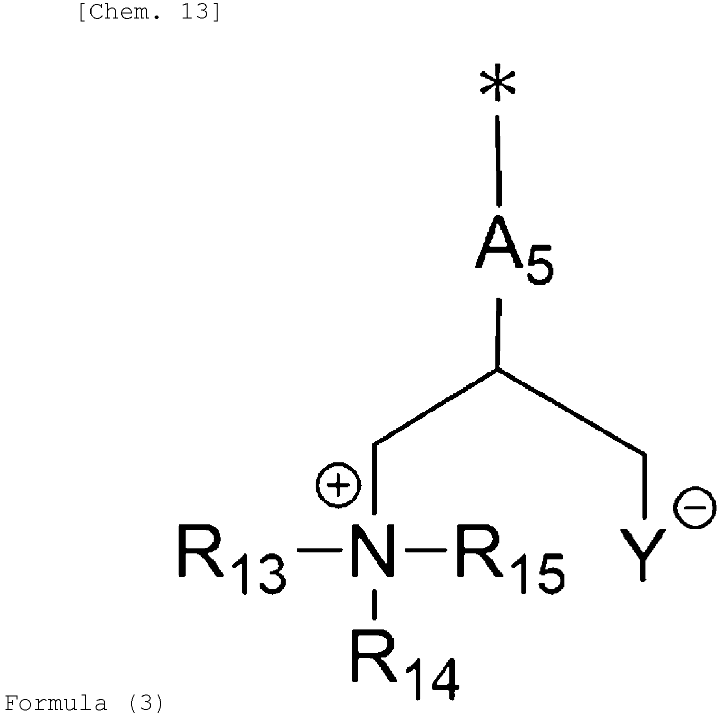

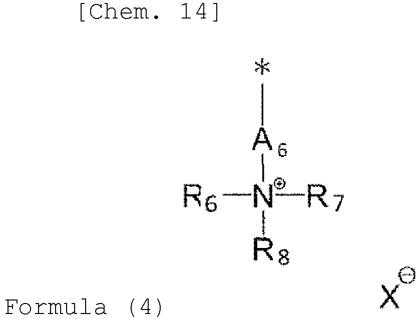

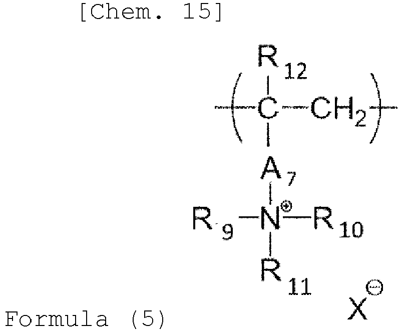

In the formulae (1) to (5), R₁ to R₅ and R₁₂ to R₁₅ each independently denote any one of a hydrogen atom and an alkyl group, R₆ to R₁₁ denote any one of an alkyl group and an aryl group, N denotes a nitrogen atom, A₁ to A₇ denote a linking group, X- denotes an anion, Y⁻ denotes a COO⁻ group or a SO₃⁻group, and "*" denotes a bonding arm to the polymer portion.
- The fifth constitution includes the ink composition according to any one of the first to fourth constitutions, wherein each of the plurality of binding portions includes a structural unit represented by at least one of the formulae (1) to (3).
- The sixth constitution includes the ink composition according to any one of the first to fifth constitutions, wherein the polymer portion has a structural unit represented by at least one of the formulae (6) to (8).

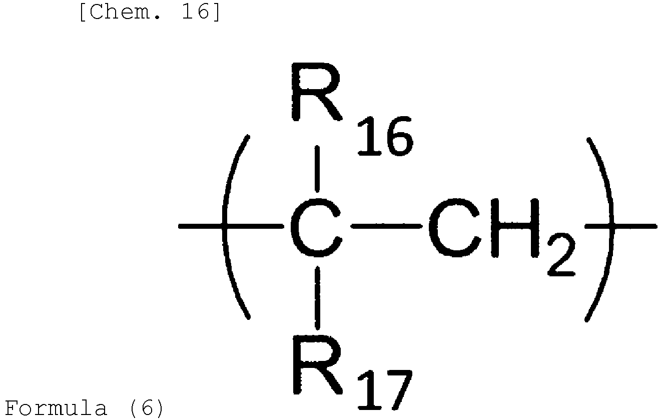

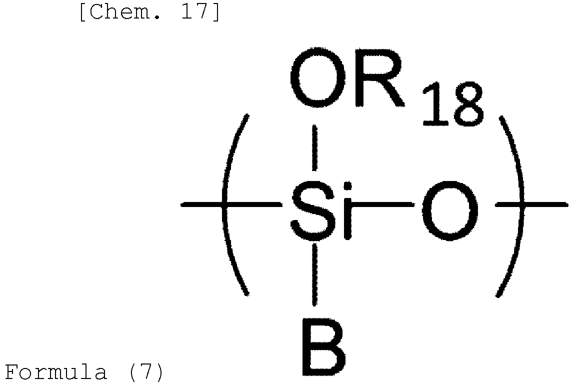

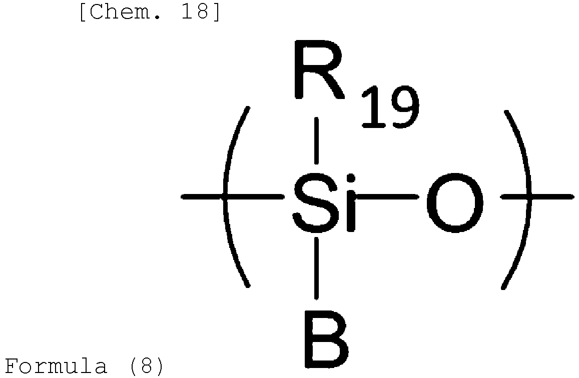

In the formulae (6) to (8), R₁₆ and R₁₈ each independently denote any one of a hydrogen atom and an alkyl group, and R₁₇ denotes any one of an alkyl group, a carboxylate group, a carboxamide group, an alkoxy group, and an aryl group. In the formulae (6) to (8), R₁₉ denotes an alkyl group, and B denotes a bonding arm to one of the binding portions.
- The seventh constitution includes the ink composition according to any one of the first to sixth constitutions, wherein the shell-like ligand has at least a portion coordinated to the nanoparticle.
- The eighth constitution includes the ink composition according to any one of the first to seventh constitutions, wherein the shell-like ligand has an organic group extending outward from the polymer portion.
- The ninth constitution includes the ink composition according to the eighth constitution, wherein the organic group is a portion of an alkyl group in at least one of the binding portions and the polymer portion.
- The tenth constitution includes the ink composition according to the eighth or ninth constitution, wherein the organic group is compatible with the polymerizable compound.
- The eleventh constitution includes the ink composition according to any one of the first to tenth constitutions, wherein the shell-like ligand has a number-average molecular weight of 1,000 or more and 50,000 or less.
- The twelfth constitution includes the ink composition according to any one of the first to eleventh constitutions, wherein the nanoparticle has a perovskite crystal structure.
- The thirteenth constitution includes a wavelength conversion member containing the ink composition according to any one of the first to twelfth constitutions cured with the polymerizable compound.
- The fourteenth constitution includes a wavelength conversion layer, wherein the wavelength conversion member according to the thirteenth constitution has an optical coupling surface that is optically coupled to a light-emitting layer that emits light with a first wavelength.
- The fifteenth constitution includes the wavelength conversion layer according to the fourteenth constitution, wherein the nanoparticle emits light with a second wavelength longer than the light with the first wavelength received through the optical coupling surface.

The present invention is not limited to these embodiments, and various changes and modifications may be made therein without departing from the spirit and scope of the present invention. Accordingly, the following claims are attached to make the scope of the present invention public.

This application claims the benefit of Japanese Patent Application No. 2021-194475 and Japanese Patent Application No. 2021-194477 both filed November 30, 2021, Japanese Patent Application No. 2022-041492 filed March 16, 2022, Japanese Patent Application No. 2022-051869 filed March 28, 2022, Japanese Patent Application No. 2022-182324 and Japanese Patent Application No. 2022-182326 filed November 15, 2022, and Japanese Patent Application No. 2022-189340 filed November 28, 2022, which are hereby incorporated by reference herein in their entirety.

## Claims

1. An ink composition comprising: a photoresponsive nanoparticle; a shell-like ligand including a plurality of binding portions with an ionic structural backbone and a polymer portion bound to the nanoparticle at a plurality of positions via the plurality of binding portions; and
a polymerizable compound to be polymerized upon receiving energy.

2. The ink composition according to Claim 1, wherein the plurality of binding portions include a zwitterionic structural backbone.

3. The ink composition according to Claim 1 or 2, wherein the plurality of binding portions include a structural backbone of at least one of a betaine structure and a quaternary ammonium salt.

4. The ink composition according to Claim 1 or 2, wherein the plurality of binding portions include a structural unit represented by at least one of formulae (1) to (5): 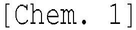 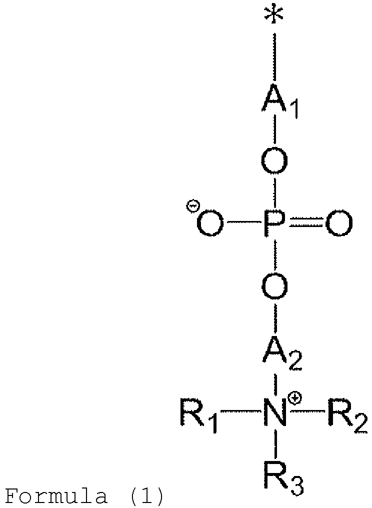 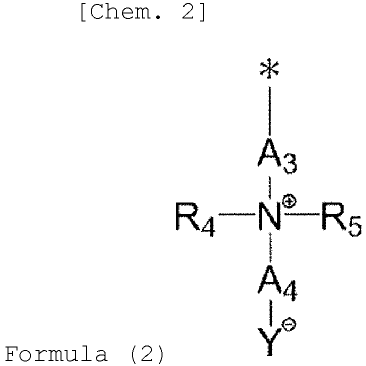 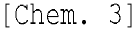 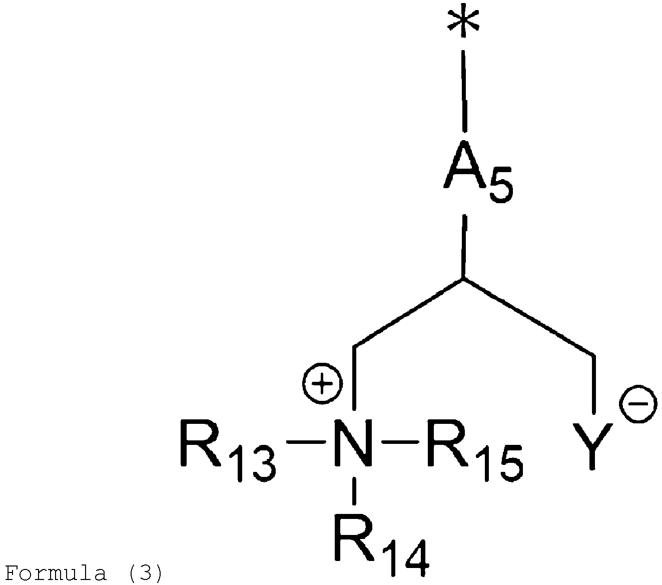 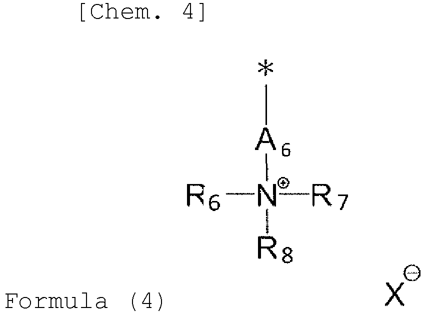 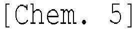 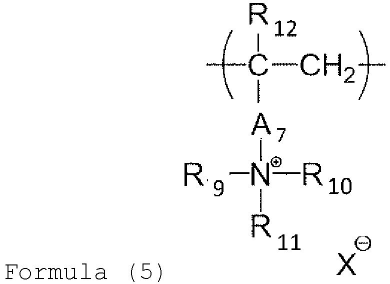 wherein R₁ to R₅ and R₁₂ to R₁₅ each independently denote any one of a hydrogen atom and an alkyl group, R₆ to R₁₁ denote any one of an alkyl group and an aryl group, N denotes a nitrogen atom, A₁ to A₇ denote a linking group, X-denotes an anion, Y⁻ denotes a COO⁻ group or a SO₃⁻ group, and "*" denotes a bonding arm to the polymer portion.

5. The ink composition according to Claim 4, wherein each of the plurality of binding portions includes a structural unit represented by at least one of formulae (1) to (5).

6. The ink composition according to Claim 1 or 2, wherein the polymer portion has a structural unit represented by at least one of formulae (6) to (8): 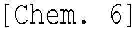 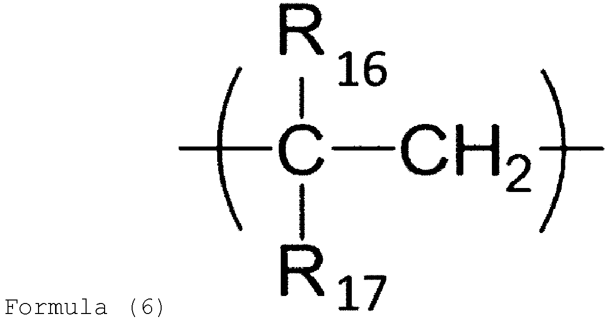 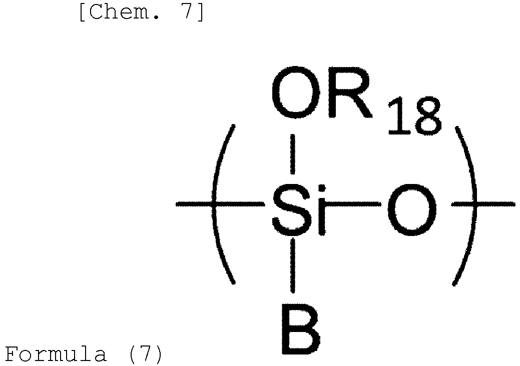 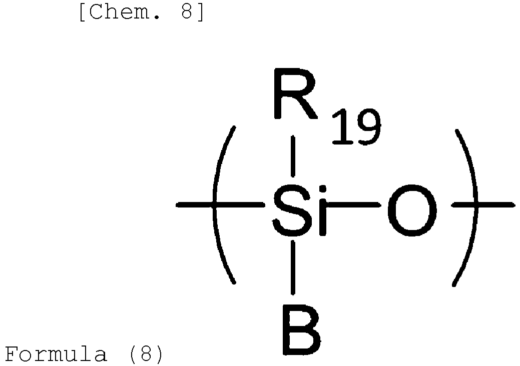 wherein R₁₆ and R₁₈ each independently denote any one of a hydrogen atom and an alkyl group, R₁₇ denotes any one of an alkyl group, a carboxylate group, a carboxamide group, an alkoxy group, and an aryl group, R₁₉ denotes an alkyl group, and B denotes a bonding arm to one of the binding portions.

7. The ink composition according to Claim 1 or 2, wherein the shell-like ligand has at least a portion coordinated to the nanoparticle.

8. The ink composition according to Claim 1 or 2, wherein the shell-like ligand has an organic group extending outward from the polymer portion.

9. The ink composition according to Claim 8, wherein the organic group is a portion of an alkyl group in at least one of the binding portions and the polymer portion.

10. The ink composition according to Claim 8, wherein the organic group is compatible with the polymerizable compound.

11. The ink composition according to Claim 1 or 2, wherein the shell-like ligand has a number-average molecular weight of 1,000 or more and 50,000 or less.

12. The ink composition according to Claim 1 or 2, wherein the nanoparticle has a perovskite crystal structure.

13. A wavelength conversion member comprising: the ink composition according to Claim 1 or 2 cured with the polymerizable compound.

14. A wavelength conversion layer, wherein the wavelength conversion member according to Claim 13 has an optical coupling surface that is optically coupled to a light-emitting layer that emits light with a first wavelength.

15. The wavelength conversion layer according to Claim 14, wherein the nanoparticle emits light with a second wavelength longer than the light with the first wavelength received through the optical coupling surface.
